# EUROPEAN PATENT SPECIFICATION

(11) **EP 2 916 638 B1**
(45) Date of publication and mention of the grant of the patent: **24.04.2019**
(21) Application number: 13850477.4
(22) Date of filing: 28.03.2013
(51) Int. Cl.: H05K 13/04, H05K 13/08

(54) **NOZZLE MANAGEMENT DEVICE**
DÜSENVERWALTUNGSVORRICHTUNG
DISPOSITIF DE GESTION DE BUSE

(30) Priority: 30.10.2012 WO PCT/JP2012/078044
(43) Date of publication of application: 09.09.2015
(73) Proprietor: FUJI Corporation, Chiryu Aichi (JP)
(72) Inventor: HOSAKA, Hideki, Chiryu, Aichi (JP); SHIMOSAKA, Kenji, Chiryu, Aichi (JP); HOSHIKAWA, Kazumi, Chiryu, Aichi (JP); TSUGE, Kuniaki, Chiryu, Aichi (JP); KOMIYAMA, Nobuhisa, Chiryu, Aichi (JP); TESHIMA, Chikashi, Chiryu, Aichi (JP); TSUJI, Hisayuki, Chiryu, Aichi (JP)
(74) Representative: Grünecker Patent- und Rechtsanwälte PartG mbB
(86) International application number: PCT/JP2013/059226
(87) International publication number: WO 2014/069016

(56) References cited:
- EP-A1- 1 191 833
- JP-A- H0 823 192
- JP-A- 2002 208 798
- JP-A- 2005 150 325
- JP-A- 2012 005 948
- JP-A- 2012 138 521
- US-A1- 2006 111 222

## Description

### Technical Field

The present invention relates to a nozzle management machine that manages suction nozzles used to hold an electrical component in an electrical component mounting machine.

### Background Art

In most electrical component mounting machines, electrical components are held by suction nozzles when the electrical components are mounted on a circuit board. Using suitable suction nozzles in such an electrical component mounting machine is important for mounting accuracy of electrical components to be highly maintained. In the related art, a technique is disclosed in JP-A-2012-114237 which is related to washing of suction nozzles and techniques disclosed in JP-A-2012-4306 and JP-A-2010-258185 which are related to inspection of suction nozzles.

Also in related art, US 2006/111222 A1 discloses a component mounting apparatus including an exchangeable suction nozzle which is easily supplied with another suction nozzle to replace the former suction nozzle. A plurality of mounting modules having respective identical constructions are arranged adjacent to each other such that the mounting modules are oriented in a same direction, so that the mounting modules constitute a mounting-apparatus line. When the mounting-apparatus line is reset, a mounting head is used to exchange automatically suction nozzles between a nozzle stocker and a nozzle carrier plate, so that a current arrangement of suction nozzles on the nozzle stocker is changed to a new arrangement of suction nozzles for the next component mounting operation. The nozzle carrier plate can hold a plurality of sorts of suction nozzles that are needed for the next component mounting operation but are not held by the mounting modules. A wiring-board conveying device is used to convey sequentially the nozzle carrier plate to each of the mounting modules and, in a state in which the nozzle carrier plate is positioned and held, one or more unnecessary suction nozzles are returned to the nozzle carrier plate and one or more suction nozzles needed for the next mounting operation are held by one or more vacant nozzle holders.

### Summary of Invention

### Technical Problem

As understood from the fact that the documents JP-A-2012-114237, JP-A-2012-4306 and JP-A-2010-258185 described above are present, it is necessary to suitably manage suction nozzles for suitable use of the suction nozzles. For this reason, a nozzle management machine capable of performing suitable management of suction nozzles, particularly, a nozzle management machine with high practicality has been demanded. The invention has been made in consideration of the above-described problem and an object thereof is to provide a nozzle management machine with high practicality.

### Solution to Problem

In order to solve the above-described problem, there is provided a nozzle management machine which manages suction nozzles used to hold an electrical component in an electrical component mounting machine and includes a nozzle storing device that includes a plurality of palettes capable of respectively placing suction nozzles; and a nozzle transfer device that transfers the suction nozzles respectively placed on the plurality of pallets.

### Advantageous Effects of Invention

According to the invention, since the suction nozzles placed on the pallet in the nozzle storing device can be transferred to, for example, a nozzle tray to be placed when used in the electrical component mounting machine or to another region in the pallet or another pallet by the nozzle transfer device according to various purposes, a nozzle management machine with high practicality is realized.

### Aspects of Invention

Hereinafter, several aspects of inventions (hereinafter, referred to as "claimable inventions" in some cases) recognized to be claimable in the present application are exemplified and the description thereof will be made. Respective aspects will be described in a form in which the aspects are divided into sections, respective sections are denoted by numbers, and numbers of other sections are cited if necessary. This form is merely made to facilitate understanding of claimable inventions and is not intended to limit combinations of constituent elements constituting the invention to those described in respective sections. That is, the claimable inventions need to be interpreted in consideration of descriptions in association with respective sections described below and descriptions of embodiments. Further, as long as the claimable inventions are interpreted as described above, an aspect obtained by adding other constituent elements are further added to the aspects of respective sections or an aspect obtained by eliminating some constituent elements from the aspects of respective sections can be an aspect of the claimable inventions.

In addition, in the following sections, the section (1), the section (31), the section (6), the section (8), the section (41), the section (46), the section (51), the section (61), the section (62), the section (64), the section (65), the section (71), the section (72), the section (73), and the section (12) respectively correspond to claim 1, claim 2, claim 3, claim 4, claim 5, claim 6, claim 7, claim 8, claim 9, claim 10, claim 11, claim 12, claim 13, claim 14, and claim 15.

### «Basic configuration»

Some aspects described below are aspects related to basic configuration of a nozzle management machine (hereinafter, simply referred to as a "management machine" in some cases) and include an aspect to which limitations related to a configuration of a nozzle storing device are added.
(1) A nozzle management machine which manages suction nozzles used to hold an electrical component in an electrical component mounting machine, the machine including: a nozzle storing device that includes a plurality of palettes capable of respectively placing the suction nozzles; and a nozzle transfer device that transfers the suction nozzles respectively placed on the plurality of pallets.

According to the aspect; since the suction nozzles (hereinafter, simply referred to as "nozzles" in some cases) placed on the pallet in the nozzle storing device (hereinafter, also simply referred to as a "storing device") can be transferred to, for example, a nozzle tray (specifically described below) to be placed when used in the electrical component mounting machine or to another region in the pallet or another pallet by the nozzle transfer device according to various purposes, a nozzle management machine with high practicality is realized.

The "pallet" in the present aspect can be referred to as a nozzle placing device or a container and stores a plurality of nozzles in a unit of a pallet in the present aspect. According to the present aspect, when taking in and out of the storing device and a treatment on nozzles are performed in a unit of a pallet, a management machine with abundant convenience is realized.

(2) The nozzle management machine according to (1), in which each of the plurality of pallets includes a plurality of placing units respectively having one suction nozzle to be placed thereon.

When the placing units are provided on the pallets, it is possible to reliably hold nozzles in a pallet. In other words, it is preferable that the placing units have a configuration capable of preventing the movement of nozzles from being dislocated.

(3) The nozzle management machine according to (1) or (2), in which one or more of the plurality of pallets are configured so as to place plural types of suction nozzles whose types are different from one another.

When only one kind of nozzle cannot be placed on one pallet, the number of kinds of pallets needs to be increased according to the kinds of nozzles and the increase thereof is associated with a certain kind of complication. When the pallets are capable of placing plural kinds of nozzles, it is possible to reduce the kinds of pallets and avoid or relieve the complication. That is, in this aspect, generalization of pallets is realized. Further, in consideration of the entire storing device, since the number of entire pallets is restricted, when a pallet on which only one kind of nozzle can be placed is prepared in plural, it is necessary to reduce the number of pallets for each kind of nozzle. Meanwhile, by employing a pallet capable of placing plural kinds of nozzles, it is possible to easily operate a storing device without depending on the kind of nozzle. From the viewpoints of avoiding the complication and easily operating a storing device, it is preferable to employ a pallet capable of placing all kinds of nozzles to be targeted by the management machine.

In general, the nozzle has a flange described below and is circle when seen from the upper side. In a case where circle nozzles are arranged on a pallet, arrangement efficiency is poor in nozzles whose outer diameters are relatively large. That is, the area of the nozzles, specifically the flanges thereof become relatively small when compared to the area of the pallet. From this viewpoint, by arranging nozzles whose outer diameters are relatively large and nozzles whose outer diameters are relatively small in a mixed manner, that is, by alternately arranging the nozzles, the number of nozzles to be placed can be increased. When described in an extreme manner, the arrangement efficiency can be largely improved by arranging nozzles whose outer diameters are small in a gap between nozzles whose outer diameters are large. From this viewpoint, in the present aspect, it is preferable that the nozzle management machine is configured such that plural kinds of nozzles whose sizes are different from one another, particularly, plural kinds of nozzles whose outer diameters of the flanges are different from one another can be placed.

In addition, in the above-described aspect, that is, in the aspect of providing the plurality of placing units on a pallet, it is possible to configure the nozzle management machine such that at least some of the plurality of placing units can place plural kinds of nozzles whose types are different from one another. When a placing unit can place only one kind of nozzle, in a case where plural kinds of nozzles are placed on one pallet, plural kinds of placing units need to be provided for the pallet. In this case, nozzles may not be placed on the plural placing units . That is, the probability of the presence of multiple empty placing units becomes higher. When plural kinds of nozzles can be placed on a placing unit, that is, a placing unit which can be used for plural kinds of nozzles is provided, the pallet becomes generalized and nozzles can be efficiently placed on the pallet. In addition, when the nozzle management machine is configured such that plural kinds of nozzles whose sizes are different from one another can be placed on placing unit, nozzles can be more efficiently placed on a pallet.

(4) The nozzle management machine according to any one of (1) to (3), in which the nozzle storing device includes a pallet moving device that moves the plurality of pallets in the nozzle storing device.

According to the present aspect, when pallets are movable in the storing device, it is possible to carry the pallets out from the storing device in a specific position and to carry the pallets in the storing device. The pallet moving device in the present aspect may be configured so as to move each of the plurality of pallets alone or move plural pallets at the same time, that is, all together.

(5) The nozzle management machine according to (4), in which the pallet moving device is a pallet circulating device that circulates and moves the plurality of pallets at the same time.

In the pallet moving device of the present aspect, the structure of the device can be made relatively simple and the plurality of pallets can be all moved along the same path depending on the structure thereof.

(6) The nozzle management machine according to any one of (1) to (5), in which the nozzle management machine includes a pallet transfer device for transfer that transfers one of the plurality of pallets from the nozzle storing device to a transfer position set as a position in which the suction nozzles are transferred by the nozzle transfer device, and the nozzle transfer device is configured so as to transfer the suction nozzle placed on one of the plurality of pallets transferred to the transfer position by the pallet transfer device for transfer.

The "pallet transfer device for transfer" in the present aspect is an aspect of a "pallet transfer device" that transfers one entire pallet on which a plurality of nozzles are placed and can be considered as an aspect of a "nozzle transfer device." According to the present aspect, it is possible to relatively easily transport a plurality of nozzles between the storing device and the transfer device. In addition, the pallet transfer device for transfer (hereinafter, also simply referred to as a "transfer device") may be configured so as to transfer an optional pallet regardless of the position in which the pallet is positioned in the storing device or configured so as to transfer only a pallet positioned in a specific position as described below. The former configuration is effective in a case where the storing device does not include a pallet moving device. In addition, it is preferable that the transfer device has a function of transferring a pallet positioned in a transfer position to the storing device, that is, a function of returning a pallet.

(7) The nozzle management machine is configured such that the nozzle storing device includes a pallet moving device that moves the plurality of pallets in the nozzle storing device and the pallet transfer device for transfer transfers one of the plurality of pallets, which are moved to a set position by the pallet moving device, to the transfer position.

The transfer device in the present aspect has a function of transferring one pallet positioned in a specific position among a plurality of pallets included in the storing device. That is, in the present aspect, in a case where a pallet is moved to a specific station by the pallet moving device in the storing device, the pallet is transferred between the station and the nozzle transfer device. According to the present aspect, since the pallet is only required to be transferred between the specific position in the storing device and the transfer device, the structure of the transfer device can be made simple.

(8) The nozzle management machine according to (6) or (7), in which the pallet transfer device for transfer is configured so as to sequentially transfer two or more pallets from among the plurality of pallets such that two or more of the plurality of pallets are temporarily positioned in two or more of transfer positions respectively, which are the transfer positions.

According to the present aspect, when the plurality of pallets are positioned in a position in which the pallets can be transferred by the transfer device, nozzles placed on any one of the plurality of pallets can be temporarily transferred to the nozzle tray described below and nozzles between the plurality of pallets can be transferred. Therefore, according to the present aspect, it is possible to realize a nozzle management machine with abundant convenience.

### «Configuration of nozzle transfer device»

Some aspects described below are aspects to which restrictions on the configuration of the nozzle transfer device are added.

(11) The nozzle management machine according to any one of (1) to (8), in which the nozzle transfer device includes a nozzle holding jig that holds one suction nozzle and a holding jig moving device that moves the nozzle holding jig.

The present aspect is an aspect of a specific structure of the nozzle transfer device. A jig that detachably holds a nozzle such as a chuck or a clamp can be employed as the above-described "nozzle holding jig." Further, in addition to so-called XYZ type robots, various moving devices such as an articulated robot and the like can be widely employed as the "holding jig moving device."

(12) The nozzle management machine according to (11), in which the nozzle storing device can store plural types of suction nozzles whose types are different from one another, and the nozzle transfer device is configured so as to use one nozzle holding jig according to the type of the suction nozzles to be held from a plurality of nozzle holding jigs respectively prepared as the nozzle holding jigs.

In the case where the storing device can store plural kinds of nozzles, the plural kinds of nozzles are occasionally difficult to transfer using one nozzle holding jig due to a difference in the size or the shape thereof. In this case, the present aspect is effective. According to the present aspect, even when the storing device stores plural kinds of nozzles whose sizes or shapes are different from one another, it is possible to reliably hold and accurately transfer each of the plural kinds of nozzles.

### «Transfer of nozzles between tray and pallet»

Some aspects described below are aspects to which restrictions on one function of the nozzle transfer device, specifically, a function of transferring nozzles between a nozzle tray and a pallet are added.

(21) The nozzle management machine according to any one of (1) to (12), in which the electrical component mounting machine is configured such that suction nozzles used thereon are placed on a nozzle tray disposed so as to be detachably attached thereto, and the nozzle transfer device is configured so as to transfer the suction nozzles between the nozzle tray and one of the plurality of pallets.

In the electrical component mounting machine, nozzles to be used are exchanged according to the size or the like of electrical components when several electrical components are mounted on a circuit board. In most electrical component mounting machines, several nozzles which can be exchanged are arranged in a nozzle station provided in the electrical component mounting machines in a state of being placed on a nozzle tray (hereinafter, also simply referred to as a "tray") . According to the present aspect, nozzles can be transferred from a pallet to the tray or from the tray to the pallet by the transfer device. Specifically, "setting transfer" that sets several nozzles stored in the storing device in a tray for the purpose of using nozzles in the electrical component mounting machine or "storing transfer" that stores nozzles being used in the electrical component mounting machine in the storing device from a tray can be performed.

(22) The nozzle management machine according to (21), in which the nozzle transfer device is configured so as to transfer the suction nozzles between a nozzle tray and one of the plurality of pallets in a state in which the nozzle tray and one of the plurality of pallets are respectively positioned in transfer positions respectively set as positions in which the suction nozzles can be transferred by the nozzle transfer device.

The present aspect is an aspect in which nozzles are transferred in a state in which both the pallet and the tray are respectively positioned in set positions. In addition, in the present aspect, transfer of nozzles between the plurality of pallets and the tray is not excluded in the state in which the plurality of pallets are positioned in transfer positions respectively set as described above.

(23) The nozzle management machine according to (22), in which the nozzle management machine includes a pallet transfer device for transfer that transfers one of the plurality of pallets to the transfer position set with respect to one of the plurality of pallets from the nozzle storing device.

The present aspect is an aspect of positioning a pallet in the transfer position using the transfer device described above.

### «Transfer of nozzles between pallets»

Some aspects described below are aspects to which restrictions on one function of the nozzle transfer device, specifically, a function of transferring nozzles between a plurality of pallets are added.

(31) The nozzle management machine according to any one of (1) to (23), in which the nozzle transfer device is configured so as to transfer suction nozzles between one of the plurality of pallets and another pallet.

The present aspect is an aspect in which nozzles can be transferred between pallets. The present aspect is effective in terms of alignment or a change in arrangement of nozzles (hereinafter, also collectively referred to as "arrangement" in some cases) stored in the storing device. In addition, regardless of the fact that nozzles are transferred in one pallet or between a plurality of pallets, hereinafter, the transfer of the nozzles for alignment or the change in arrangement of nozzles is referred to as "arrangement transfer" in some cases.

In regard to arrangement, the purpose of the arrangement is not particularly limited, but it is possible to perform arrangement so as to fill empty placing units for the purpose of improving storage efficiency of the storing device in a case where a plurality of placing units are provided in a pallet as described in detail below. Further, in a case where a management machine includes a device for performing a treatment on nozzles described in detail below and performs a treatment on nozzles such as washing or inspecting for each pallet, it is possible to perform arrangement such that only nozzles to which the treatment is not applied are placed on one pallet for the purpose of improving efficiency of the treatment on nozzles. In addition, for the purpose of using each nozzle on the average, it is possible to arrange nozzles in descending order of the length of the period for which nozzles are not used. In addition, for the purpose of rapidly performing setting, in the case where the storing device can store plural kinds of nozzles, it is possible to arrange the nozzles in order of frequency of use for each type, to arrange the nozzles in one pallet in a ratio according to the frequency of use for each type, or to arrange a set of nozzles to be a target of the next setting transfer or a set of nozzles to be frequently used in one pallet.

(32) The nozzle management machine according to (31), in which the nozzle transfer device is configured so as to transfer the suction nozzles between one of plural pallets and another pallet in a state in which one of the plurality of pallets and another pallet are respectively positioned in transfer positions respectively set as positions in which the suction nozzles can be transferred by the nozzle transfer device.

The present aspect is an aspect of transferring nozzles in a state in which a plurality of pallets are respectively positioned in set positions.

(33) The nozzle management machine according to (32) further including a pallet transfer device for transfer that transfers one of the plurality of pallets to the transfer position set with respect to one pallet from the nozzle storing device, and the pallet transfer device for transfer is configured so as to sequentially transfer one of the plurality of pallets and another pallet to the transfer positions respectively.

The present aspect is an aspect of respectively positioning a plurality of pallets in transfer positions using the transfer device described above.

### «Device of performing treatment on nozzles»

Some aspects described below are aspects to which restrictions on a function of performing any treatment on the suction nozzles stored in the storing device are added.

(41) The nozzle management machine according to any one of (1) to (33), in which the nozzle management machine includes one or more devices for performing a treatment on nozzles that respectively perform any treatment on the suction nozzle placed on any one of the plurality of pallets.

The "device for performing a treatment on nozzles" in the present aspect is a device for performing any treatment on nozzles and specific examples thereof include a nozzle inspecting device and a nozzle washing device. When the device for performing a treatment on nozzles (hereinafter, simply referred to as a "treatment performing device" in some cases) is included, the nozzle management machine can have various functions since the treatment performing device is included, in addition to the function of storing nozzles and a nozzle management machine with high practicality which can be realized according to the present aspect. In addition, when interpreted in a broad sense, the "nozzle transfer device" described above can be considered as a type of the treatment performing device and thus the nozzle transfer device will also be described below as a device for performing a treatment on nozzles in some cases.

In the present aspect, an aspect having a plurality of treatment performing devices is included. In the aspect having the plurality of treatment performing devices, an aspect having a plurality of devices for performing the same treatment or an aspect having a plurality of devices for performing treatments different from one another is also included. According to the former aspect, a management machine with high ability of performing the treatment can be realized. In addition, according to the latter aspect, a management machine with multiple functions can be realized.

In a case where the management machine includes a plurality of treatment performing devices that performs treatments different from one another, the management machine can be configured such that pallets on which nozzles are placed sequentially pass through the plurality of treatment performing devices and the treatments are sequentially performed on the nozzles by each of the plurality of treatment performing devices. Alternatively, a configuration in which the plurality of treatment performing devices can respectively perform treatments in parallel on the nozzles placed on the pallets different from one another is possible. When the latter configuration, that is, a configuration in which respective operations of the plurality of treatment performing devices are performed independently from operations of other devices is employed, practical use of the plurality of treatment performing devices, that is, practical use of the management machine related to a plurality of treatments becomes easy.

(42) The nozzle management machine according to (41), in which the nozzle management machine includes one or more pallet transfer devices for a treatment that respectively transfers one of the plurality of pallets to one or more devices for performing a treatment on nozzles from the nozzle storing device, and each of one or more devices for performing a treatment on nozzles performs any treatment on the suction nozzles placed one of the plurality of pallets which are transferred by one corresponding pallet transfer device from among one or more of the pallet transfer devices for a treatment.

The "pallet transfer device for a treatment" in the present aspect is a form of the "pallet transfer device" that transfers one entire pallet on which a plurality of nozzles are placed similar to the "pallet transfer device for transfer" described above and can be considered as one form of the "nozzle transfer device." According to the present aspect, it is possible to relatively easily transport a plurality of nozzles between the storing device and the treatment performing device. In addition, the pallet transfer device for a treatment (hereinafter, simply referred to as the "transfer device" in some cases) may be configured so as to transfer an optional pallet regardless of the fact of which position the pallet is positioned in the storing device similar to the nozzle transfer device for transfer, or configured so as to transfer only a pallet positioned in a specific position as described below. The former configuration is effective in a case where the storing device does not include a pallet moving device. In addition, it is preferable that the pallet transfer device for a treatment has a function of transferring a pallet, which is transferred to the treatment performing device, to the storing device, that is, a function of returning the pallet similar to the nozzle transfer device for transfer. In addition, in the description above, the pallet transfer device for a treatment and the pallet transfer device for transfer described above are collectively described as the "pallet transfer device" which is a broader concept of these in some cases.

Simply stated, the present aspect can be considered as an aspect including transfer devices for each treatment performing device. The present aspect is particularly effective when a plurality of treatment performing devices described above can be operated independently from one another.

(43) The nozzle management machine according to (42), in which the nozzle storing device includes a pallet moving device that moves the plurality of pallets in the nozzle storing device, and each of one or more of the pallet transfer devices for a treatment transfers one of the plurality of pallets moved to set positions by the pallet moving device to one corresponding device for performing a treatment on nozzles from among one or more of the devices thereof.

Similar to the aspect related to the pallet transfer device for transfer described above, the transfer device in the present aspect has a function of transferring one pallet that is positioned in a specific position from among a plurality of pallets included in the storing device. That is, in the present aspect, in a case where pallets in the storing device are moved to a specific station by the pallet moving device, pallets are transferred between the station and the treatment performing device. According to the present aspect, since the pallets need to be transferred between a specific position in the storing device and the treatment performing device, the structure of the transfer device can be simplified.

(44) The nozzle management machine according to any one of (41) to (43), in which the nozzle management machine includes a nozzle washing device that washes the suction nozzles placed on one pallet from among the plurality of pallets as one device for performing a treatment on nozzles among one or more of the devices thereof.

The present aspect is an aspect including the nozzle washing device (hereinafter, also simply referred to as the "washing device" in some cases) as a treatment performing device. It is preferable that the nozzles are washed for the purpose of eliminating clogging, removing dirt, or the like. According to the present aspect, since the nozzles can be washed, a management machine with high practicality is realized. In addition, since nozzles can be washed by the washing device in a state in which the nozzles are placed on a pallet, extremely stated, in the same state in which nozzles are stored in the storing device, the washing can be simply and efficiently done. Further, in the present aspect, a washing method performed by the washing device is not particularly limited and various known washing methods can be employed.

In addition, in the present aspect, a nozzle drying device (hereinafter, also simply referred to as a "drying device" in some cases) that dries the suction nozzles washed by the washing device may be included. In the case that the drying device is included, the nozzles can be stored in a state of being dried to some extent even when the nozzles are stored in the storing device immediately after drying. In addition, after nozzles are washed, the nozzles can be used without a long wait. Moreover, in the drying device in the present aspect, drying means employed by the drying device are not particularly limited and various known drying means can be employed. In addition, in the case where the above-described transfer device is included, it is preferable that nozzles are dried when a pallet on which the washed nozzles are placed is transferred to the storing device by the transfer device from a viewpoint of reducing the time loss.

(45) The nozzle management machine according to any one of (41) to (44), in which the nozzle management machine includes a nozzle inspecting device that inspects the suction nozzles placed on one of the plurality of pallets as one of one or more of the devices for performing a treatment on nozzles.

According to the present aspect, for example, since nozzles stored or to be stored in the storing device can be inspected, a convenient management machine is realized. Further, since the inspection of the nozzles can be performed in a state in which the nozzles are placed on a pallet by the nozzle inspecting device (hereinafter, simply referred to as an "inspecting device"), that is, when the inspection is performed in the same state in which the nozzles are stored in the storing device when extremely stated, the inspection can be simply and efficiently performed.

The items inspected with the inspecting device in the present aspect are not particularly limited, but the inspection can be performed through various methods such as (a) passing flow rate inspection which inspects the flow rate of the air passing through nozzles, (b) identifier reading inspection which inspects reading of an identifier for recognizing specific information related to a nozzle in a state of being attached to the nozzle, (c) tip portion state inspection which inspects the state of the tip portion of a nozzle, and (d) necessary retreat force inspection which measures the force necessary for retreat of the tip portion of a suction nozzle in a case where the tip portion of the nozzle can retreat due to the biasing force. In addition, the inspecting device may perform inspection related to only one item, or perform inspection related to a plurality of items. Further, in the present aspect, an aspect having a plurality of inspecting devices that inspect items different from one another is included.

(46) The nozzle management machine according to any one of (41) to (45), in which the nozzle management machine is configured such that the transfer of the suction nozzle placed on one of the plurality of pallets performed by the nozzle transfer device and any treatment performed by one of one or more devices for performing a treatment on nozzles with respect to the suction nozzle placed on another one of the plurality of pallets are performed in parallel.

Simply stated, the present aspect is an aspect in which the operation of the treatment performing device and the operation of the nozzle transfer device are performed independently from each other. According to the present aspect, it is possible to concurrently perform the above-described setting transfer, storage transfer, and transfer of nozzles between pallets and to wash or inspect nozzles stored in a pallet not related to the transfer, and thus a treatment on another nozzle other than the nozzles provided for the transfer can be performed without interrupting the transfer described above. Therefore, it is possible to perform management of nozzles in a highly efficient manner. In addition, in a case where a plurality of treatment performing devices are included, as described above, a configuration in which treatments can be performed on nozzles placed on pallets different from one another in parallel, that is, it is desirable that a configuration in which each operation of the plurality of treatment performing devices are performed independently from operations of other devices is employed for each of the plurality of treatment performing devices.

### «Control of control device»

Some aspects described below are aspects related to the control of the nozzle management machine, in other words, aspects showing a method of practically using the nozzle management machine. In addition, some aspects described below include aspects to which restrictions on information which is a premise at the time of performing various control are added.

(51) The nozzle management machine according to any one of (1) to (46), in which the nozzle management machine includes a control device that controls its own device.

The present aspect is a basic aspect related to control and the control device is a constituent element that independently and practically uses the management machine. The control device may be configured with a computer as a main constituent element.

(52) The control device includes a nozzle information storage section that stores specific information of each of the suction nozzles stored in the nozzle storing device in association with each of the storage positions in the nozzle information memory section and performs control based on the specific information of each of the suction nozzles stored in the nozzle information storage section.

The "specific information" in the present aspect includes ID, quality information related to the quality of a nozzle, information related to the level of ability, the frequency of use, information directly or indirectly indicating time during which nozzles are not used, and the like as typical information. The specific information is extremely useful information for understanding storage positions of a plurality of nozzles stored in the storing device, that is, for understanding which nozzles are stored in which position. According to the present aspect, it is possible to understand which nozzles are stored in which storage position in the storing device and the stored nozzles can be suitably managed based on such knowledge.

(53) The nozzle management machine according to (52), in which identifiers are attached to each of the suction nozzles in order to recognize each piece of the specific information, the nozzle management machine includes an identifier reader that reads the identifiers, and the nozzle information memory section stores the specific information of each of the suction nozzles acquired by reading the identifier reader.

The present aspect is an aspect to which restrictions on means for acquiring the specific information are added. As the "identifier" in the present aspect, for example, a bar code or a 2D code (two-dimensional code such as a QR code (registered trademark)) can be employed, and as the "identifier reader," for example, a bar code reader or an imaging device such as a camera can be employed. It is preferable that the specific information is recognized when nozzles are transferred, particularly, when nozzles are stored and transferred. In consideration of this point, it is preferable that the identifier reader is provided in the transfer device. More specifically, in a case where the transfer device is configured to include the nozzle holding jig and the holding jig moving device, it is preferable that the identifier reader is configured so as to be moved along with the nozzle holding jig by the holding jig moving device.

(54) The nozzle management machine according to (52) and (53), in which each of the plurality of pallets includes a plurality of placing units on which each of the suction nozzles is respectively placed, and each of the storage positions of the suction nozzles is prescribed so as to be placed on any of the plurality of placing units in any of the plurality of pallets.

Simply stated, in the present aspect, each placing unit of each pallet is prescribed as one storage position. According to the present aspect, it is possible to understand which region of which pallet stores which nozzle and to more suitably perform management of the nozzles being stored.

### «Variation of setting nozzles in tray»

Some aspects described below are aspects related to setting nozzles on the nozzle tray, that is, setting transfer of nozzles.

(61) The nozzle management machine according to any one of (51) to (54), in which the electrical component mounting machine is configured such that the suction nozzles used thereon are placed on a nozzle tray disposed so as to be detachably attached thereto, the nozzle transfer device is configured so as to transfer the suction nozzles between the nozzle tray and one of the plurality of pallets, and the control device includes a setting control unit that transfers the suction nozzles required for the electrical component mounting machine to the nozzle tray from one or more of the plurality of pallets by controlling the nozzle transfer device.

The present aspect is a basic aspect related to setting of nozzles. The "setting transfer" means transfer for setting nozzles to be used in the electrical component mounting machine in a tray, and several nozzles of the plurality of nozzles stored in the storing device are arranged in a nozzle tray by the setting transfer. Therefore, according to the present aspect, by setting the nozzles to be used in the electrical component mounting machine in a tray in advance, it is possible to effectively support preparation of nozzles with respect to the electrical component mounting machine. That is, the loss of work due to the electrical component mounting machine can be reduced. In addition, the convenience of the management machine is improved when configured so as to automatically perform setting of the nozzles based on any information.

(62) The nozzle management machine according to (61), in which the nozzle management machine is communicative with at least one of the electrical component mounting machine and a management device that manages the electrical component mounting machine, and the setting control unit is configured so as to transfer the suction nozzles required for the electrical component mounting machine based on information received from at least one of the electrical component mounting machine and the management device.

In the present aspect, information for setting of the nozzles is sent from the outside of the management machine and the setting of the nozzles is performed based on the sent information. According to the present aspect, since the nozzles can be set based on the information from the outside, a highly convenient management machine can be realized. The information received by the management machine may be information directly indicating which nozzle being placed on which region of which tray or may be indirect information such as a mounting program that is executed by the electric component mounting machine. In a case of the indirect information, placement of which nozzles on which region of which tray is determined by the control device, and then setting of the nozzles can be performed based on the determination. Further, the "management device" includes a device such as a so-called host computer.

(63) The nozzle management machine according to (61) or (62), in which the control device includes a storage control unit that transfers the suction nozzles to one or more pallets from among the plurality of pallets from the nozzle tray on which the suction nozzles are placed by controlling the nozzle transfer device in order to store the suction nozzles in the nozzle storing device.

The present aspect is an aspect in which the nozzle transfer device can perform the above-described storage and transfer. The "storage transfer" means transfer for storing nozzles being used in the electrical component mounting machine in the storing device and at least some nozzles of the plurality of nozzles being placed on a tray are eliminated from the tray by the storage transfer. According to the present aspect, a management machine capable of effectively supporting the removal of the nozzles or the like in the electrical component mounting machine can be realized.

(64) The nozzle management machine according to (63), in which the control device is configured such that another suction nozzle having the same form as those of the suction nozzles transferred from the nozzle tray by the control of the storage control unit is transferred to the nozzle tray by the control of the setting control unit.

The present aspect is an aspect in which the so-called resetting of nozzles can be performed. For example, in a case where nozzles need to be exchanged due to use for a long period of time, the present aspect is effective when nozzles being used in the electrical component mounting machine are exchanged. According to the present aspect, only by setting the tray on which nozzles being used are placed in the management machine, the nozzles can be automatically exchanged for other nozzles which can be used and, with this configuration, a management machine with high practicality can be realized.

(65) The nozzle management machine according to any one of (61) to (64), in which the setting control unit is configured such that the suction nozzles are transferred to the nozzle tray so as for the frequency of use to be as uniform as possible.

The "frequency of use" can be considered as a parameter or an index indicating that how long nozzles have been used or how many times the nozzles have been used. In addition, the time for use or the times of nozzles being used over the entire period in the past may be indicated or the time for use or the times of nozzles being used during the set time may be indicated. In addition, the frequency of use in the present aspect means the frequency of use for each nozzle.

According to the present aspect, nozzles stored in the storing device can be used uniformly, that is, without biasing to some or particular nozzles and a management machine with high practicality can be realized. Specifically, for example, when the control device stores information related to the frequency of use as the specific information of each nozzle and the setting transfer is performed based on the stored information, the frequency of use of nozzles can be as uniform as possible.

(66) The nozzle management machine according to any one of (61) to (65), in which the setting control unit is configured so as to transfer the suction nozzles to the nozzle tray in descending order of the length of the period for which nozzles are not used.

The present aspect can be considered as the former aspect, that is, a kind of the aspect in which setting transfer is performed such that the frequency of use of nozzles becomes as uniform as possible. The "period for which nozzles are not used" (hereinafter, also referred to as an "unused period" in some cases) can be considered as the time of storage of nozzles from the time point of the nozzles initially being stored. When considered in this manner, according to the present aspect, nozzles which have been stored in the storing device for a longer period of time without being used are preferentially provided for setting. As a result, the frequency of use of nozzles becomes uniform. In order to realize the management machine of the present aspect, specifically, the control device is configured such that the control device stores information related to the period for which nozzles are not used (can be considered as a kind of information related to the frequency of use) as the specific information of each nozzle and setting transfer is performed based on the stored information. In addition, as the information related to the unused period, the time at which nozzles are stored in the management machine (hereinafter, also referred to as "storage time" in some cases) can be employed. By storing the storage time of nozzles and performing setting transfer based on the storage time, it is possible to easily make the frequency of use of nozzles uniform.

### «Variation of arrangement of nozzles in storage device»

Some aspects described below are aspects related to arrangement of nozzles in a pallet. In other words, the present aspect can be considered as an aspect related to a method of performing arrangement transfer described above.

(71) The nozzle management machine according to any one of (51) to (66), in which the control device includes an arrangement control unit that arranges the suction nozzles in one or more of the plurality of pallets in the nozzle storing device by controlling the nozzle transfer device according to set rules.

The present aspect is a basic aspect related to the arrangement of nozzles in the storing device. According to the present aspect, since the nozzles stored in the storing device are arranged according to the set rules, it is possible to easily perform management of nozzles.

(72) The nozzle management machine according to (71), in which the nozzle management machine includes a nozzle washing device that washes the suction nozzle placed on any one of the plurality of pallets, and the arrangement control unit arranges only one suction nozzle which is not completely washed by the nozzle washing device on one of the plurality of pallets.

According to the present aspect, in a case where the management machine includes the washing device, since it is possible to prevent nozzles which are already washed from being washed again, the nozzles can be effectively washed.

(73) The nozzle management machine according to (71) or (72), in which the electrical component mounting machine is configured such that the suction nozzles used thereon are placed on the nozzle tray disposed so as to be detachably attached thereto, and the arrangement control unit arranges the suction nozzles placed on the nozzle tray so as to constitute a specific set in one of the plurality of pallets.

According to the present aspect, since the specific set of nozzles to be used in the electrical component mounting machine are arranged in one pallet, it is possible to perform setting rapidly when the specific set of nozzles are set in the tray. Specifically, nozzles of a set being frequently used, that is, a set with high frequency of use or a set expected to be used in advance may be arranged on one pallet as nozzles of a specific set.

(74) The nozzle management machine according to any one of (71) to (73), in which the arrangement control unit is configured such that the suction nozzles are arranged in descending order of the length of the period for which the nozzles are not used in one or more pallets of the plurality of pallets.

According to the present aspect, nozzles can be uniformly used, that is, used without biasing by performing setting according to order of arranged nozzles. In other words, the frequency of use of nozzles can be as uniform as possible without elaborating the setting transfer. Further, in a case where plural kinds of nozzles can be stored in the storing device, nozzles may be arranged in descending order of the length of period for which the nozzles are not used for each type of nozzle or only some kinds of nozzles among the plural kinds of nozzles may be arranged in descending order of the length of period for which nozzles are not used. Moreover, as described above, nozzles can be easily arranged in order of the length of period for which the nozzles are used based on the storage time of the nozzles.

(75) The nozzle management machine according to any one of (71) to (74), in which the nozzle storing device can store plural kinds of suction nozzles whose types are different from one another, and the arrangement control unit is configured so as to arrange two or more types of suction nozzles at a ratio in accordance with the frequency of use for each type of nozzle in each of one or more pallets of the plurality of pallets.

The "frequency of use for each type of nozzle" in the present aspect can be considered as a parameter or an index indicating that how long one type of nozzle is used or how many times one type of nozzle is used. That is, the "frequency of use for each type of nozzle" can be considered as a parameter or an index indicating the total of the time of use in regard to one type of nozzle or the total of the times of nozzles being used. In addition, it may indicate the total operation time or the total times of use over the entire period in the past or may indicate the total operation time or the total times of use during the set time.

According to the present aspect, plural types of nozzles are arranged in one pallet only by the number in accordance with the frequency of use for each type of nozzle. That is, in a case of nozzles whose types are used with high frequency, a large number of nozzles are arranged. Meanwhile, in a case of nozzles whose types are used with low frequency, a small number of nozzles are arranged. As a result, in most cases, setting of nozzles in one tray is finished by performing setting transfer from the one pallet. Therefore, according to the present aspect, it is possible to rapidly set nozzles.

(76) The nozzle management machine according to any one of (71) to (75), in which the nozzle storing device can store plural kinds of suction nozzles whose types are different from one another, and the arrangement control unit arranges two or more types of suction nozzles in descending order of frequency of time for each type of nozzle in one or more pallets of the plurality of pallets.

Simply stated, according to the present aspect, several types of nozzles are aligned in descending order of frequency of use in the storing device (including arrangement over the plurality of pallets). Accordingly, management of nozzles in the storing device becomes easy. Moreover, in a case where a pallet on which two or more types of nozzles are placed is present, it is possible to rapidly perform setting of a set including two or more types of nozzles by performing setting transfer from the pallet.

### Brief Description of Drawings

Fig. 1 is a perspective view illustrating an electrical component mounting machine in which suction nozzles serving as targets of management of a nozzle management machine of an example are used.
Fig. 2 is a perspective view illustrating a typical suction nozzle.
Fig. 3 is a view illustrating a nozzle tray on which suction nozzles are placed in an electrical component mounting machine.
Fig. 4 is a perspective view illustrating the appearance of a nozzle management machine of an example.
Fig. 5 is a perspective view illustrating the internal structure of a nozzle management machine.
Fig. 6 is a perspective view illustrating the internal structure of the nozzle management machine from a different viewpoint.
Fig. 7 is a perspective view for describing a nozzle transfer device included in a nozzle management machine.
Fig. 8 is a perspective view for describing a first nozzle inspecting device included in a nozzle management machine.
Fig. 9 is a perspective view for describing a second nozzle inspecting device included in a nozzle management machine.
Fig. 10 is a perspective view for describing a nozzle washing device and a nozzle drying device included in a nozzle management machine.
Fig. 11 is a perspective view illustrating the nozzle washing device and the nozzle drying device illustrated in Fig. 10 in a state in which a housing is eliminated therefrom.
Fig. 12 is a view illustrating a nozzle pallet on which suction nozzles are placed in a nozzle storing device included in a nozzle management machine.
Fig. 13 is a view illustrating several suction nozzles managed by a nozzle management machine.
Fig. 14 is a cross-sectional view illustrating a state in which a suction nozzle is placed in a placing hole and illustrating a part of a nozzle pallet of another placing hole which can be employed.
Fig. 15 is a schematic view for describing tip portion state inspection by a first nozzle inspecting device included in a nozzle management machine.
Fig. 16 is a schematic view for describing necessary retreat force inspection of a first nozzle inspecting device included in a nozzle management machine.
Fig. 17 is a schematic view for describing passing flow rate inspection and identifier reading inspection by a second nozzle inspecting device included in a nozzle management machine.
Fig. 18 is a schematic view for describing washing and drying of suction nozzle performed by a nozzle washing device and a nozzle drying device included in a nozzle management machine.
Fig. 19 is a perspective view for describing an additional configuration of a nozzle management machine.
Fig. 20 is a chart illustrating the flow of various operations carried out in a nozzle management machine.
Fig. 21 is a view illustrating connection between a nozzle management machine, an electrical component mounting machine, and a management computer.
Fig. 22 is a table schematically illustrating information related to stored nozzles, which is stored in a control device of a nozzle management machine.
Fig. 23 is a table schematically illustrating information related to frequency of use for each type of nozzle, which is stored in a control device of a nozzle management machine.
Fig. 24 is a table schematically illustrating information related to a stored tray, which is stored in a control device of a nozzle management machine.
Fig. 25 is a table schematically illustrating information related to setting of nozzles, which is used at the time of setting suction nozzles in a nozzle tray by a control device of a nozzle management machine.
Fig. 26 is a conceptual view for describing a role of a nozzle pallet in a nozzle management machine.
Fig. 27 is a conceptual view illustrating arrangement order of suction nozzles in a nozzle pallet.
Fig. 28 is a flowchart illustrating a nozzle storing program executed by a nozzle management machine in order to perform a nozzle storing operation.
Fig. 29 is a view schematically illustrating transfer of suction nozzles in a nozzle storing operation.
Fig. 30 is a flowchart illustrating a first nozzle arranging program executed by a nozzle management machine in order to perform a first nozzle arranging operation.
Fig. 31 is a view schematically illustrating transfer of suction nozzles in a first nozzle arranging operation.
Fig. 32 is a flowchart illustrating a nozzle washing program executed by a nozzle management machine in order to perform a nozzle washing operation.
Fig. 33 is a flowchart illustrating a first nozzle inspecting program executed by a nozzle management machine in order to perform a first nozzle inspecting operation.
Fig. 34 is a flowchart illustrating a second nozzle inspecting program executed by a nozzle management machine in order to perform a second nozzle inspecting operation.
Fig. 35 is a view schematically illustrating an aspect of alignment of suction nozzles for storage.
Fig. 36 is a view schematically illustrating several other aspects of alignment of suction nozzles for storage.
Fig. 37 is a flowchart illustrating a second nozzle arranging program executed by a nozzle management machine in order to perform a second nozzle arranging operation.
Fig. 38 illustrates a nozzle setting program executed by a nozzle management machine in order to perform a nozzle setting operation.
Fig. 39 is a view schematically illustrating a state in which a specific set of nozzles are eliminated by setting among suction nozzles aligned in the aspect illustrated in Fig. 35.
Fig. 40 is a view schematically illustrating a state in which a specific set of nozzles are eliminated by setting among suction nozzles aligned in each of the aspects illustrated in Fig. 36.
Fig. 41 is a flowchart illustrating a first half part of a nozzle resetting program executed by a nozzle management machine in order to perform a nozzle resetting operation.
Fig. 42 is a flowchart illustrating a second half of the nozzle resetting program executed by the nozzle management machine in order to perform the nozzle resetting operation.
Fig. 43 is a block diagram illustrating a configuration of functions of a control device included in a nozzle management machine.

### Description of Embodiments

Hereinafter, typical embodiments of the claimable invention will be described in detail with reference to the accompanying drawings as examples. In addition, the claimable invention can be carried out in various aspects to which various modifications and improvement are added based on the knowledge of a person skilled in the art in addition to aspects described in the sections of "aspects of invention" other than examples described below. Further, it is possible to form modification examples of examples described below using technical matters described in each section of "aspects of invention."

### Examples

A nozzle management machine of Examples manages suction nozzles being used in an electrical component mounting machine. The suction nozzles are component holding jigs that adsorb and hold electrical components using a negative pressure supplied to the suction nozzles in mounting of the electrical components on a circuit board. Before description of the nozzle management machine of Examples is made, the electrical component mounting machine and the suction nozzles will be simply described, and then the nozzle management machine of Examples, for example, the overall configuration of the nozzle management machine, each device constituting the nozzle management machine, an additional configuration in the nozzle management machine, several operations performed by the nozzle management machine, and the configuration of functions of a control device related to those operations will be sequentially described. Further, in the description below, the "nozzle management machine," the "electrical component mounting machine, " the "suction nozzles, " the "circuit board, " and the "electrical components" are simply referred to as the "management machine," the "mounting machine," the "nozzles," the "board," and the "components" respectively.

### [A] Electrical component mounting machine and suction nozzles

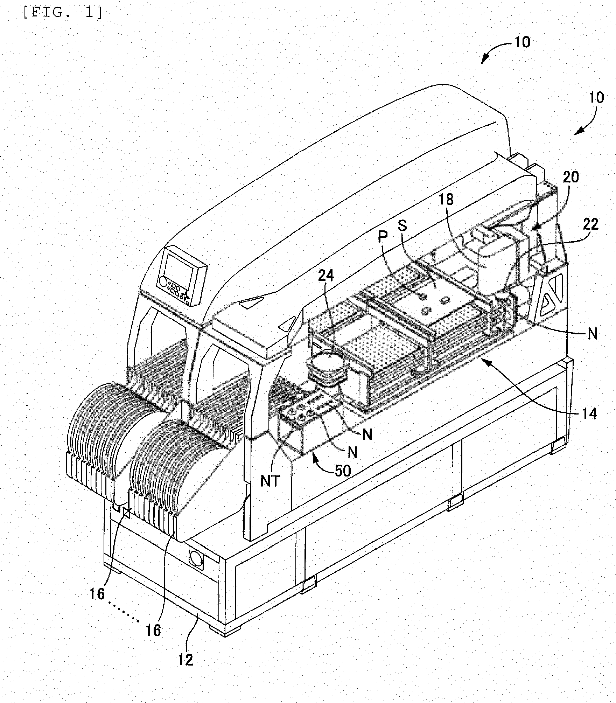

Fig. 1 illustrates an electronic component mounting machine for which suction nozzles serving as targets of management of a management machine are used as an example. In the figure, two mounting machines 10 having the same structure are disposed parallel to a base 12 (in the figure, an exterior panel positioned in the front side is eliminated). The mounting machine 10 includes a conveyor type board conveyance device 14 that transports a board S and fixes the board S to a set position; a plurality of feeder type component supply devices 16, each of which supplies a component P; a mounting head 18 that mounts the component P supplied from the component supply devices 16 on the fixed board S; and a head moving device 20 that moves the mounting head 18 between the component supply device 16 and the fixed board S. The mounting head 18 includes an operational axis 22 whose lower end portion is attached by suction nozzles N; and an operational axis elevating and rotating device (not illustrated) that elevates and rotates the operational axis 22. In addition, the mounting head 18 illustrated in the figure is an index type of mounting head and a plurality of nozzles N is detachably attached to the operational axis 22. The component P supplied from the component supply device 16 is adsorbed and held in the tip (lower end) of the nozzle N, and the held component P is mounted on the board S when the mounting head 18 is moved to the upper side of the board S and then the components is released from the state of being adsorbed and held by the nozzle N. In addition, since the component P is mounted in a suitable posture in a suitable position on the board S, the component P is imaged by a component camera 24 provided in the mounting machine 10 from the lower side in a state of being adsorbed and held by the nozzle N and data of a holding position and a holding posture obtained by capturing an image is used at the time of mounting.

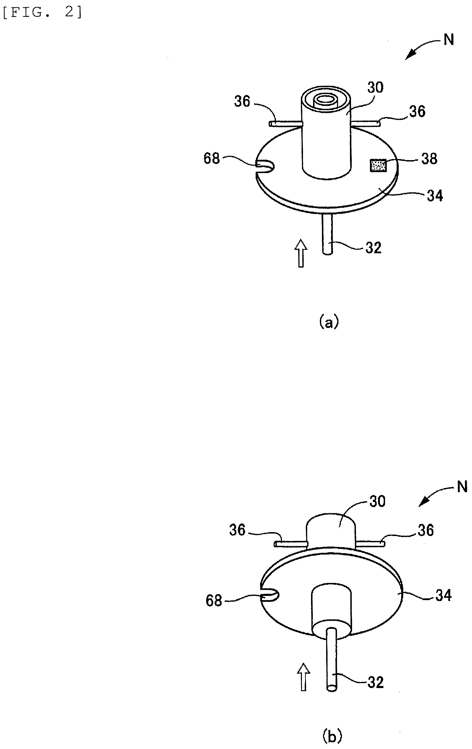

The nozzles N are targets to be managed of the management machine and the nozzles N are illustrated in Fig. 2. Fig. 2 (a) is a view illustrating the nozzles N when seen from the obliquely upper side and Fig. 2 (b) is a view illustrating the nozzles N when seen from the obliquely lower side. As understood from the figures, the nozzles N include a cylindrical barrel tube 30 functioning as a main body portion of the nozzles N; a suction pipe 32 extending to the lower side from the barrel tube 30; and a flange 34 stretching to the vicinity of the barrel tube 30 and fixed to the barrel tube 30. The upper end portion of the barrel tube 30 functions as a base end portion of the nozzle N and is held by the operational axis on the upper end portion. The suction pipe 32 functions as a tip portion of the nozzle and has a shape of a relatively thin pipe. Two interlocking pins 36 are extended to the barrel tube 30 and the nozzles N are attached to the operational axis 22 using those interlocking pins 36. A technique of attaching the nozzles N using the interlocking pins 36 is a general technique and the description here is not described and the description in other figures is also not described.

A positive pressure and a negative pressure are selectively provided through the barrel tube 30 to the suction pipe 32 from the mounting head 18. The component P is adsorbed and held by the tip (lower end) of the suction pipe 32 due to the negative pressure being supplied and the adsorbed and held component P is separated from the suction pipe 32 due to the positive pressure being supplied. In the figure, the internal structure thereof is not described, but the suction pipe 32 is configured so as to advance and retreat with respect to the barrel tube 30. Specifically, the tip portion of the nozzle N is biased by the spring force in an advancing direction from the barrel tube 30 in order to alleviate an impact added to the component P when the component P is mounted on the board S, and the tip portion thereof can be retreated, that is, retracted with respect to the barrel tube 30 in a case where a force greater than the biasing force is added thereto. In addition, the flange 34 functions as a rear surface forming member in order to make a clear image at the time when the component P is imaged by the component camera 24 and the flange 34 is a portion having the largest outer diameter in the nozzle N. A two-dimensional code 38 is attached to the upper surface of the flange 34 as an identifier for recognizing the specific information of the nozzles N. The two-dimensional code 38 show the ID of the nozzles N as a kind of the specific information and the ID is used for individual management of the nozzles N.

Although only one kind of nozzle is illustrated in the figure, various kinds of nozzles N whose size and shapes are different from one another are present. Even in the mounting machine 10, several kinds of nozzles N whose size is different from one another can be attached to the operational axis 22 and the several kinds of nozzles can be automatically exchanged according to the component P to be adsorbed and held in the mounting machine 10. In addition, the nozzles N to be used vary according to the electrical circuit (circuit in which the component P is mounted on the board S) to be produced. In addition, a plurality of nozzles N to be used in the mounting machine 10 are arranged in a nozzle station 50 provided in the mounting machine 10 on the side of the component supply device 16 in a state of being mounted on the nozzle tray NT.

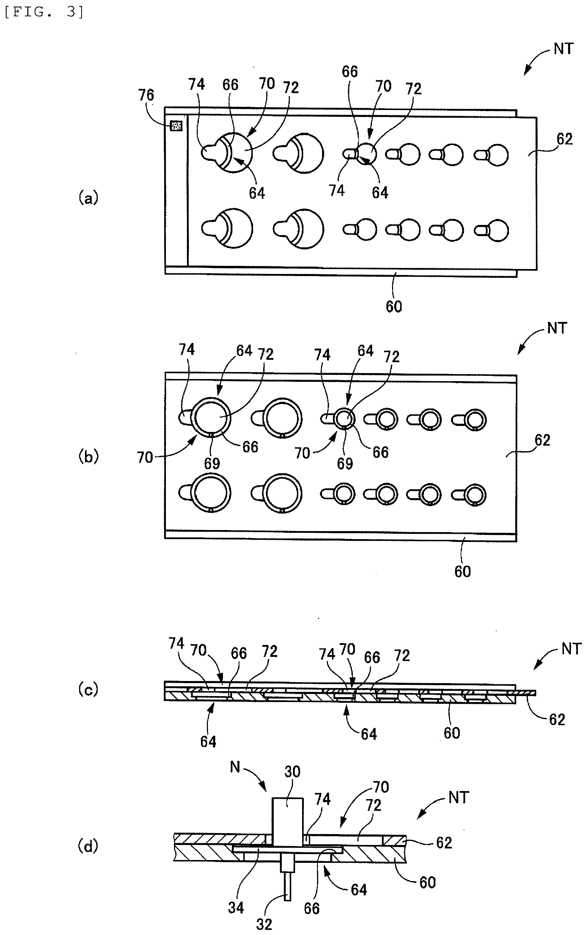

The nozzle tray (hereinafter, simply referred to as the "tray" in some cases) NT functions as a nozzle placing device for placing the nozzles N and general has a plate shape as illustrated in Fig. 3. Specifically, the tray NT includes a base plate 60 and a cover plate 62 that covers the upper surface of the base plate 60, and the cover plate 62 is configured to be slidable with respect to the base plate 60 in a certain range. Fig. 3(a) illustrates a state in which the cover plate 62 is displaced with respect to the base plate 60 and Fig. 3(b) illustrates a state in which the cover plate 62 exactly overlaps the base plate 60. The cover plate 62 is configured so as to be slidable between respective positions of the two states.

When the description is made with reference to Fig. 3(c) which is a cross-sectional view and Fig. 3 (d) which is a partial cross-sectional view illustrating a state of the nozzles N being placed, twelve placing holes 64, each of which constitutes a placing unit, are provided in the base plate 60. Specifically, two kinds of nozzles N whose size is different from each other can be placed on the tray NT, and four placing holes 64 for placing the nozzles N whose size is large and four placing holes 64 for placing the nozzles N whose size is small are provided in the tray NT. The placing hole 64 is a stepped hole in which the dimension of the inner peripheral wall is different in the depth thereof and a stepped surface 66 is a surface on which the flange 34 of the nozzle N is placed. The inner diameter of the placing hole 64 in the upper surface of the base plate 60, that is, the maximum inner diameter thereof is slightly greater than the outer diameter of the flange 34, and the placing hole 64 is configured so as to regulate the displacement (shift) of the nozzles N in the diameter direction in the outer periphery of the flange 34. In addition, the depth to the stepped surface is a depth in which the cover plate 62 is not interrupted by the flange 34 of the nozzles N placed on the placing hole 64. In addition, the nozzles N illustrated in the figure have the flange 34 which is thinner than the depth to the stepped surface and the upper surface of the flange 34 does not protrude more than the upper surface of the base plate 60 of the tray NT in the nozzles N in the state of being placed on the placing hole 64. As understood from Fig. 2, a notch 68 is provided in the outer periphery of the flange 34 and the notch 68 is engaged with a short pin 69 erected on the stepped surface 66. The nozzles N can be placed only in a specific direction due to the notch 68 and the pin 69 and rotation of nozzles N in the state of being placed on the tray NT is prevented.

Meanwhile, a loophole 70 is provided in the cover plate 62 in correspondence with the placing hole 64 of the base plate 60. The loophole 70 is formed of a circular hole portion 72 having a shape of a cycle and a slot portion 74 extending from one side of the circular hole portion 72. The inner diameter of each circular hole portion 72 is approximately equivalent to the maximum inner diameter of the corresponding placing hole 64. The width of the slot portion 74 is greater than the outer diameter, to some extent, of the barrel tube 30 of the nozzle N placed on the corresponding placing hole 64. In the state illustrated in Fig. 3(b), the center of each placing hole 64 coincides with the center of the circular hole portion 72 of the corresponding loophole 70 and the whole placing holes 64 can be seen from the upper side. Meanwhile, in the state of Fig. 3(a), the center of each placing hole 64 approximately coincides with the center of an arc present in the tip of the slot portion 74 of the corresponding loophole 70, and only a part of the placing hole 64 can be seen from the upper side. These two states are as described above and thus, conveniently, the state of Fig. 3(b) is referred to as a "placing hole open state" and the state of Fig. 3 (a) is referred to as a "placing hole closed state."

The nozzle N can be placed on the placing hole 64 of and separated from the placing hole 64 in the placing hole open state. Meanwhile, by putting the placing hole into the placing hole closed state when the nozzle N is placed on the placing hole 64, the barrel tube 30 of the nozzle N is inserted to the slot portion 74 of the loophole 70 and many portions on the upper surface of the flange 34 are covered by the cover plate 62. In this state, the separation of the nozzles N from the placing hole 64 is prevented. In regard to the prevention of the separation of the nozzles N, a mechanism formed by including the cover plate 62, that is, a nozzle separation preventing mechanism which is referred to as a so-called "shutter mechanism" is provided in the tray NT.

The cover plate 62 is biased so as to put the placing hole into the placing hole closed state by a spring (not illustrated) and the placing hole is put into the placing hole open state by allowing the cover plate 62 to slide with a force greater than the biasing force of the spring. Although not illustrated, the sliding is performed by the cover sliding mechanism disposed in the nozzle station 50. The nozzles N are attached to the operational axis of the mounting head 18 and removed from the operational axis, and the nozzles N being attached thereto are exchanged for other nozzles N when the placing hole open state is realized by the control device of the mounting machine 10 controlling the cover sliding mechanism.

The tray NT is detachably attached to the nozzle station 50 and, for example, the tray NT on which the nozzles N are placed in advance can be set in the nozzle station 50 when production of an electrical circuit is started. Further, for example, the entire tray NT on which the nozzles N being used are placed can be removed from the nozzle station 50 when the production of an electrical circuit is finished. Accordingly, the tray NT markedly contributes to speedup such as retooling of the mounting machine 10. In addition, in the tray NT, the two-dimensional code 76 is attached to one corner of the base plate 60 as an identifier for recognizing the specific information of the tray NT. The two-dimensional code 76 shows the ID of the tray NT as a kind of the specific information and the ID is used for individual management of the tray NT.

Further, the suction nozzles N and the tray NT described above are used for the mounting machine 10. The management device of Examples described below uses not only nozzles N used for the mounting machine 10 but also nozzles N used for another mounting machine as targets. In addition, the above-described tray NT is an example of the tray NT used for the mounting machine 10 and the mounting machine 10 can use other trays NT which are different from one another according to the kind thereof. Moreover, trays NT to be used are different from one another according to mounting machines. As will be described below, the mounting machine of Examples uses the nozzles N mounted or to be mounted on another tray NT as targets.

### [B] Overall configuration of nozzle management machine

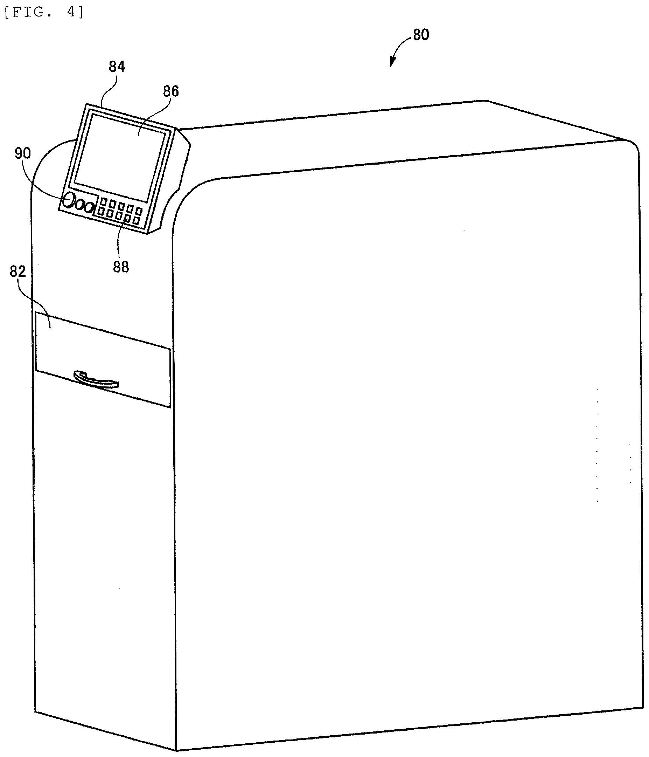

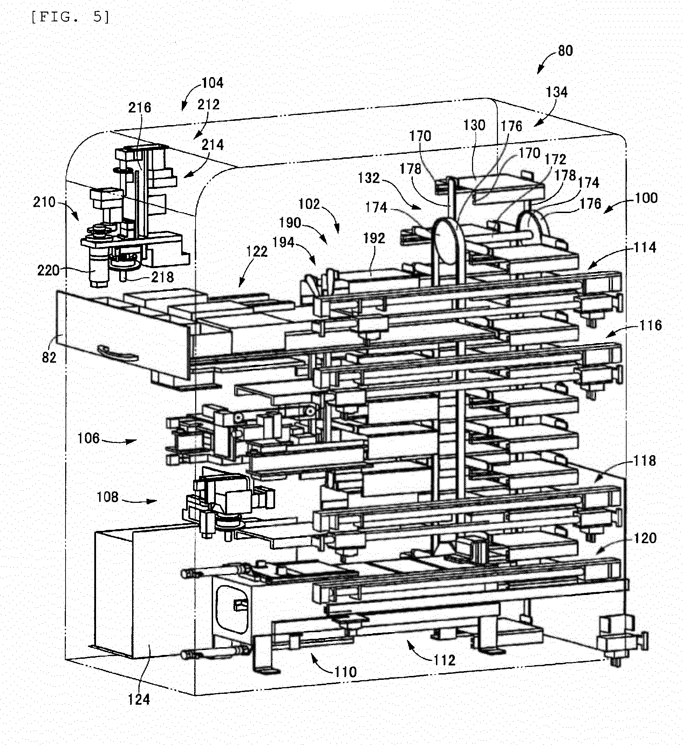

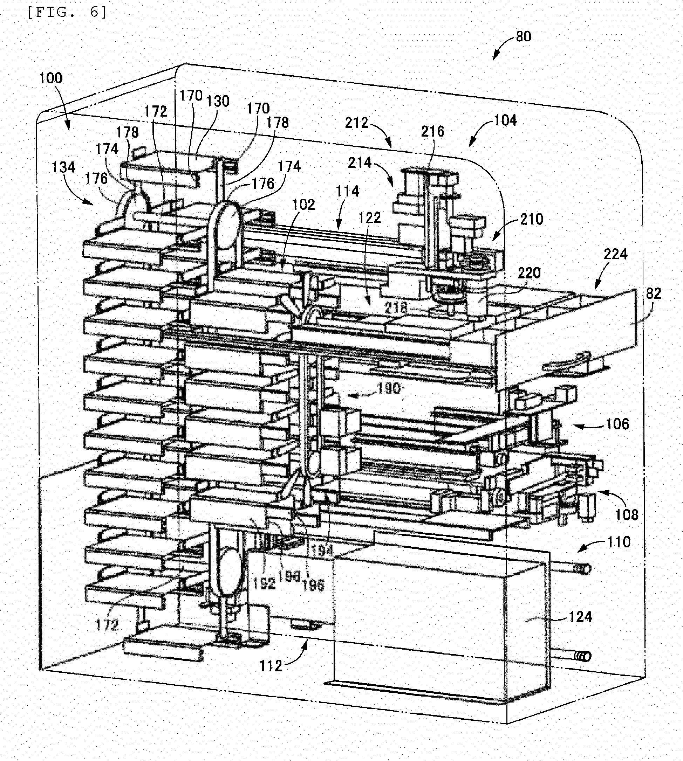

As the outer appearance is illustrated in Fig. 4, the management machine 80 of Examples has a shape of a square and the size thereof is relatively compact. A drawer 82, which will be described below in detail, is provided on the front surface (surface on the left side of the figure) of the management machine 80. Moreover, a controller 84 is attached to the upper portion of the front surface as a control device of the management machine 80. The controller 84 uses a computer as a main constituent element and includes input and output devices such as a display 86, an operation key 88, and a switch 90. Fig. 5 illustrates a management machine 80 in a state in which an exterior panel is removed and Fig. 6 illustrates the management machine 80 when seen from the opposite direction. Hereinafter, the internal structure of the management machine 80 will be described with reference to these figures. Further, in Fig. 5, the left side of the figure is the front side of the management machine 80 and the right side thereof is the rear side of the management machine 80.

The management machine 80 is configured by combining several devices. Specifically, the nozzle storing device 100 that stores the nozzles N is disposed on the rear side in a state of being placed on a nozzle pallet (hereinafter, simply referred to as a "pallet" in some cases) and a tray storing device 102 that stores the tray NT is disposed on the front left side of the nozzle storing device 100. Further, in order from the upside, the nozzle transfer device 104, the first nozzle inspecting device 106, the second nozzle inspecting device 108, and the nozzle washing device 110 are disposed on the front side of the management machine 80 as devices for performing a treatment on nozzles that perform any process with respect to the nozzles N (hereinafter, referred to as a "treatment on nozzles") stored or to be stored in the nozzle storing device 100.

Simply stated, the nozzle transfer device 104 is a device that transfers nozzles N between the tray NT and the pallet. The first nozzle inspecting device 106 performs inspection on two items, specifically, inspection related to the state of tip portion of the nozzle N (tip portion state inspection) and inspection related to necessary retreat force of the tip portion of the nozzle N (necessary retreat force inspection) and the second nozzle inspecting device 108 performs inspection on two items, specifically, inspection related to the flow rate of air passing through the nozzle N (passing flow rate inspection) and inspection related to reading the two-dimensional code 38 as an identified attached to the flange 34 of the nozzle N (identifier reading inspection) . The nozzle washing device 110 is a device washing the nozzles N with high-pressure water. In addition, the nozzle drying device 112 that dries the nozzles N washed by the nozzle washing device 110 is disposed between the nozzle storing device 100 and the nozzle washing device 110.

The transfer of the nozzles N between each device for performing a treatment on nozzles and each nozzle storing device 100 is performed by each nozzle transfer device corresponding to each device for performing a treatment on nozzles. Since the transfer of the nozzles N is performed in a state of being placed on the pallet, each of the nozzle transfer devices is used as a pallet transfer device. Specifically, a first pallet transfer device 114 that transfers a pallet between the nozzle transfer device 104 and the nozzle storing device 100; a second pallet transfer device 116 that transfers a pallet between the first nozzle inspecting device 106 and the nozzle storing device 100; a third pallet transfer device 118 that transfers a pallet between the second nozzle inspecting device 108 and the nozzle storing device 100; and a fourth pallet transfer device 120 that transfers a pallet between the nozzle washing device 110 and the nozzle storing device 100 are respectively disposed. Meanwhile, a tray transfer device 122 that transfers the tray NT between the nozzle transfer device 104 and the tray storing device 102 is disposed therebetween. Further, a driving source unit 124 in which power sources for each device described above, a driving circuit, an air compressor, and a high-pressure pump are incorporated is disposed on the front side and the lower portion of the management machine 10.

In addition, the nozzle transfer device 104 is specially treated, and each of the first nozzle inspecting device 106, the second nozzle inspecting device 108, the nozzle washing device 110, and the nozzle drying device 112 other than the nozzle transfer device 104 can be considered as a device for performing a treatment on nozzles. According to this consideration, the first pallet transfer device 114 can be considered as a pallet transfer device for transfer; and each of the second pallet transfer device 116, the third pallet transfer device 118, and the fourth pallet transfer device 120 can be considered as a pallet transfer device for a treatment.

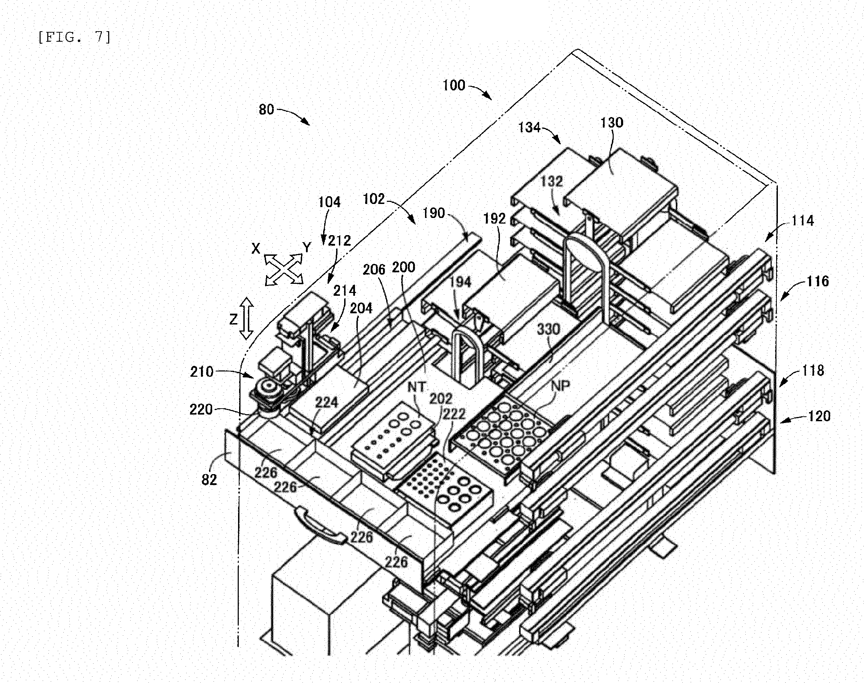

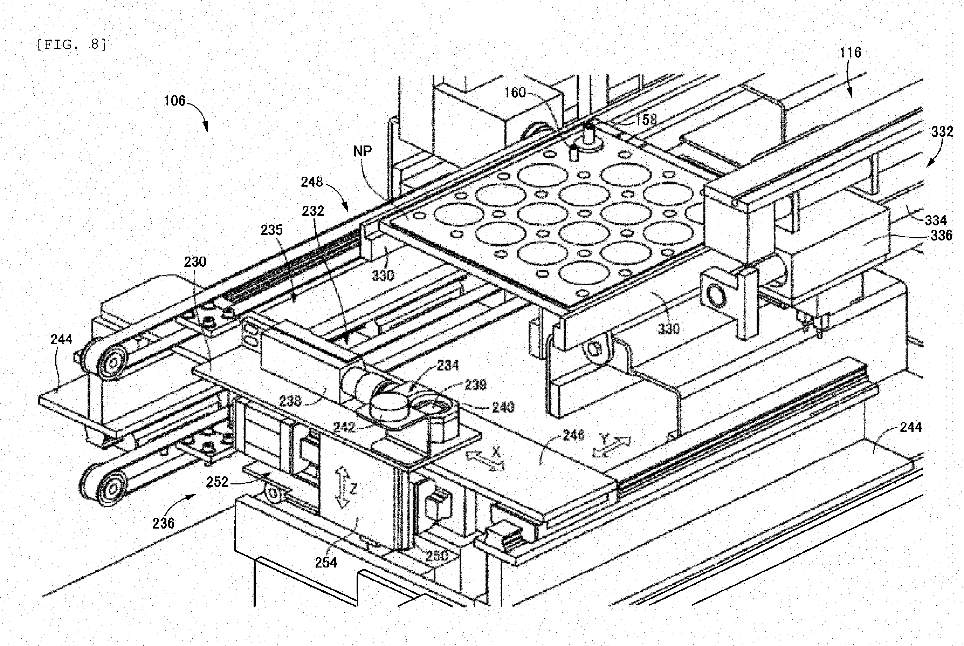

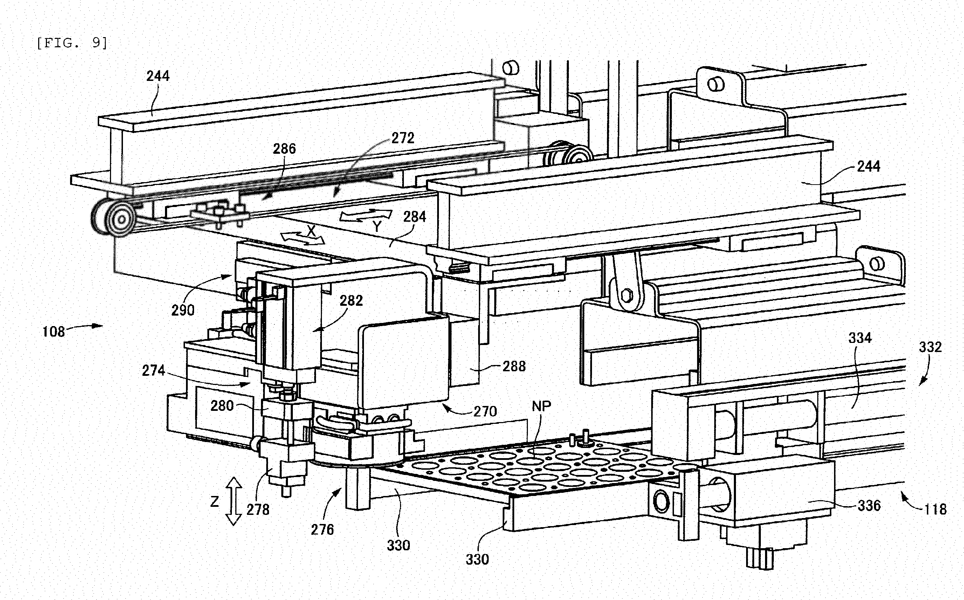

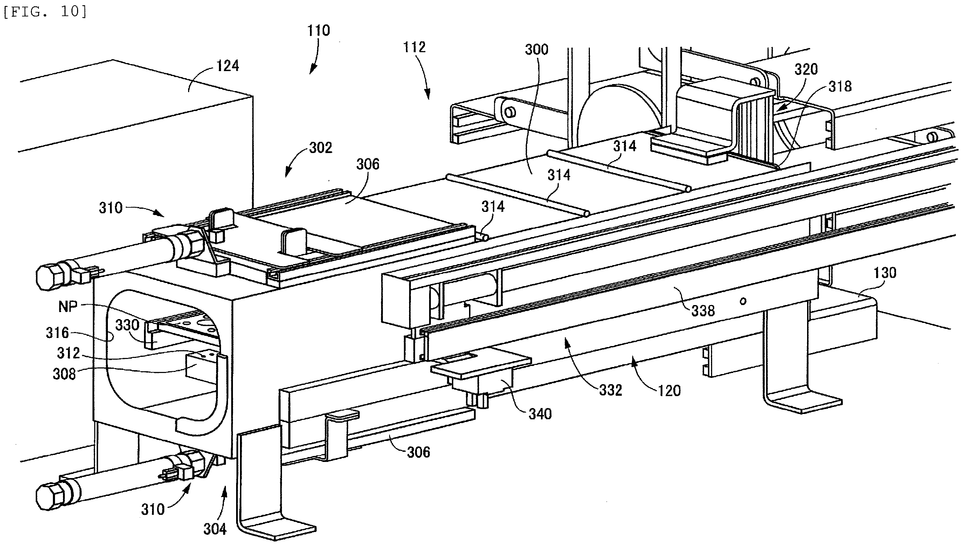

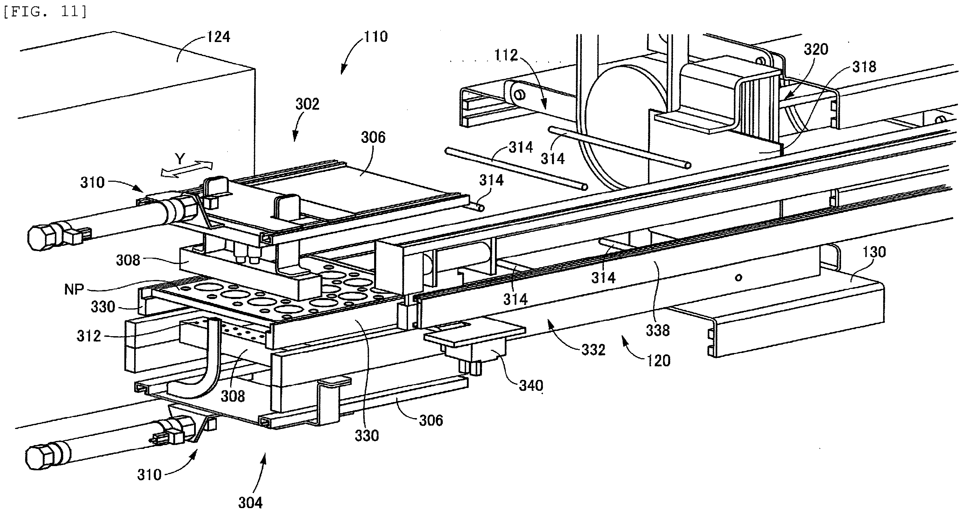

Moreover, in the description below, the nozzle storing device, the tray storing device, the nozzle transfer device, the nozzle inspecting device, the nozzle washing device, the nozzle drying device, the pallet transfer device, and the tray transfer device are respectively referred to as the "storing device," the "storing device," the "transfer device," the "inspecting device," the "washing device," the "drying device," the "transfer device," and the "transfer device" in some cases. In addition, the description below will be made with reference to Fig. 7 illustrating the transfer device 104, Fig. 8 illustrating the first inspecting device 106, Fig. 9 illustrating the second inspecting device 108, and Figs 10 and 11 illustrating the washing device 110 and the drying device 112.

### [C] Nozzle storing device

The nozzle storing device 100 includes a plurality of pallet carriers (hereinafter, also simply referred to as a "carrier") 130 in which the above-described pallets are respectively stored and a carrier circulating mechanism (hereinafter, also simply referred to as a "circulating mechanism") 132 that circulates the carriers 130, and a pallet moving device (hereinafter, also simply referred to as a "moving device") 134 that moves a plurality of pallets in the storing device 130 is configured by the plurality of carriers 130 and a circulating mechanism 132. Hereinafter, the storing device 100 will be described by dividing pallets and a moving device 134.

### i) Nozzle pallet

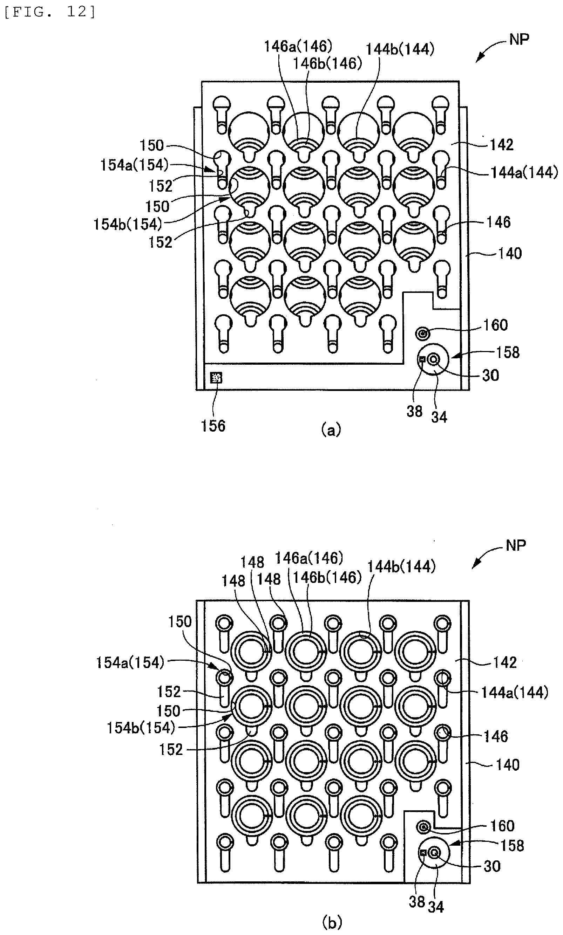

The pallet NP functions as a nozzle placing device for placing the nozzles N and includes a base plate 140 and a cover plate 142 that covers the upper surface of the base plate 140 as illustrated in Fig. 12 in the same manner as that of the tray NT described above. Fig. 12(a) illustrates a state in which the cover plate 142 is displaced with respect to the base plate 140 and Fig. 12(b) illustrates a state the cover plate 142 exactly overlaps the base plate 140. The cover plate 142 is configured so as to be slidable between respective positions of the two states.

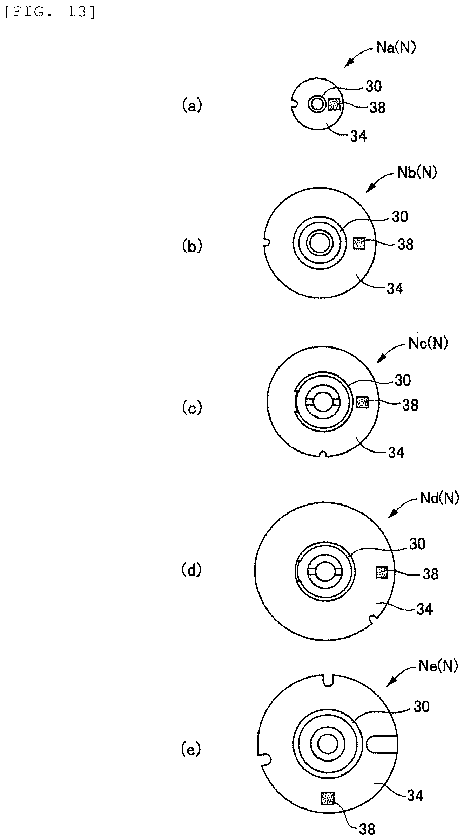

Conveniently, in the management machine 80, when five kinds of nozzles N illustrated in Fig. 13 are used as the targets of the management, all five kinds of nozzles N can be placed on the pallet NP. Five kinds of nozzles N are different from each other in terms of the shape and can be classified into three kinds in terms of the outer diameter of the flange 34. Fig. 13 is a view when the nozzles N are seen from the upper side and, specifically, the nozzles N can be classified into a nozzle Na whose size is small illustrated in Fig. 13(a); nozzles Nb and Nc whose size is medium illustrated in Figs. 13(b) and 13(c); and nozzles Nd and Ne whose size is large illustrated in Figs. 13(d) and 13(e). Placing holes 144 respectively constituting a placing unit are provided in the base plate 140 in the same manner as that of the tray NT. Specifically, twenty four placing holes 144a on which small nozzles N are placed and fifteen placing holes 144b on which large nozzles N are placed are provided and the nozzles Na are placed on the placing hole 144a and the nozzles Nb, Nc, Nd, and Ne are placed on the placing hole 114b.

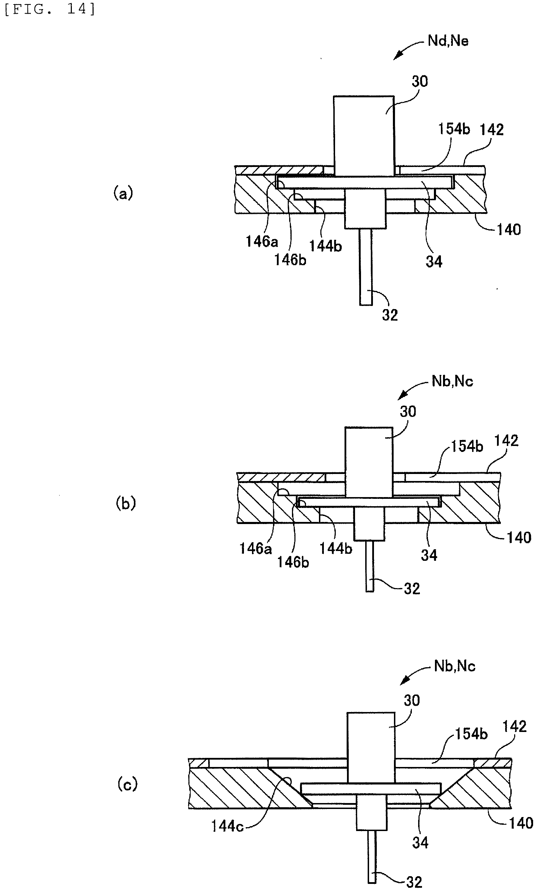

Since the placing hole 144a has one stepped surface 146 similar to the placing hole 64 of the tray NT described above, the description thereof is not repeated. When description of the placing hole 144b is made with reference to Fig. 14 illustrating a state of placing the nozzles N, the placing hole 144b is a stepped hole in which the dimension of the inner peripheral wall is different in the depth thereof and, specifically, a stepped hole having two stepped surfaces 146a and 146b. As illustrated in Fig. 14(a), nozzles Nd and Ne whose size is large are placed on the stepped surface 146a positioned on the upper side. Meanwhile, as illustrated in Fig. 14(b), the nozzles Nb and Nc whose size is medium are placed on the stepped surface 146b positioned on the lower side. That is, both stepped surface 146a and 146b are surfaces on which the nozzles N are placed. In the placing hole 144b, the internal dimension of the inner peripheral wall is different in the depth direction and the flange 34 of plural kinds of nozzles N which are different in the outer diameter of the flange 34 are configured so as to be embedded in the position with different depths. In addition, the placing hole 144b is configured so as to regulate the displacement (shift) of the nozzles N in the diameter direction in the outer periphery of the flange 34 with respect to all nozzles N. A pin 148 engaging with the notch 68 of the flange 34 is erected on both stepped surfaces 146a and 146b for the purpose of preventing rotation of the nozzles N.

Further, in place of the placing hole 144b in a form in which the above-described plurality of stepped surfaces 146 are included, as illustrated in Fig. 14(c), a tapered placing hole 144c whose inner dimension of the inner peripheral wall is reduced in the axis direction, that is, in the depth direction can be employed. Even in the case of the placing hole 144c, the flange 34 of the plural kinds of nozzles N which are different in the outer diameter of the flange 34 is embedded in a portion having depths different from each other. In addition, the figure illustrates the state of placing the nozzles Nb and Nc whose size is medium. In a case of the nozzles Nd and Ne whose size is large are placed, the nozzles Nd and Ne are placed in a position upper than the position of the nozzles Nb and Nc.

Meanwhile, loopholes 154a and 154b respectively having a circular portion 150 and a slot portion 152 are provided in the cover plate 142 in correspondence with the placing holes 144a and 144b of the base plate 140 similar to the tray NT. In the state illustrated in Fig. 13(b), the center of each placing hole 144 coincides with the center of the circular portion 150 of the corresponding loophole 154 and the above-described placing hole open state is realized. Meanwhile, in the state of Fig. 13(a), the center of each placing hole 144 approximately coincides with the center of an arc present in the tip of the slot portion 74 of the corresponding loophole 154, and the placing hole closed state is realized. With such a structure, in regard to prevention of the separation of the nozzles N, a mechanism including the cover plate 142, that is, a nozzle separation preventing mechanism which is referred to as a so-called "shutter mechanism" is provided in the pallet NP. In addition, similar to the tray NT, the cover plate 142 is biased by a spring (not illustrated) so as to put into the placing hole closed state and the placing hole is put into the placing hole open state by sliding the cover plate 142 with a force greater than the biasing force of the spring.

Similar to the tray NT, in the pallet NP, a two-dimensional code 156 is attached to one corner of the base plate 140 as an identifier for recognizing the specific information of the Pallet NP. The two-dimensional code 156 shows the ID of the Pallet NP as a kind of the specific information and the ID is used for individual management of the tray NP.

In the pallet NP, a reference nozzle 158 is fixed to one corner portion of the base plate 140 and a reference pipe 160 is fixed to the side of the reference nozzle 158, and both are in a state of passing through the base plate 140. The reference nozzle 158 is practically a nozzle N, specifically, the above-described nozzle Nb. Meanwhile, the reference pipe 160 is a part of the nozzle N, specifically, a simulated object that simulates the barrel tube 30 and the suction pipe 32. The reference nozzle 158 and the reference pipe 160 function as reference targets to be referenced in the inspection performed by the above-described first inspecting device 106 and the second inspecting device 108 and are used for at least one of setting a reference of inspection performed by the inspecting devices 106 and 108, calibration or examination of the inspecting devices 106 and 108. Although the specific use thereof will be described below, the reference nozzle 158 is referenced in the necessary retreat force inspection using the first inspecting device 106 and the identifier reading inspection using the second inspecting device. Further, the reference pipe 160 is referenced in the tip portion state inspection using the first inspecting device 106 and in the passing flow rate inspection using the second inspecting device 108. In addition, the reference nozzle 158 and the reference pipe 160 are configured such that excellent inspection results can be generally obtained in the inspection to be referenced as reference targets. In addition, in the management machine 80, the reference target is provided in the pallet NP, but may be provided, for example, in the body of the management machine 80 or other devices in the positions in which the inspection can be performed by the first inspecting device 106 and the second inspecting device 108.

### ii) Pallet moving device

As described above, the pallet moving device 134 includes a plurality of pallet carriers 130 and the carrier circulating mechanism 132. The carrier 130 is a member which generally has a shape of a channel, that is, whose cross-section has a shape of a "U" character, and the carriers are arranged in a posture in which opening portions in the channel shape are directed to the lower side. A pair of rails 170 are attached to the lower end portion of the carrier 130, specifically, the inside of the lower end portion of two flanges in the channel shape, and the above-described pallet NP is held so as to be discharged toward the front side by the pair of rails 170 or so as to be inserted from the front side thereof.

As understood from Figs. 5 and 6, the carrier circulating mechanism 132 includes a pair of sprocket axes 172 respectively disposed in the vertical direction. The sprocket axes 172 are disposed in a state of being extended in the longitudinal direction and have sprockets 174 on each of the end portions in the longitudinal direction. A chain 176 is wound between the sprocket 174 in the front sides of the pair of sprocket axes 172 and between the sprocket 174 on the rear sides thereof. A plurality of brackets 178 are extended toward the outside at a right angle to each of the chain 176 on the front side and the chain 176 on the rear side and one carrier 130 is swingably supported by each tip of the brackets 178 on the front side and each tips corresponding to the brackets 178 on the rear side. Since one of the pair of sprocket axis 172 is a driving axis, each bracket 178 is rotated by allowing one of the pair to rotate. In this manner, each carrier 130 supported by each bracket 178 is concurrently rotated. In addition, the pallet NP is held by the carrier 130 in a posture in which the surface on which the nozzles N are placed is directed to the upper side, that is, in a posture in which the cover plate 142 is positioned on the upper side, and the supporting structure of the carrier 130 supported by the bracket 178 is configured so as to maintain the posture of the pallet NP even in a case where the carrier 130 is in any rotating position.

Since the carrier circulating mechanism 132 has the above-described structure, the pallet moving device 134 is considered as a pallet circulating device that circulates and moves a plurality of pallets NP concurrently, that is, all together, along a certain path parallel to a plane which is vertically arranged in the storing device 100. Moreover, in the moving device 134, a plurality of set positions corresponding to the above-described respective devices 104 to 108 for performing a treatment on nozzles, that is, a plurality of set positions corresponding to the first to fourth pallet transfer devices 114 to 120 are set as stop positions of each pallet NP. The set position can be considered as a station in the circulation of the pallet NP and the management machine 80 is configured such that the pallet NP moved and stopped in a specific station is transferred to the corresponding devices 104 to 108 for performing a treatment on nozzles by the first to fourth transfer devices 114 to 120 corresponding to the station. In addition, in a case where the carrier 130 not holding the pallet NP is positioned in a specific station, the pallet NP can be transferred from the corresponding devices 104 to 108 for performing a treatment on nozzles to the carrier 130 by the first to fourth transfer devices 114 to 120 corresponding to the station.

The nozzles N between the device for performing a treatment on nozzles and the nozzle storing device 100 are transferred by the nozzle transfer device corresponding to the device for performing a treatment on nozzles. Since the nozzles N are transferred in a state of being placed on the above-described pallet NP, the nozzle transfer device is used as the pallet transfer device. Specifically, the first pallet transfer device 114 that transfers a pallet between the nozzle transfer device 104 and the nozzle storing device 100; the second pallet transfer device 116 that transfers a pallet between the first nozzle inspecting device 106 and the nozzle storing device 100; the third pallet transfer device 118 that transfers a pallet between the second nozzle inspecting device 108 and the nozzle storing device 100; and the fourth pallet transfer device 120 that transfers a pallet between the nozzle washing device 110 and the nozzle storing device 100 are respectively disposed. In addition, the nozzle transfer device has a function of transferring one or more nozzles N as a one nozzle group and the nozzle transfer device 104, the first nozzle inspecting device 106, the second nozzle inspecting device 108, and the nozzle washing device 110, each of which is a device for performing a treatment on nozzles, perform a process on the nozzles N included in one nozzle group transferred by the nozzle transfer device as described below in detail.

### [D] Tray storing device

The tray storing device 102 is a device that stores the nozzle tray NT described above, includes a tray moving device (hereinafter, also simply referred to as a "moving device") 190 similar to the pallet moving device 134 of the nozzle storing device 100, and uses the moving device 190 as a main constituent element. The moving device 190 includes a plurality of tray carriers (hereinafter, also simply referred to as a "carrier") 192 in which the tray NT is stored similar to the pallet moving device 134 and a carrier circulating mechanism (hereinafter, also simply referred to as a "circulating mechanism") 194 that circulates the carriers 192.

The carrier 192 is a member which generally has a shape of a channel, that is, whose cross-section has a shape of a "U" character similar to the pallet carrier 130 described above, and the carriers are arranged in a posture in which opening portions in the channel shape are directed to the lower side. Similar to the pallet carrier 130, a pair of rails 196 are attached to the lower end portion of the carrier 192, specifically, the inside of the lower end portion of two flanges in the channel shape, and the tray NT is held so as to be discharged toward the front side by the pair of rails 196 in a posture in which the surface on which the nozzles N are placed is directed to the upper side or so as to be inserted from the front side thereof.

As illustrated from Figs. 5 and 6, the circulating mechanism 194 includes a pair of sprocket axes respectively having two sprockets in the vertical direction, a pair of chains, and a plurality of brackets extended to each chain and is configured so as to rotate respective carriers 192 supported by respective brackets at the same time, similar to the circulating mechanism 132 of the pallet moving device 134. The tray moving device 190 including the circulating mechanism 194 having such a structure is used as a tray circulating device that circulates and moves a plurality of pallets NP concurrently, that is, all together, along a certain path parallel to a plane which is vertically arranged in the storing device 102, similar to the pallet moving device 134 described above. Moreover, in the tray moving device 190, one set position corresponding to the above-described nozzle transfer device 104, that is, one set position corresponding to the tray transfer devices 122 is set as a stop position of each pallet NP. In a case where the tray NT, which is moved and stopped in the set position, that is, the station, is transferred to the transfer device 104 by the tray transfer device 122 and the carrier 192 not holding the tray NT is positioned in the station, the tray NT can be transferred from the transfer device 104 to the carrier 192 by the tray transfer device 122.

### [E] Nozzle transfer device

In the management machine 80, in order to set the nozzles N stored in the storing device 100 in the tray NT, the nozzles N are transferred from the pallet NP to the tray NT. Further, in order to store the nozzles N in the storing device 100, the nozzles N are transferred to the pallet NP from the tray NT. When the former is referred to as "setting transfer" and the latter is referred to as "storage transfer," the setting transfer and the storage transfer are performed by the above-described nozzle transfer device 104 positioned in the upper portion of the front side of the management machine 80.

As illustrated in Fig. 7, the drawer 82 (in the figure, in a state of slightly being pulled out) included in the management machine 80 includes a table 200 and the tray NT provided for the transfer is set one of a fixed stage 202 and a movable stage 204 provided in the table 200. The fixed stage 202 is fixed to the table 200 and the movable stage 204 is supported by the table 200 so as to be slidable in the longitudinal direction by a stage slide mechanism 206 provided in the table 200. In addition, in the figure, the fixed stage 202 and the movable stage 204 respectively illustrate a state in which the tray NT is set and a state in which the tray NT is not set. Moreover, in the figure, a state in which the movable stage 204 is positioned in a set position which is the front end in the transfer range, that is, the transfer position is illustrated. Further, for the sake of simplicity, the structure related to holding the tray NT of the stages 202 and 204 and the nozzles N placed on the tray NT are not illustrated. In addition, cover sliding mechanisms (not illustrated) that-slide the cover plate 62 are respectively provided in the fixed stage 202 and the movable stage 204 as a mechanism for making the state of the set tray NT into the placing hole open state described above.

An operator is capable of setting the tray NT and removing the set tray NT in a state in which the drawer 82 is pulled out with respect to both of the fixed stage 202 and the movable stage 204. In addition, the tray NT can be transferred between the tray storing device 102 and the movable stage 204 in a state in which the movable stage 204 is positioned in the rear end position in the moving range. Specifically, the tray NT is transferred between the carrier 192 positioned in the above-described set position, that is, the station corresponding to the transfer device and the movable stage 204 in the storing device 102. Moreover, the tray transfer mechanism which is a mechanism for transferring the tray NT is not described here. Further, the above-described tray transfer device 122 that transfers the tray NT between the set position on the table 200 and the storing device 102, specifically, the transfer device 104 and the storing device 102 is configured by including the movable stage 204, the stage slide mechanism 206, and the tray transfer mechanism.

As understood from the description above, in the management machine 80, the setting transfer with respect to the tray NT brought from the outside and set in the fixed stage 202 or the movable stage 204 is possible and the setting transfer to the tray NT stored in the storing device 102 is also possible. Further, the tray NT in which the nozzles N are set and the tray NT which brought from the outside in a state in which the nozzles N are placed can be stored in the storing device 102.

The pallet NP provided for the setting transfer and the storage transfer is transferred from a set position corresponding to the transfer device 104 in the nozzle storing device 100, that is, the carrier 130 positioned in the station corresponding to the transfer device to a set position in which the nozzles N can be transferred by the transfer device 104, that is, a transfer position using the first pallet transfer device 114 (the structure thereof will be described below). The position in which the pallet NP is positioned in the figure is the transfer position. The pallet NP provided for the setting transfer and the storage transfer is transferred to the carrier 130 positioned in the station corresponding to the transfer device in the storing device 100 by the first transfer device 114 after the setting transfer and the storage transfer are finished. Moreover, for the sake of simplicity, the nozzles N placed on the pallet NP are not illustrated in the figure. In addition, a pallet fixing mechanism (not illustrated) that fixes the pallet NP positioned on the transfer position to the position is provided in the first transfer device 114 and a cover sliding mechanism (not illustrated) that slides the cover plate 142 is provided on the table 200 as a mechanism for making the state of the pallet NP positioned in the transfer position into the placing hole open state.

The transfer device 104 is arranged on the upper side of the table 200 and includes a transfer head 210 and a head moving device 212 having three head moving mechanisms that move the transfer head 210 in the horizontal direction, the longitudinal direction, and the vertical direction (hereinafter, also respectively referred to as the "X direction," the "Y direction," and the "Z direction"). As understood from Figs. 5 and 6 in addition to Fig. 7, an X direction moving mechanism that moves the transfer head 210 in the X direction and a Y direction moving mechanism that moves the transfer head 210 in the Y direction are not illustrated in these figures and only a Z direction moving mechanism 214 is illustrated. In addition, the X direction moving mechanism and the Y direction moving mechanism constitute an XY type moving device that is disposed in the upper portion of the body of the management machine 80 and moves the slide 216 along a plane at a right angle to the Z direction, and the Z direction moving mechanism 214 is disposed in the slide 216.

A holding chuck 218 serving as a nozzle holding jig for holding the nozzles N to be transferred and a camera 220 serving as an identifier reader for reading two-dimensional codes 38, 76, and 156 respectively provided for the nozzles N, the tray NT, and the pallet NP are attached to the lower portion of the transfer head 210. Further, the transfer head 210 includes a chuck rotating mechanism that rotates the holding chuck 218 around the axis. In addition, the above-described head moving device 212 functions as a holding jig moving device that moves the holding chuck 218 which is a nozzle holding jig.

When a basic operation of the transfer device 104 is simply described, the transfer head 210 is moved by the head moving device 212 and at least one of the two-dimensional code 76 provided for the tray NT and the two-dimensional code 156 provided for the pallet NP is imaged by the camera 220 while at least one of the setting transfer and the storage transfer is performed. Further, the transfer head 210 is moved, by the head moving device 212, to the upper side of the pallet NP or the tray NT which becomes a transfer source, the two-dimensional code 38 of the nozzles N serving as the target of transfer is imaged by the camera 220, the nozzles N are held by the holding chuck 218, and the transfer head 210 is moved, by the head moving device 212, to the upper side of the tray NT or the pallet NP which becomes a transfer destination, and the held nozzles N are separated from the holding chuck 218 and then placed on specific or optional placing holes 64 and 144 of the tray NT or the pallet NP.

Moreover, a placing plate 220 such that the base plate 140 of the pallet NP, specifically, a placing plate 222 having several placing holes is disposed on the table 200, and the placing plate 222 is used for temporary placing of the nozzles N while the nozzles N are set in the tray NT or the nozzles N are stored in the storing device 100. A defective box 224 is detachably disposed on the table 200 as a defective nozzle indwelling device that indwells nozzles N determined as defectives, that is, defective nozzles based on the results of the inspection on various items. As understood from the figures, the defective box 224 is partitioned into four spaces 226 and each of the four spaces 226 is respectively used as an indwelling unit that distinguishes defective nozzles from other nozzles and indwells the defective nozzles. Although the use of the defective box 224 will be described below, the transportation of the defective nozzles to the defective box 224 is performed by the nozzle transfer device 104 after setting the nozzles N in the tray NT or regardless of the setting. Accordingly, the transfer device 104 functions as a defective nozzle transporting device.

### [F] First nozzle inspecting device

The first nozzle inspecting device 106 is a device that is positioned on the lower side of the nozzle transfer device 104 and performs inspection on two items, specifically, tip portion state inspection and necessary retreat force inspection as described above. When described with reference to Fig. 8, after the pallet NP positioned in the set position in the above-described storing device 100, that is, the station corresponding to the first inspecting device is transferred to the inspection position by the above-described second pallet transfer device 116 (the structure thereof will be described below), the tip portion state inspection and the necessary retreat force inspection of the nozzles N placed on the pallet NP are performed by the first inspecting device 106 from the lower side of the nozzles N. Further, the position of the pallet NP illustrated in the figure is the above-described inspection position and a pallet fixing mechanism (not illustrated) that fixes the pallet NP to the inspection position is provided in the second transfer device 116. In addition, for the sake of simplicity, the nozzles N placed on the pallet NP is not illustrated in the figure.

The first inspecting device 106 includes a base 230, an inspecting unit 235 having a camera device 232 and a load measuring device 234 fixed on the base 230, and a unit moving device 236 moving the inspecting unit 235, and the inspecting unit 235 moves the space on the lower side of the pallet NP positioned in the inspection position. The camera device 232 includes a camera main body 238, a lens 239, a ringlight 240 that is positioned so as to surround the lens 239 as a light source, and the load measuring device 234 uses a load cell 242 as a main constituent element. The unit moving device 236 includes a movable beam 246 that is supported by a pair of beams 244 that form a part of the body of the management machine 80; a Y direction moving mechanism 248 having a belt driving system that moves the movable beam 246 in the Y direction; an X direction moving mechanism 252 that moves a slide 250 supported by the movable beam 246 in the X direction; and a Z direction moving mechanism 254 that fixes to the slide 250, supports the inspecting unit 235 in the base 230, and moves the inspecting unit 235 in the Z direction. In summary, according to the first inspecting device 106, the tip portion state inspection and the necessary retreat force inspection are both performed on the tip portion side of the nozzles N, and the camera device 232 and the load measuring device 234 which are main constituent elements for performing inspection on various items are arranged in the space present on the tip portion side of the nozzles N and those are moved by the unit moving device 236 which is a kind of moving device.

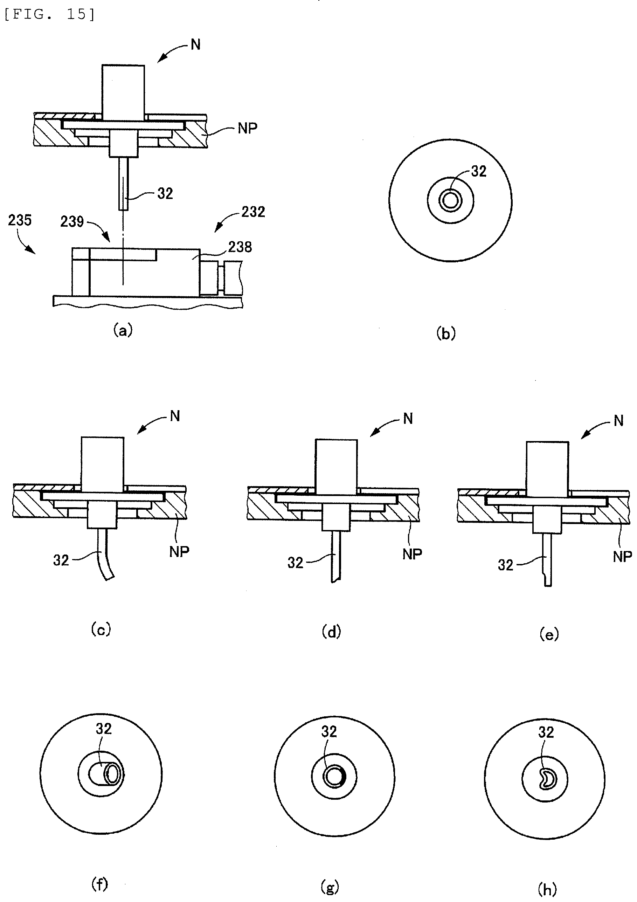

In the tip portion state inspection performed by the first inspecting device 106, as illustrated in Fig. 15 (a), the inspecting unit 235 is moved to a position by the unit moving device 236, which is positioned directly below the nozzles N inspected by the lens 239 of the camera device 232. Specifically, the position of the suction pipe 32 of the nozzles N in the Z direction can be recognized from the specific information of the nozzles N, the inspecting unit 235 is positioned in the position in which the lens 239 is separated from the tip of the suction pipe 32 by a set distance. In this state, the tip portion of the nozzle N, that is, the suction pipe 32 is imaged by the camera device 232.

The nozzle N illustrated in Fig. 15 (a) is a nozzle N whose shape of the suction pipe 32 is normal and Fig. 15(b) illustrates an image captured by the camera device 232 of the suction pipe 32 of the nozzle N. Further, Figs. 15(c) to 15(e) respectively illustrate a nozzle N with "curvature, " "chipping of the tip, " and "crushing of the tip" of the suction pipe 32, and the captured images of the suction pipes 32 of the nozzle N are illustrated in Figs. 5(f) to 5(g). In the tip portion state inspection, it is confirmed whether the shape abnormality of the tip portion such as the "curvature," the "chipping of the tip, " or the "crushing of the tip" is generated in a nozzle N based on the image data of the nozzles N captured by the camera device 232. Further, although not illustrated, "attachment of foreign matters" or "attachment of dirt" to the tip portion is confirmed as well. A nozzle N in which shape abnormality is generated in the tip portion and a nozzle N in which a foreign matter or dirt is attached to the tip portion is determined as a defective nozzle. In addition, although the description will be made below in detail, the tip portion of the reference pipe 160 fixed to the pallet NP is imaged by the camera device 232 whenever abnormality on the state of the tip portion of any nozzle N is confirmed, and a nozzle N in which abnormality is confirmed in the state of the tip portion is certified as a defective nozzle under the condition in which abnormality is not found in the tip portion of the reference pipe 160 after confirmation whether abnormality is generated based on image data of the tip portion of the reference pipe 160. That is, the reference pipe 160 as a reference target is used for examination of the first inspecting device 106, specifically, for post-examination.

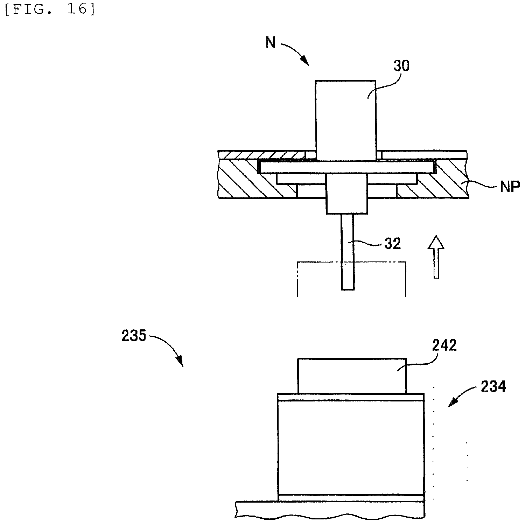

In the necessary retreat force inspection performed by the first inspecting device 106, as illustrated in Fig. 16, the inspecting unit 235 is moved to a position, by the unit moving device 236, positioned directly below the nozzle N to be inspected by the center of the load cell 242 of the load measuring device 234. In this position, the inspecting unit 235 is lifted by the set distance based on the specific information of the nozzles N. Specifically, the load measuring device 234 is lifted to a position in which the suction pipe 32 of the nozzles N retreats by a certain distance with respect to the barrel tube 30.

As described above, the suction pipe 32 is biased to the advancing direction from the barrel tube 30 by a spring, and the tip of the suction pipe 32 is brought into contact with the upper surface of the load cell 242 in the case where the load measuring device 234 is lifted, and a load corresponding to the biasing force of the spring is applied to the load cell 242 in this state. The load cell 242 measures the load. The biasing force due to the spring can be recognized from the specific information of the nozzles N and the necessary retreat force of the suction pipe 32 is excessive in a case where a load greater than the biasing force is detected by the load cell 242. For example, the suction pipe 32 is not easily drawn into the barrel tube 30 due to the mixture of foreign matters into the nozzles N or damage of the barrel tube 30, and the necessary retreat force becomes excessive in this case. In a case where the necessary retreat force is greater than the threshold force set based on the specific information, the necessary retreat force is certified as excessive and the nozzle N is determined as a defective nozzle. Moreover, in a case where the necessary retreat force inspection of the nozzles N being placed on one pallet NP is performed, the load applied to the above-described reference nozzle 158 is measured prior to the inspection, and calibration of the load cell 242, that is, adjustment for making the load value measured by the load cell 242 become equivalent to the actual value is performed based on the measured load. That is, the reference nozzle 158 as the reference target is used for calibration of the load measuring device 234 performed as a preliminary process of the necessary retreat force inspection performed by the first inspecting device 106, in other words, calibration of the first inspecting device 106.

Moreover, the tip portion state inspection and the necessary retreat force inspection performed by the first inspecting device 106 may be performed on all nozzles N being placed on one pallet NP or on some nozzles N. In addition, both inspections may be performed or only one of them may be performed. After the inspection on the placed nozzles N is finished, the pallet NP positioned in the inspection position is transferred to the carrier 130, by the second transfer device 116, positioned in the station corresponding to the first inspecting device in the storing device 100.

### [G] Second nozzle inspecting device

As described above, the second nozzle inspecting device 108 is a device that is positioned on the lower side of the first nozzle inspecting device 106 and performs inspection on two items, specifically, passing flow rate inspection and identifier reading inspection. When described with reference to Fig. 9, after the pallet NP positioned in the set position in the above-described storing device 100, that is, the station corresponding to the second inspecting device is transferred to the inspection position by the above-described third pallet transfer device 118 (the structure thereof will be described below), the passing flow rate inspection and the identifier reading inspection of the nozzles N placed on the pallet NP are performed by the second inspecting device 108 from the upper side of the nozzles N. Further, the position of the pallet NP illustrated in the figure is the above-described inspection position and a pallet fixing mechanism (not illustrated) that fixes the pallet NP to the inspection position is provided in the third transfer device 118. In addition, for the sake of simplicity, the nozzles N placed on the pallet NP is not illustrated in the figure.

The second inspecting device 108 includes an inspection head 270 and a head moving device 272 that moves the inspection head 270 along a plane parallel to the upper surface of the pallet NP on the upper side of the pallet NP. An air carrying device 274 and a camera 276 as an identifier reader are provided in the inspection head 270 parallel to each other. The air carrying device 274 includes an air joint 278 that is connected to the upper end portion of the barrel tube 30 which is the based end portion of the nozzle N and compressed air is supplied to the nozzle N from the air joint 278. The air pressure sensor 280 that measures the air pressure of a supply path of the compressed air to be supplied is disposed on the upper side of the air joint 278 integrally with the air joint 278. In addition, the air carrying device 274 includes a joint elevating mechanism 282 that elevates the air joint 278 and the air joint 278 is elevated by the joint elevating mechanism 282 with respect to the inspection head 270. The head moving device 272 includes a movable beam 284 that is supported by a pair of beams 244 that is described related to the first inspecting device 106; a Y direction moving mechanism 286 having a belt driving system that moves the movable beam 284 in the Y direction; and an X direction moving mechanism 290 that moves a slide 288 supported by the movable beam 284 in the X direction. In summary, according to the second inspecting device 108, the passing flow rate inspection and the identifier reading inspection are both performed on the base end portion side of the nozzles N, and the air carrying device 274 and the camera 276 which are main constituent elements for performing inspection on various items are arranged in the space present on the base end portion side of the nozzles N and those are moved by the head moving device 272 which is a kind of moving device.

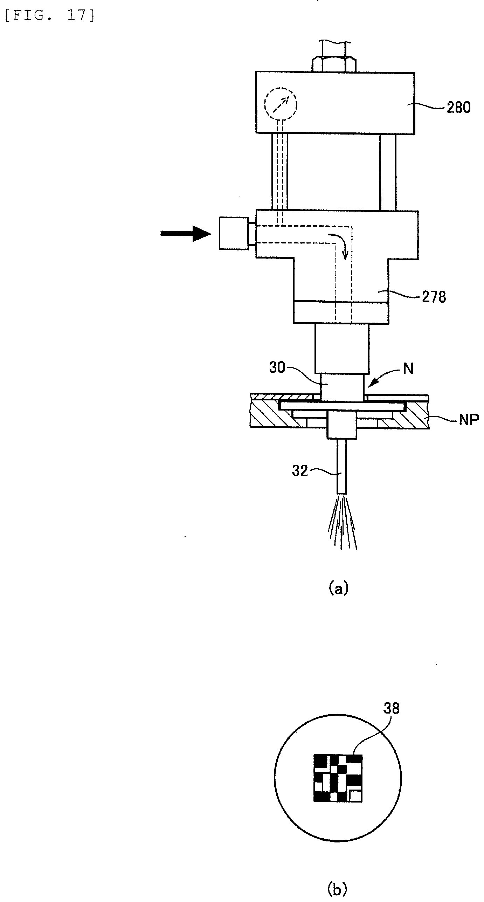

In the passing flow rate inspection performed by the second inspecting device 108, the inspection head 270 is moved to a position, by the head moving device 272, in which the air joint 278 is positioned on the right above the nozzle to be inspected. In this state, the air joint 278 is lowered so as to be connected with the nozzle N by the joint elevating mechanism 282. As illustrated in Fig. 17(a), in a state in which the air joint 278 is connected to the nozzle N, the air carrying device 274 carries the compressed air to the nozzle N. In a normal nozzle N, the air which is not so resistive is allowed to pass through, a flow rate is sufficiently secured, and the air pressure to be measured by the air pressure sensor 280 becomes relative small. Meanwhile, for example, in a case where "clogging" is generated in the nozzle N, passing resistance to the air passing through the nozzle N becomes large and thus the flow rate is not sufficiently secured. In this state, the air pressure to be measured by the air pressure sensor 280 becomes relatively high. In consideration of this point, in a case where the air pressure measured by the air pressure sensor 280 is larger than the threshold pressure in the passing flow rate inspection, generation of the "clogging" in the nozzle N is certified and the nozzle N is determined as a defective nozzle. That is, in the passing flow rate inspection, the "clogging" of the nozzle N is certified by measuring the pressure of the nozzle N on the base end portion side instead of directly measuring the flow rate of the air. Moreover, the flow meter (flow sensor) is disposed in place of the air pressure sensor 280, the flow rate of the air passing through the flow meter is directly measured, and the presence of "clogging" may be determined based on the result of the measurement.

Further, the compressed air carried to the nozzle N is supplied to the air carrying device 274 from a compressor (not illustrated) disposed in the above-described driving source unit 124, but the air pressure is measured by the air pressure sensor 280 to change, for example, depending on the output pressure of the compressor. That is, the air pressure is changed by the environmental conditions related to the second inspecting device 108. In consideration of this point, it is preferable to set the threshold pressure according to the environmental conditions. In the management machine 80, the compressed air is carried to the reference pipe 160 fixed to the pallet NP by the air carrying device 274 and the threshold pressure is set based on the air pressure to be measured by the air pressure sensor 280 prior to the passing flow rate inspection of the nozzle N. That is, the reference pipe 160 as the reference target is used for setting a reference of the inspection to be performed as a preliminary process related to the passing flow rate inspection performed by the second inspecting device 108.

In the identifier reading inspection performed by the second inspecting device 108, the inspection head 270 is moved to a position, by the head moving device 272, in which the camera 276 is positioned in the right above the two-dimensional code 38 which is an identifier provided for the flange 34 of the nozzle N to be inspected. In this state, the two-dimensional code 38 is imaged by the camera 276. In addition, an image captured by the camera 276 is, for example, a view of Fig. 17 (b) . In the identifier reading inspection, the ID of the nozzle N is recognized based on the image data obtained by capturing an image by the camera and the nozzle N is determined as a defective nozzle in a case where the ID cannot be recognized. In the management machine 80, since the ID cannot be recognized due to the malfunction of the camera 276 or the like, the two-dimensional code 38 attached to the flange 34 of the reference nozzle 158 fixed to the pallet NP is imaged by the camera 276 prior to the reading of the two-dimensional code 38 of the nozzle N, the function of reading an identifier of the second inspecting device 108 is confirmed to be sufficient based on the image data obtained by capturing an image by the camera, and the identifier reading inspection of the nozzle N is performed under the condition in which the function of reading an identifier is sufficient. That is, the reference nozzle 158 as a reference target is used for examination of the second inspecting device 108, that is, for post-examination.

Moreover, the passing flow rate inspection and the identifier reading inspection performed by the second inspecting device 108 may be performed on all nozzles N being placed on one pallet NP or on some nozzles N. In addition, both inspections may be performed or only one of them may be performed. After the inspection on the placed nozzles N is finished, the pallet NP positioned in the inspection position is transferred to the carrier 130, by the second transfer device 116, positioned in the station corresponding to the second inspecting device in the storing device 100.

### [H] Nozzle washing device and nozzle drying device

The nozzle washing device 110 is positioned on the lower side of the second nozzle inspecting device 108 and the nozzle drying device 112 is positioned between the washing device 110 and the above-described storing device 100. A housing 300 is provided in the management machine 80 in relation to the washing device 110 and the drying device 112. Fig. 10 illustrates the washing device 110 and the drying device 112 in the presence of the housing 300 is present and Fig. 11 illustrates the washing device 110 and the drying device 112 without the housing 300. When the description is made with reference to those figures, after the pallet NP positioned in the set position in the storing device 100, that is, the station corresponding to the washing device is transferred to a washing position by the above-described fourth pallet transfer device 120 (the structure thereof will be described below), the nozzles N placed on the pallet NP in the position are washed by the washing device 110. Further, after washing, the washed nozzles N which are placed on the pallet NP are dried by the drying device 112 during the transfer of the pallet NP to the station corresponding to the washing device by the fourth pallet transfer device 120. The position of the pallet NP illustrated in the figure is the above-described washing position, and a pallet fixing mechanism (not illustrated) that fixes the pallet NP in the inspection position is provided in the fourth transfer device 120. In addition, for the sake of simplicity, the nozzles N placed on the pallet NP is not illustrated in the figure.

The washing device 110 includes an upper portion washing unit 302 that washes the nozzle N from the upper portion thereof and a lower portion washing unit 304 that washes the nozzle N from the lower portion thereof, and the upper portion washing unit 302 and the lower portion washing unit 304 have approximately the same structure. Each of the units 302 and 304 includes a support frame 306 attached to the housing 300; an injection nozzle 308 supported by the support frame 306; and a Y direction moving mechanism 310 moving the injection nozzle 308 in the Y direction. The injection nozzle 308 has a shape of a long and narrow rectangle positioned so as to extend in the X direction over the entire width of the pallet NP, and multiple injection holes 312 are provided on the surface facing the pallet NP. The Y direction moving mechanism 310 moves the injection nozzle 308 in the Y direction over the entire length of the pallet NP. High-pressure water pressed by a high-pressure pump (not illustrated) which is disposed in the above-described driving source unit 124 is supplied to the injection nozzle 308 and the high-pressure water is injected toward the nozzles N placed on the pallet NP from the injection hole 312.

The drying device 112 includes a plurality of air blowing pipes 314 disposed in the upper portion and the lower portion of the housing 300. Warm air (hot air) is sent to the air blowing pipes 314 through a heater (not illustrated) disposed in the driving source unit 124 from a blower (not illustrated) . A plurality of releasing holes are provided in each of the plurality of air blowing pipes 314 and the warm air is released toward the nozzles N placed on the pallet NP from the releasing holes. The nozzles N are dried by the released warm air.

The above-described housing 300 is disposed to prevent the high-pressure water injected by the washing device 110 and the warm air released by the drying device 112 from adversely affecting other devices. A transparent window 316 for peeking the inside is provided on the front side of the housing 300, and a shielding plate 318 and a shielding plate opening and closing mechanism 320 which is opened only when the pallet NP passes through the shielding plate 318 are provided on the rear side thereof.

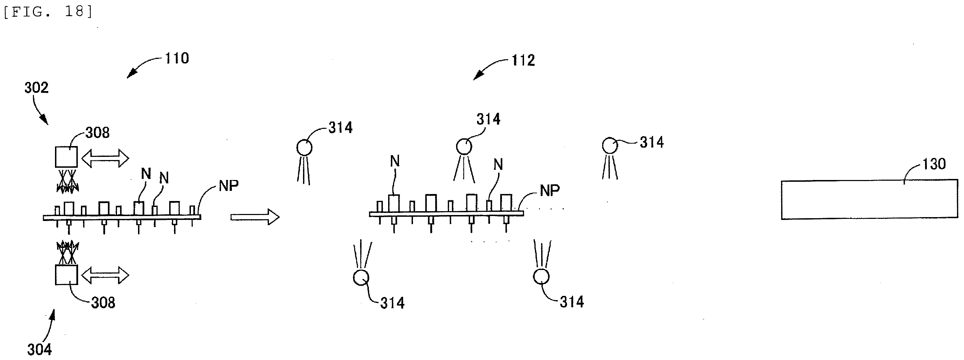

As illustrated in Fig. 18, the nozzles N being placed on the pallet NP fixed in the above-described washing position is washed by the washing device 110. Specifically, the upper portion washing unit 302 injects high-pressure water from the upper side of the nozzle N, that is, the base end side of the nozzle N and mainly washes the upper surface or the like of the barrel tube 30 and the flange 34. Meanwhile, the lower portion washing unit 304 injects high-pressure water from the lower side of the nozzle N, that is, the tip side of the nozzle N and mainly washes the suction pipe 32. In order to obtain a high washing effect, the orientation of the injection hole 312 is adjusted such that the injection nozzle 308 injects high-pressure water to various directions in addition to the direction of directly below or directly above. Since the width of the injection nozzle 308 is relatively narrow and the high-pressure water is only injected to some of the nozzle arrays arranged on the pallet NP in the X direction, the injection nozzle 308 is moved, by the Y direction moving mechanism 310, across the entire length of the pallet NP in the Y direction. In addition, the injection nozzle 308 is a nozzle having a two-fluid system, that is, not a nozzle injecting water by distributing water using the compressed air but a nozzle configured so as to inject water pressed by a pump using the pressure of the water from the injection hole 312 directly. Therefore, the washing device 110 is considered as a device with high washing ability.

The drying device 112 performs drying by blowing warm air when the fourth transfer device 120 transfers the pallet NP present in the inspection position after the nozzles N are washed to the station 130 corresponding to a washing device. Accordingly, during at least a part of the time necessary for drying, the pallet NP can be returned to the storing device 100 and thus the time loss in a series of processes such as washing and drying is reduced. In addition, warm air has a relatively high speed and water droplets adhered to the nozzles N are blown off by the pressure of the warm air and the water remaining on the nozzles N is dried by the temperature of the warm air.

### [I] Pallet transfer device

The first to fourth pallet transfer devices 114 to 120, each of which is a nozzle transfer device, are devices that transfer the pallet NP between the storing device 100 and the device for performing a treatment on nozzles as described above. The first, second, and third transfer devices 114, 116, and 118 have approximately the same structure and the fourth transfer device 120 has a structure slightly different from those of the first, second, and third transfer devices 114, 116, and 118.

When the description is made with reference to Figs. 5 to 7, each of the first, second, and third transfer devices 114, 116, and 118 includes a pair of rails 330 disposed so as to be extended toward the front side from the storing device 100 and the pallet NP is supported by the pair of rails 330 so as to straddle over the pair of rails 330 and slide thereon. Further, each of the first, second, and third transfer devices 114, 116, and 118 includes the moving mechanism 332 that moves the pallet NP between the carrier 130 of the storing device 100 and the pair of rails 330 and on the pair of rails 330. The moving mechanism 332 includes a guide 334 disposed so as to be extended in the longitudinal direction on the right side of the management machine 80 and a transporting unit 336 supported by the guide 334. The transporting unit 336 self-travels along the guide 334 in a state of being supported by the guide 334. Although not illustrated, the transporting unit 336 includes an extending portion that extends to the intermediate portion of the pair of rails 330 on the lower side of the pair of rails 330 and a clamp that grips the rear end portion of the pallet NP from the lower side thereof is provided in the tip of the extending portion.

When one carrier 130 of the storing device 100 is positioned in the above-described set position, that is, the station corresponding to the device for performing a treatment on nozzles, a pair of rails 330 and a pair of rails 170 of the carrier 130 coincide with each other and the transporting unit 336 can be moved to the rear end of the guide 334 such that the extending portion passes through the lower side of the carrier 130. The above-described clamp grips the rear end portion of the pallet NP stored in the carrier 130 in a state in which the transporting unit 336 is positioned in the rear end and the pallet NP is transferred to the above-described setting position by the transporting unit 336 moves to the front end of the guide 334 in the state of the pallet NP being gripped. After the transfer, the state of the pallet NP being gripped by the clamp is released. In a case where the pallet NP positioned in the set position is transferred to the carrier 130, a reverse operation of the above-described operation is performed. In addition, the set position means the above-described transfer position, inspection position, or washing position. Further, as described above, each of the first, second, and third transfer devices 114, 116, and 118 includes the pallet fixing mechanism for fixing the pallet NP positioned in the set position to the pair of rails.

The structures of the guide and the transporting unit of the fourth transfer device 120 are different from those of the first, second, and third transfer devices 114, 116, and 118. Although detailed description thereof is not made here, since the fourth transfer device 120 transfers the pallet NP in the housing 300 as described above, the guide 338 and the transporting unit 340 having structures suitable for the transfer are employed. The structures and operations of other portions of the fourth transfer device 120 are the same as those of the first, second, and third transfer devices 114, 116, and 118 and thus the description thereof will not be repeated. In addition, in Fig. 5, the illustration is made such that each of the first, second, and third transfer devices 114, 116, and 118 includes two transporting units 336, but the reason for this is to conveniently illustrate both of the state in which the transporting unit 336 is positioned in the front end of the guide and the state in which the transporting unit 336 is positioned in the rear end thereof, and practically, each of the first, second, and third transfer devices 114, 116, and 118 includes only one transporting unit 336.

### [J] Additional configuration of the nozzle management machine

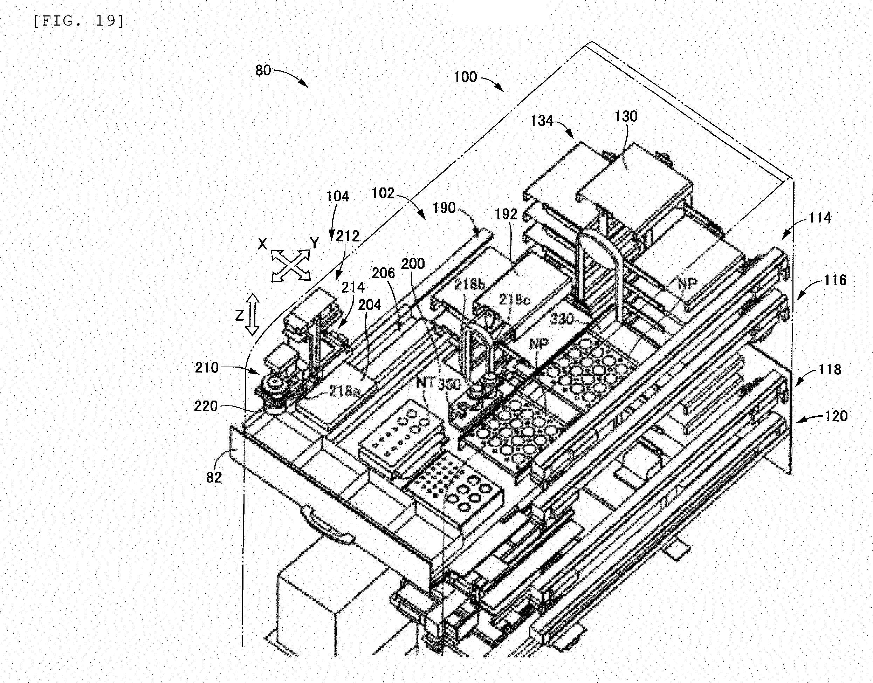

The management machine 80 includes an additional configuration which will be described below in addition to the basic configuration. The additional configuration will be described with reference to Fig. 19.

As described above, the transfer device 104 of the management machine 80 includes a transfer head 210 and a head moving device 212 that moves the transfer head, and the transfer head 210 includes a holding chuck 218 serving as a nozzle holding jig for holding the nozzles N to be transferred. In addition, in the management machine 80, five kinds of nozzles Na, Nb, Nc, Nd, and Ne are used as the targets as described above. Accordingly, the transfer device 104 needs to be capable of moving all five kinds of nozzles Na to Ne. The five kinds of nozzles Na to Ne can be classified into three groups in terms of the size, specifically, a group formed of small size of nozzles and including nozzles Na; a group formed of medium size of nozzles and including nozzles Nb and Nc; and a group formed of large size of nozzles and including nozzles Nd and Ne, but a holding chuck 218 with a considerably complicated structure needs to be employed in order to hold nozzles N of all groups using one holding chuck 218 and suitably transfer the nozzles.

Here, in the management machine 30, three holding chucks 218 which are respectively nozzle holding jigs are used properly in accordance with the three groups. Specifically, three holding chucks are a holding chuck 218a for holding the nozzles Na, a holding chuck 218b for holding the nozzles Nb and Nc, and the holding chuck 218c for holding the nozzle Nd and Ne. Accordingly, the holding chuck 218 is detachably formed in the transfer head 210. The figure illustrates a state in which the holding chuck 218a is mounted on the transfer head 210 and the holding chucks 218b and 218c are placed on a cradle 350 that is attached to the table 200. The transfer head 210 is moved to the upper side of an available slot of the cradle 350 by the head moving device 212 and then lowered. In addition, when the mounted holding chuck 218 is separated, the transfer head 210 is moved to the upper side of the holding chuck 218 to be mounted and then lowered, and the holding chuck 218 is mounted. By the above, the holding chuck 218 can be exchanged in automatic. In the management machine 30, the nozzles N are transferred while exchanging the holding chuck 218 according to the size of the nozzles N to be transferred.

Moreover, as understood from the figure, in the management machine 80, two pallets NP can be provided for transfer of the nozzles N. In other words, two pallets NP can be respectively positioned in two transfer positions. Specifically, the front side is the first transfer position and the rear side is the second transfer position. That is, the first transfer device 114 can continuously transfer two pallets NP to two transfer positions from the storing device 110. In addition, for the sake of simplicity, the nozzles N being placed on two pallets NP are not illustrated in the figure. Further, two pallet fixing mechanisms (not illustrated) that fix the pallets NP to the transfer positions are provided in the first transfer device 114 and a cover sliding mechanism (not illustrated) that slides two cover plates 142 is provided on the table 200 in correspondence with two transfer positions as a mechanism for making the state of the pallets NP positioned in the transfer positions into the placing hole open state.

In the management machine 80, since two pallets NP can be provided for the transfer of the nozzles N, the nozzles N can be transferred between two pallets NP in addition to the setting transfer and the storage transfer described above. When the nozzles N can be transferred between two pallets NP, it is possible to efficiently perform rearrangement or alignment (hereinafter, also collectively referred to as "arrangement") of the nozzles N stored in the storing device 100. That is, "arrangement transfer" which is the transfer of the nozzles N for arrangement of the nozzles N can be conveniently carried out. In addition, the setting transfer from two pallets NP or the storage transfer from two pallets NP can be carried out and the management machine 80 is highly convenient in terms of transfer.

### [K] Operation performed by nozzle management machine

### i) Summary of operation

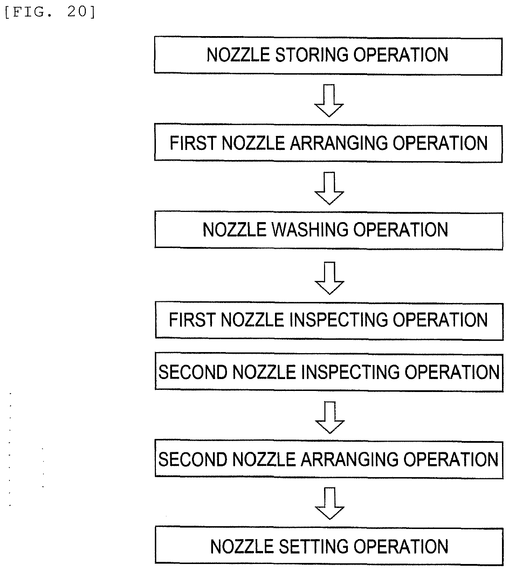

The management machine 80 having the above-described configuration performs various operations by the control of the controller 84 serving as a control device controlling the entire management machine 80. When the description is made along the flow from reception of a nozzle N into the management machine 80 to deliver from the management machine 80 of the nozzle N, as illustrated in the chart of Fig. 20, as various operations, the management machine 80 performs a "nozzle storing operation" for storing nozzles N being placed on the tray NT in the management machine 80, a "first nozzle arranging operation" for arranging the stored nozzles N on the pallet NP for washing and inspecting, a "nozzle washing operation" for washing the nozzle N arranged on the pallet NP, a "first nozzle inspecting operation" and a "second nozzle inspecting operation" for inspecting the washed nozzles N, a "second nozzle arranging operation" for aligning and storing the inspected nozzles in the pallet NP, and a "nozzle setting operation" for setting the aligned and stored nozzles N in the tray NT. In addition, although not illustrated in the chart, a "nozzle resetting operation" which is an operation combining the nozzle storing operation and the nozzle setting operation and performed for exchanging the nozzles N being placed on the tray NT for other nozzles N having the same type can be performed.

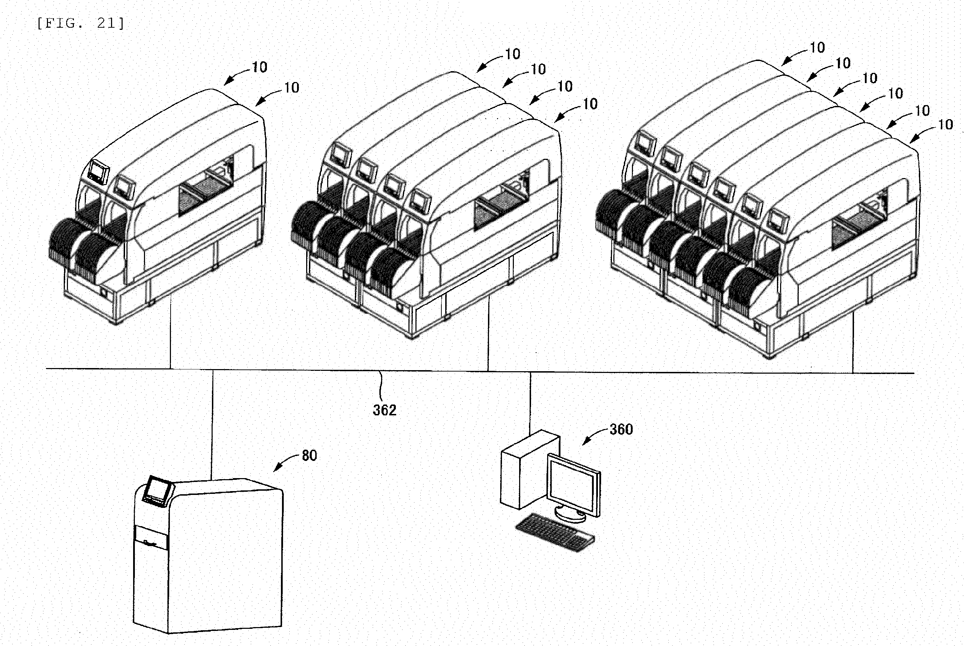

The above-described various operations are performed based on management information, that is, information related to the nozzles N and the tray NT created or acquired during the management of the stored nozzles N or the tray NT. Further, rules related to a method of using a plurality of pallets NP and a method of using one pallet NP are prescribed. In addition, the alignment mode for storing the inspected nozzles N can be selectively employed from among several modes. Hereinafter, the rules on the use of the pallet, the above-described various operations performed by the management machine 80 will be sequentially described by adding the above-described several alignment modes after description is made by exemplifying the management information. As illustrated in Fig. 21, the management machine 80 is connected with several electrical component mounting machines 10 and a host computer 360 serving as a management device that manages the entire electrical component mounting machines 10 through a LAN 362 and the controller 84 can perform several operations from among the above-described various operations based on instructions, information, or the like sent from any of the electrical component mounting machines 10 and the host computer 360.

### ii) Management information

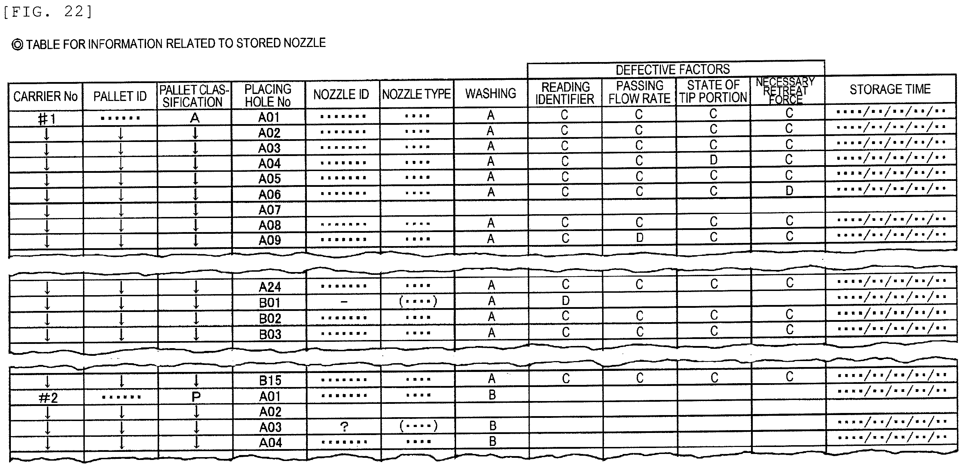

The controller 84 stores "stored nozzle information" as management information related on stored nozzles N. The stored nozzle information can be schematically illustrated as a table for information related to stored nozzle of Fig. 22. When simply described, the stored nozzle information is information showing that which nozzles N are stored in which placing hole 144 of which pallet NP stored in which carrier 130. In other words, the stored nozzle information is information in a mode in which the specific information of the stored nozzles N are associated with a storage position in the storing device 100. In the description below, the stored nozzle information is handled as information stored in a form of the above-described table and the stored nozzle information will be described in detail based on the table.

In the stored nozzle information table illustrated in the figure, each row corresponds to one placing hole 144 of one pallet NP, that is, each of the stored nozzles N. In addition, each column of the table corresponds to various pieces of information related to the nozzles N. Specifically, the "carrier No" indicates the number of the carriers 130 storing the pallet NP on which the nozzles N are placed and the numbers of the carriers 130 included in the storing device 100 are stored in a form of "#1," "#2," .... The "pallet ID" indicates an ID of the pallet NP as the specific information of the pallet NP on which the nozzles N are placed. The "pallet classification" indicates a parameter indicating that the pallet NP is a pallet for alignment described below or a pallet for a pre-process, "A" indicates that the pallet NP is a pallet for alignment, and "P" indicates that the pallet NP is a pallet for a pre-process. The "placing hole No" indicates the number of the placing holes 144 serving as placing units on which the nozzles N are placed and the numbers of "A01" to "A24" are stored in correspondence with small placing holes 144a illustrated in Fig. 12 and the numbers of "B01" to "B15" are stored in correspondence with large placing holes 144b. In addition, the arrows "↓" in the "carrier No," the "pallet ID," and the "pallet classification" conveniently indicate that the contents which are the same as those in the upper row are stored.

The "nozzle ID" and the columns on the right side thereof are all related to specific information of the nozzles N. When description is made on each item, the "nozzle ID" indicates the ID of the nozzle N. When "-" is shown in the "nozzle ID, " this means that the ID of the nozzle N cannot be recognized. Further, when "?" is shown in the "nozzle ID," this means that the ID of the nozzle N has not been recognized yet. The "nozzle type" shows the types of nozzles N, that is, the kinds of nozzles N. Specifically, the types of respective nozzles Na to Ne illustrated in Fig. 13 are stored. The "(••••)" means that the type of a nozzle is assumed. The "washing" indicates whether the nozzles N are washed by the washing device 110, "A" indicates that the nozzles are washed, and "B" indicates that the nozzles have not been washed yet.

The "defective factor" indicates a factor of a defective in a case where a nozzle N is determined as a defective nozzle, that is, the nozzle N determined as a defective nozzle in any of the inspections on the above-described four items. In the case where the nozzle N is determined as a defective nozzle in any of the inspections on four items, "D" is stored in a column corresponding to the item determined as a defective nozzle from among four columns of "reading identifier," "passing flow rate," "state of tip portion," and "necessary retreat force." "C" indicates that a nozzle is not determined as a defective nozzle in the inspections on respective items, and in a case where "C" or "D" is not stored in each column, this means that the inspections have not been performed yet.

The "storage time" shows the time at which nozzles N are stored in the management machine 80 in terms of the year, the month, the day, the hour, and the minute. In addition, rows without any description in the columns of the "nozzle ID" to "storage time" indicates that placing holes 144 corresponding the rows, that is, the placing holes 144 of the pallet NP stored in a carrier 130 do not have nozzles N being placed thereon.

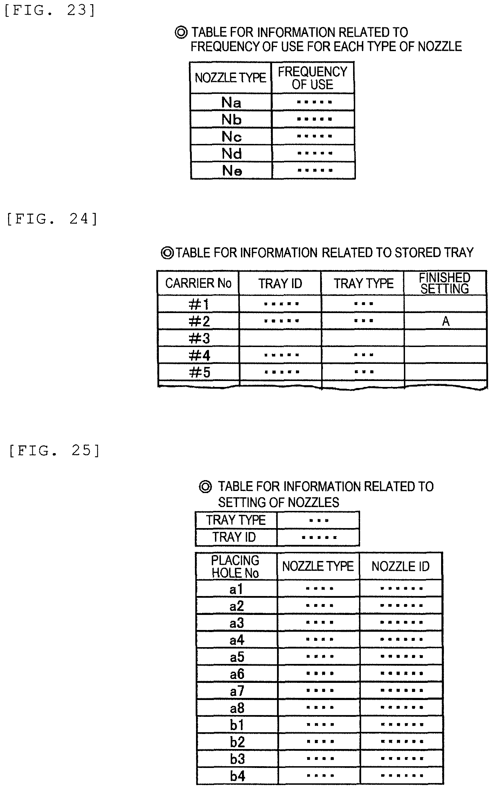

Meanwhile, the controller 84 stores "information related to the frequency of use for each type of nozzle" as one piece of management information related to the stored nozzles N. The information related to the frequency of use for each type of nozzle is schematically shown in a table for information related to the frequency of use for each type of nozzle in Fig. 23 and, specifically, the "nozzle type" shows respective types of nozzles Na to Ne illustrated in Fig. 13 and the "frequency of use" shows the frequency of use of the nozzles N of respective types. The information related to the frequency of use for each type of nozzle is information showing that what type, that is, which type of nozzle N is how frequently used. In addition, the frequency of use shows the times of setting for each nozzle, indicating that each nozzle N has been provided for setting in the tray NT in the management machine 80, by means of the collected numbers for each type of nozzle. In other words, the information shows that which type of nozzle N is used and how many times the nozzle N is used. Further, since the information related to the frequency of use for each type of nozzle can be incorporated in the table for information related to stored nozzle of Fig. 22 by providing other columns and can be linked to the "nozzle type" of the table, the information can be considered as one kind of specific information of the stored nozzles N. In the description below, the stored tray information is handled as information stored in a form of the above-described table similar to the stored nozzle information.

The controller 84 stores the "stored tray information" as the management information related to the stored tray NT. The stored tray information can be schematically illustrated as a table for information related to the stored tray in Fig. 24. When simply described, the stored tray information is information indicating that which tray N is stored in which carrier 192. In other words, the stored tray information is information in which the specific information of the stored tray NT is associated with the storage position in the storing device 102 similar to the stored nozzle information. In the description below, the stored tray information is handled as information stored in a form of the above-described table similar to the stored nozzle information and the stored tray information will be described in detail based on the table.

In the stored tray information table illustrated in the figure, each row corresponds to one carrier 192 of the storing device 102, that is, each of the stored tray NT. In addition, each column of the table corresponds to various pieces of information related to the tray NT. Specifically, the "carrier No" indicates the number of the carriers 192 storing the tray NT and the numbers of the carriers 192 included in the storing device 102 are stored in a form of "#1, " "#2, " .... The "tray ID" is an ID of the tray NT as one piece of the specific information of the tray NT. The "tray type" indicates the type of tray NT, that is, the kind of tray NT. The "finished setting" indicates whether nozzles N are set in the stored tray NT, "A" indicates that the nozzles N are set in the tray NT, and the blanks indicate that the tray NT is empty. In addition, the rows without any description in the columns of the "tray ID" and the "tray type" indicate that the tray NT is not stored in the carriers 192 corresponding to the rows.

In addition, the controller 84 uses "the nozzle setting information" as the management information related to the setting of the nozzles N in the tray NT. The nozzle setting information is schematically shown in a table for information related to setting of nozzles in Fig. 25. When simply described, the nozzle setting information is information indicating that which nozzle N is placed on which placing hole 64 of which tray NT. The "placing hole No" indicates the number of a placing hole 64 as a placing unit on which the nozzles N are placed and the figure illustrates information related to the tray NT of Fig. 3 as an example. Specifically, the numbers of "a1" to "a8" are denoted in correspondence with relatively small placing holes 64 illustrated in Fig. 3 and the numbers of "b1" to "b4" are denoted in correspondence with relatively large placing holes 64.

The setting of the nozzles N in the pallet NP is started based on the nozzle setting information in which the "tray ID" and the "nozzle ID" are not described, that is, only the "tray type" and "nozzle type" are described, and the "tray ID" and the "nozzle ID" are provided at the time point at which the setting is finished.

The above-described management information is updated and reset in several operations performed by the management machine 80 described below. In the description below, the operations will be described based on the flowcharts of programs related to the operations, but the notations of processes related to the update, deletion, and addition are not described in the flowcharts and those processes will be described in steps of the flowcharts.

### iii) Rules on use of pallet

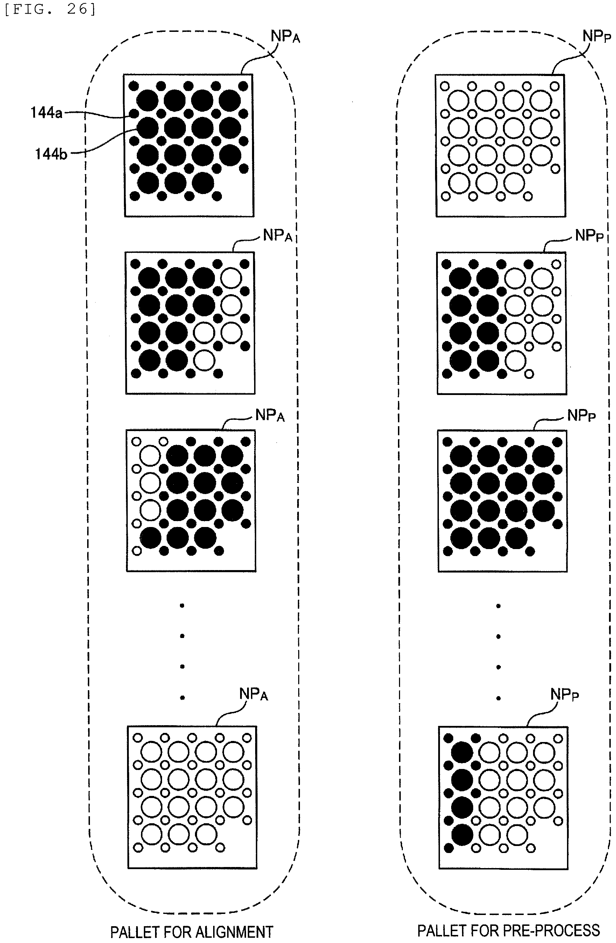

A plurality of pallets NP, specifically, twenty sheets of pallets NP in maximum can be stored in the storing device 100. As illustrated in Fig. 26, the plurality of pallets NP are classified into two groups in the management machine 80 when the above-described various operations are performed. As described above, one of the two groups is a group formed of a plurality of pallets NP (hereinafter, also referred to as "pallets NP_{A} for alignment") in which nozzles N are aligned or to be aligned in order according to the set rules and the other one is a group formed of a plurality of pallets NP (hereinafter, also referred to as "pallets NP_{P} for a pre-process") in which nozzles N are placed before the nozzles N are aligned and placed on any of the pallets NP_{A} for alignment in order to be received to the management machine 80 and to perform a process such as washing or inspecting. The nozzles N are transferred, by the above-described second nozzle arranging operation, from the pallets NP_{P} for a pre-process to the pallets NP_{A} for alignment. Further, conveniently, the placing holes 144a and 144b filled in black indicate that the nozzles N are placed on the placing holes 144a and 144b, and outlined placing holes 144a and 144b indicate that the nozzles N are not placed on the placing holes 144a and 144b in the figure .

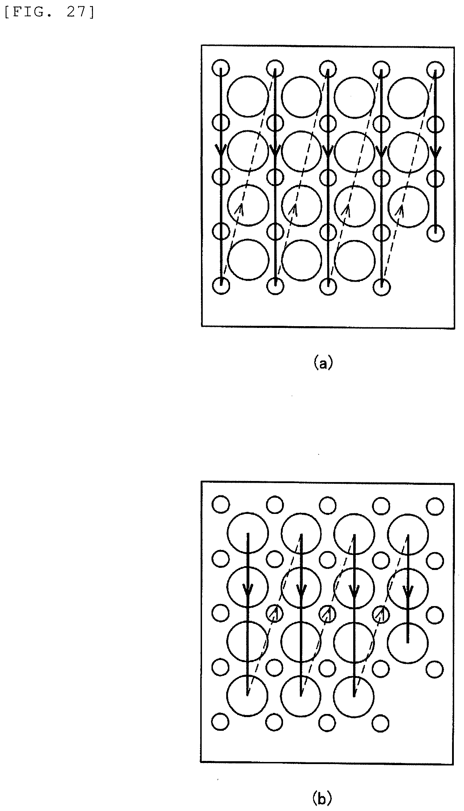

The transfer of nozzles N to one pallet NP, that is, arrangement of nozzles N in one pallet NP is performed in order illustrated in Fig. 27 as a rule. Specifically, as illustrated in Fig. 27 (a), nozzles Na are arranged in order of the leftmost column and from the upper side with respect to placing holes 144a of each column. Similarly, as illustrated in Fig. 27 (b), nozzles Nb to Ne are arranged in order from the leftmost column and from the upper side with respect to placing holes 144b of each column irrelevant to the type of nozzle N or each type of nozzle N. In addition, the order thereof is also referred to as "arrangement order." Moreover, in a case where other several nozzles N are arranged so as to be added to the pallet NP on which several nozzles N are already placed, as a rule, the arrangement is subsequently made according to arrangement order from placing holes 144a and 144b next to the rearmost placing holes 144a and 144b according to the arrangement order of the placing holes 144a and 144b on which nozzles N are already placed.

In addition, ejection of nozzles N from one pallet NP, that is, transfer of nozzles N from one pallet NP is performed according to the arrangement order as a rule. According to this rule, transfer is performed in order from the nozzles N placed on the pallet NP previously. The rule is so-called "first in-first out." In addition, ejection of any one type of nozzles among the nozzles Nb to Ne from the pallet NP in which the nozzles Nb to Ne are mixed with each other is performed according to the arrangement order as a rule. That is, the ejection of one type of nozzles N is performed according to the arrangement order while skipping other types of nozzles N other than the one type of nozzles N.

### iv) Nozzle storing operation

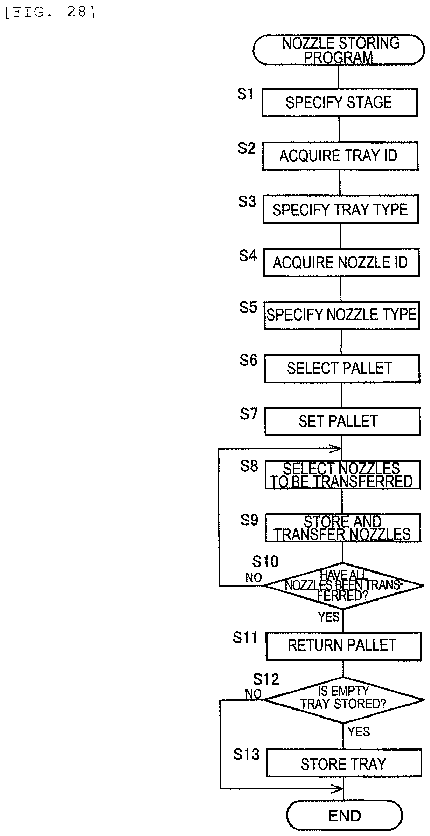

The nozzle storing operation is an operation for storing the nozzles N being placed on the tray NT in the storing device 100 for the purpose of washing, inspecting, and storing the nozzles N used in the mounting machine and the operation is performed by the controller 84 executing the nozzle storing program illustrated in the flowchart of Fig. 28. The operator of the management machine 80 opens the above-described drawer 82 and sets the tray NT on which nozzles N are placed in the fixed stage 204 or the movable stage 204, and an instruction of starting the operation is input by the operation key 88 of the controller 84 so that the operation is started. In addition, in a case where the tray NT is set in the fixed stage 202, the operation is finished in a state in which the tray NT remains after the nozzles N are stored. Meanwhile, in a case where the movable stage 204 is set on the tray NT, whether the tray NT is stored in the storing device 102 after the nozzles N are stored can be selected based on an input operation using the operation key 88 of an operator. According to the selection, the operation is finished.

In a process according to the nozzle storing program, it is specified that a stage to which the tray NT is fixed and in which the placing hole open state is realized, that is, a stage on which the tray NT is set is the fixed stage 202 or the movable stage 204 in Step 1 (hereinafter, Step is abbreviated as "S"). Next, in S2, the transfer head 210 is moved to the upper side of the specified stage, the two-dimensional code 76 attached to the tray NT is imaged by the camera 220, and the ID of the tray NT is acquired. In S3, the type of the tray NT is specified based on the ID of the acquired tray NT. In addition, the ID information includes information of the type of a tray NT. The controller 84 stores data in which the number of placing holes 64 of the tray NT, the position thereof, and the like are associated with the type of the tray NT (hereinafter, also referred to as "tray specification data"), the two-dimensional code 38 of each nozzle N being placed on the tray NT is imaged by the camera 220 according to the specification of the tray NT grasped based on the type thereof in S4 after the type is specified, and the ID of each nozzle N is acquired. In S5, the type of each nozzle N is specified based on the acquired ID. Similar to the tray NT, the ID information of the nozzle N includes information of the type of nozzle N. In addition, in a case where the ID of the nozzle NT cannot be acquired due to dirt or the like of a two-dimensional mark 38, the above-described nozzle setting information created previously, that is, nozzle setting information at the time when the nozzle N are set in the tray NT having the ID is used and the type of the nozzle N whose ID cannot be acquired is assumed.

Next, in S6, one pallet NP on which nozzles N are placed when the nozzles N are stored in the storing device 100 is selected based on the stored nozzle information described above and one pallet NP_{P} for a pre-process is selected from a plurality of pallets NP included in the storing device 100, specifically, a plurality of pallets NP_{P} for a pre-process. First, specifically, it is determined whether the pallet NP_{P} for a pre-process on which nozzles N which have not been washed yet are placed is present. In a case where one or more pallets NP_{P} for a pre-process are present, in one pallet NP_{P} for a pre-process on which nozzles N recently stored are placed, it is determined whether all nozzles N to be stored at this time according to the arrangement order can be placed after the nozzles N already being placed and the one pallet NP_{P} for a pre-process is selected when all nozzles N can be placed. In the case where all nozzles N cannot be placed on the pallet NP_{P} for a pre-process or in the case where the pallet NP_{P} for a pre-process on which nozzles N which have not been washed yet are placed is not present, one empty pallet NP_{P} for a pre-process is selected. In addition, in S7, the selected pallet NP_{P} for a pre-process is transferred by the first transfer device 114 and is set in the above-described first transfer position. Further, the reason why the nozzles N cannot be received by one pallet NP_{P} for a pre-process in the nozzle storing operation is a measure for completing the operation in a short period of time.

After the selected pallet NP_{P} for a pre-process is set, one nozzle N which can be transferred to the set pallet NP_{P} for a pre-process is selected from nozzles N being placed on the set tray NT according to the set rule in S8 and the selected nozzle N is transferred to one empty placing hole 144 by the transfer device 104 in the set pallet NP_{P} for a pre-process in S9. That is, the above-described storing and transferring are performed. Specifically, the nozzle N is transferred to one empty placing hole 144 determined according to the above-described arrangement order based on the type of the nozzle N specified in S5. At the time of storing and transferring the one nozzle N, the ID of the nozzle N acquired in S4, the type of the nozzle specified in S5, and the time (storage time) at which the nozzle N is stored are stored as the stored nozzle information. That is, updating of the stored nozzle information is carried out. Specifically, the above-described ID, type, and time are written in one row of the table for information related to stored nozzle illustrated in Fig. 22, that is, cells of "nozzle ID," "nozzle type," and "storage time" the row corresponding to the placing hole 144 on which the nozzle N is placed and the fact that the nozzle N is unwashed is written in the cell of "washing."

After the storage and transfer of one nozzle N, it is determined whether storing and transferring of all nozzles N being placed on the set tray NT have been completed in S10. In a case where storing and transferring of all nozzles N have not been completed, selecting of another nozzle N of S8 and storing and transferring another nozzle N of S9 are performed. In S10, in the case where it is determined that the storing and transferring of all nozzles N being placed on the set tray NT have been completed, the set pallet NP_{P} for a pre-process is returned to the storing device 100 by the first transfer device 114 in S11.

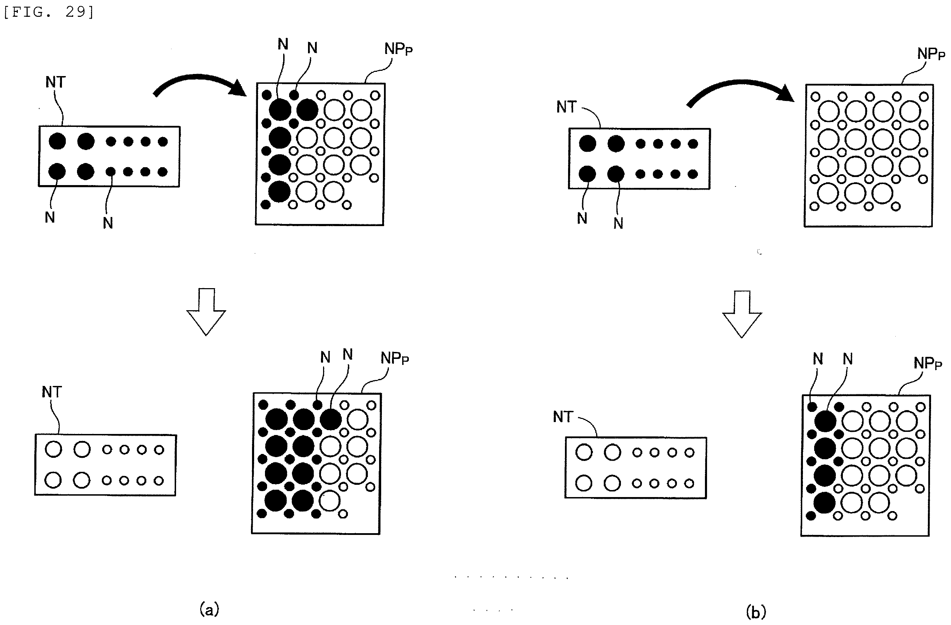

As a result of the above-described nozzle storing operation, for example, nozzles N are placed on one pallet NP_{P} for a pre-process from the tray NT as illustrated in Fig. 29. Specifically, Fig. 29(a) illustrates transfer of nozzles N to the pallet NP_{P} for a pre-process on which the nozzles N are already placed and Fig. 29 (b) illustrates transfer of nozzles N to the empty pallet NP_{P} for a pre-process. In addition, in the tray NT illustrated in the figure, small-sized nozzles Na can be placed on relatively small eight placing holes 64 and medium-sized nozzles Nb and Nc and large-sized nozzles Nd and Ne can be placed on relatively large four placing holes 64. Hereinafter, description will be made on the premise that such a tray NT is used.

After storing and transferring of all nozzles N are completed and the pallet NP_{P} for a pre-process is returned, it is determined whether the empty tray NT is stored in the tray storing device 102 in S12. As described above, the determination is made based on the fact that which one of the fixed stage 202 and the movable stage. 204 the tray NT is set in. In the case where it is determined that the tray NT is stored in the storing device 102, the empty tray NT which is set in S13 is stored in the storing device 102 by the tray transfer device 122 and the nozzle storing operation is finished. Meanwhile, in the case where it is determined that the empty tray NT is not stored in the storing device 102 in S12, the setting of the tray NT is released and the nozzle storing operation is finished. In addition, prior to the storing and transferring of the nozzles N, two-dimensional code 76 attached to the tray NT is imaged by the camera 22 provided in the transfer device 104, the ID of the tray NT is acquired, and the ID of the tray NT and the type of the tray NT specified based on the ID are added to the above-described stored tray information associated with the carrier 192 to be stored when the tray NT is stored in the storing device 102.

### v) First nozzle arranging operation

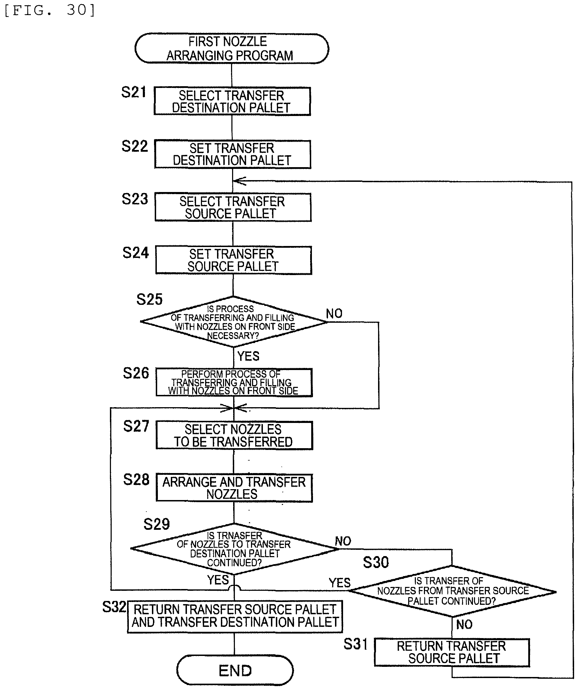

The first nozzle arranging operation is an operation for arranging nozzles N provided to be washed next from among the stored nozzles N in one pallet NP_{P} for a pre-process in consideration of the efficiency of washing. The operation is performed by the controller 84 executing the first nozzle arranging program illustrated in the flowchart of Fig. 30. The operation is performed when the number of nozzles N which have not been washed yet is counted and the number thereof exceeds the number of nozzles N which can be placed on one pallet NP based on the stored nozzle information. In addition, the operation is started under the condition in which the above-described nozzle storing operation, the second nozzle arranging operation to be described below, and the nozzle setting operation are not performed.

In a process according to the first nozzle arranging program, first, one pallet NP_{P} for a pre-process on which nozzles N to be washed are placed is selected as a transfer destination pallet NP₁ in S21. Specifically, among a plurality of pallets NP_{P} for a pre-process on which nozzles N which have not been washed are placed, a pallet NP on which nozzles N whose storage time is the earliest are placed is specified based on the stored nozzle information and the specified pallet NP_{P} for a pre-process is selected as the transfer destination pallet NP₁. In S22, the selected transfer destination pallet NP₁ is transferred from the storing device 100 by the first transfer device 114 and set in the first transfer position. Next, in S23, a pallet on which the nozzles N whose storage time is the earliest are placed from among one or more pallets in which the transfer destination pallet NP₁ is removed from a plurality of pallets NP_{P} for a pre-process on which nozzles N which have not been washed are placed is specified based on the stored nozzle information and the specified pallet NP_{P} for a pre-process is selected as a transfer source pallet NP₂. In S24, the selected transfer source pallet NP₂ is transferred from the storing device 100 by the first transfer device 114 and set in the second transfer position.

Next, in S25, it is determined whether a process of transferring and filling with nozzles on the front side is necessary in the transfer destination pallet NP₁. In a case where the process of transferring and filling with nozzles on the front side is necessary, filling and transferring are performed by the transfer device 104 in S26. The "process of transferring and filling with nozzles on the front side" is a process of sequentially transferring the nozzles N to empty placing holes 144 so as to fill the empty placing holes 144 such that nozzles N currently being placed are aligned in order from the beginning of the arrangement order in a case where several placing holes 144 on the beginning side of the arrangement order are empty.

In a case where the process of transferring and filling with nozzles on the front side is not necessary or the required process of transferring and filling with nozzles on the front side is finished, one nozzle N provided for transfer in the transfer source pallet NP₂ is selected according to the above-described arrangement order in S27 and the selected nozzle N is transferred, by the transfer device 104, to one empty placing hole 144 of the transfer destination pallet NP₁ determined according to the above-described arrangement order in S28. That is, the selected nozzle N is arranged and transferred. The above-described stored nozzle information is updated according to the arrangement and transfer of this one nozzle N. Specifically, specific information of nozzles N stored in cells subsequent to the "nozzle ID" of the row corresponding to the placing hole 144 on which the nozzles N are placed in the transfer source pallet NP₂ is transferred to one of the rows of the table for information related to stored nozzle illustrated in Fig. 22, that is, cells subsequent to the "nozzle ID" of the row corresponding to the placing hole 144 of the transfer destination pallet NP₁ on which the nozzles N are placed.

Next, in S29, it is confirmed whether nozzles N are placed on all placing holes 144 of the transfer destination pallet NP₁. That is, it is confirmed whether the transfer destination pallet NP₁ is filled with nozzles N. In a case where the nozzles N are not placed on all placing holes 144, in S30, it is determined whether nozzles N provided for transfer are still placed on the transfer source pallet NP₂, that is, whether nozzles N can be continuously transferred from the transfer source pallet NP₂. Further, in a case where nozzles N provided for the transfer are present, the next nozzle N is transferred to the transfer destination pallet NP₁ from the transfer source pallet NP₂ by processes of S27 and S28. In addition, in a case where the nozzles N provided for the transfer are not placed on the transfer source pallet NP₂, the transfer source pallet NP₂ are returned to the storing device 100 by the first transfer device 114 in S31, the process is returned to S23 and S24, the next transfer source pallet NP₂ is selected, and the transfer source pallet NP₂ is transferred from the storing device 100 by the first transfer device 114 and is set in the second transfer position. In addition, selecting nozzles N in S27 and S28 and arrangement transfer of the nozzles N are repeated. In a case where it is confirmed that nozzles N are placed on all placing holes 144 of the transfer destination pallet NP₁ in S29, both of the transfer source pallet NP₂ and the transfer destination pallet NP₁ are returned to the storing device 100 by the first transfer device 114 in S32 and the first nozzle arranging operation is finished.

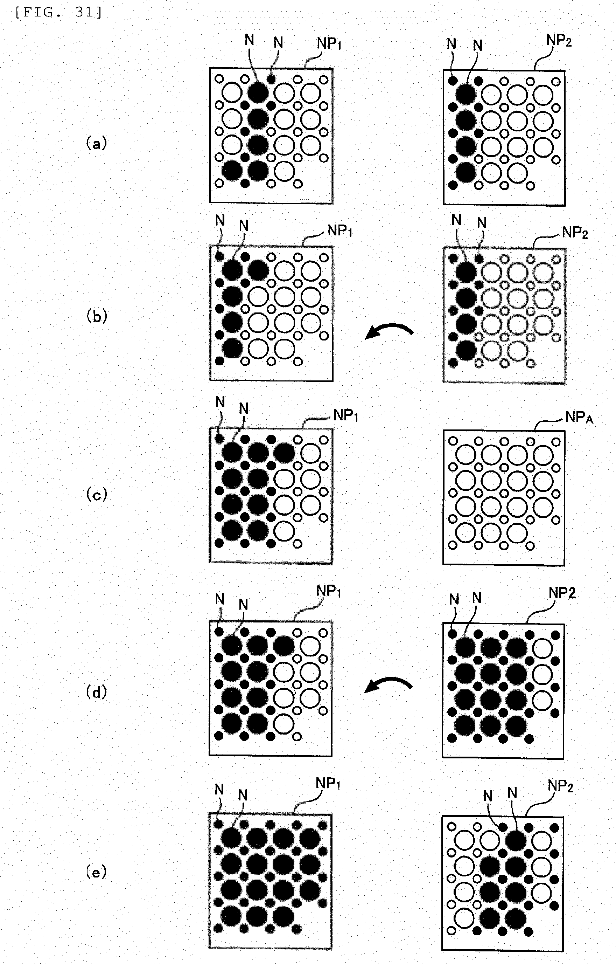

Specifically, the transfer of nozzles N as schematically illustrated in Fig. 31 is performed by the above-described first nozzle arranging operation. First, as illustrated in Fig. 31 (a), one transfer destination pallet NP₁ and one transfer source pallet NP₂ are set. In addition, in the transfer destination pallet NP₁ illustrated in the figure, several placing holes 144 on the beginning in the arrangement order do not have nozzles N, which means empty. Next, as illustrated in Fig. 31(b), the above-described filling and arranging process is performed in the transfer destination pallet NP₁. In addition, the transfer from the transfer source pallet NP₂ to the transfer destination pallet NP₁ is performed and the nozzles N are in a state of Fig. 31(c). In this state, since the transfer destination pallet NP₁ is not in a state of filling with the nozzles N, as illustrated in Fig. 31(d), the transfer source pallet NP₂ is exchanged for another pallet NP_{P} for a pre-process. Further, the transfer between the newly set transfer source pallet NP₂ to the transfer destination pallet NP₁ is continuously performed until the transfer destination pallet NP₁ is filled with the nozzles N, and the transfer destination pallet NP₁ enters the state illustrated in Fig. 31(e) as a result. The pallet NP_{P} for a pre-process in a state in which nozzles N which have not been washed yet are placed on all placing holes 144 is prepared by such a first nozzle arranging operation. That is, in the first nozzle arranging operation, the transfer of nozzles N is performed according to a rule in which only nozzles N which have not been washed yet are arranged on all placing holes 144 of one pallet NP_{P} for a pre-process. In addition, since nozzles N arranged on the pallet NP_{P} for a pre-process can be washed and inspected with the entire pallet NP_{P} for a pre-process, the efficiency of washing and inspecting of the nozzles N becomes increased. That is, the nozzles N as many as possible can be washed and inspected by one time of nozzle washing operation, first nozzle inspecting operation, and second nozzle inspecting operation.

### vi) Nozzle washing operation

The nozzle washing operation is an operation of washing and drying nozzles N being placed on one pallet NP in the storing device 100 with the entire pallet NP. Since the details of washing and drying of nozzles N will be described below, the flow of the operation will be mainly described here. Further, three operations of this operation, the first nozzle inspecting operation and the second nozzle inspecting operation described below are all performed independently from all other operations described in examples. That is, regardless of the fact that whether other operation is performed, all of three operations can be performed on nozzles N being placed on the pallet NP other than pallets NP which are targets of other operations as long as the set conditions are satisfied. In other words, in the management machine 80, these three operations can be performed in parallel with an operation related to the transfer device 104, that is, an operation related to the transfer of the nozzles N. That is, respective operations of the transfer device 104, the washing device 110, the first inspecting device 106, and the second inspecting device 108 are performed independently from each other.

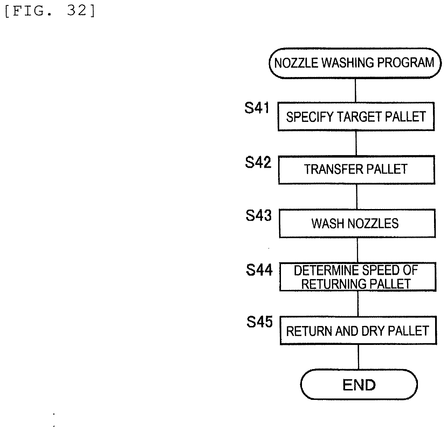

The nozzle washing operation is performed by executing the nozzle washing program illustrated in the flowchart of Fig. 32. In the process according to the program, first, the pallet NP as a target of the operation is specified in S41. Specifically, among pallets NP_{P} for a pre-process in which nozzles N which have not been washed are placed on all placing holes 144 by the first nozzle arranging operation, a pallet NP_{P} for a pre-process on which nozzles N whose storage time is the earliest are placed is specified as a target pallet. Next, the pallet NP is transferred to the above-described washing position by the fourth pallet transfer device 118 in S42. In addition, in S43, nozzles N being placed on the pallet NP are washed by the nozzle washing device 110 with the entire pallet NP in a state in which the pallet NP is positioned in the position.

After the washing of the nozzles N by the washing device 110 is finished, the speed of returning the pallet NP by the fourth transfer device 118 is determined in S44. As described above, the nozzles N being placed on the pallet NP are dried in the middle of returning of the pallet NP by the fourth transfer device 118. Accordingly, in S44, the speed of returning is determined based on the environmental temperature, the temperature of the warm air, and the like in order to secure the time necessary for sufficiently drying the nozzles N. After the speed is determined, in S45, the pallet NP is returned at the determined returning speed and the nozzles N being placed on the pallet NP are dried by the drying device 112 with the entire pallet NP. In addition, after the nozzles N are dried, the above-described stored nozzle information related to the washed nozzles N is updated. Specifically, in the table for information related to stored nozzle illustrated in Fig. 22, a symbol "A" indicating that nozzles are washed is provided and updating for the purpose of handing the nozzles as nozzles in which all inspections are not finished is carried out in regard to all nozzles N being placed on the pallet NP.

### vii) First nozzle inspecting operation

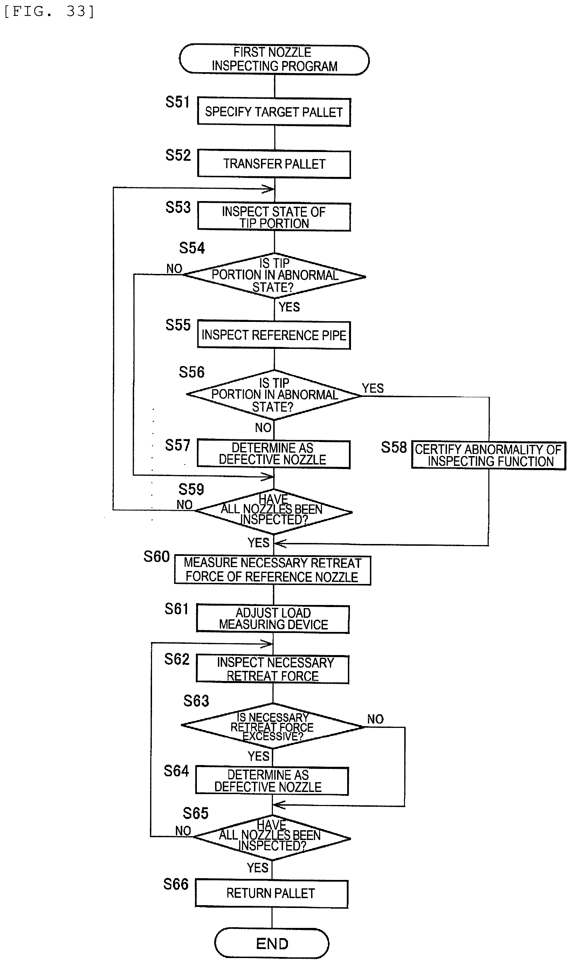

The first nozzle inspection operation is an operation of performing the tip portion state inspection and the necessary retreat force inspection on the nozzles N being placed on one pallet NP in the storing device 100 using the first inspecting device 106 and is performed by executing the first nozzle inspecting program illustrated in the flowchart in Fig. 33. In addition, since the tip portion state inspection and the necessary retreat force inspection have been described above in detail, the flow of the operation will be mainly described here.

In the process according to the first nozzle inspecting program, first, the pallet NP as a target of the operation is specified in S51. Specifically, among pallets NP_{P} for a pre-process on which nozzles N which have been washed by the nozzle washing operation and have not been inspected by the first nozzle inspecting operation are placed, a pallet NP_{P} for a pre-process on which nozzles N whose storage time is the earliest are placed is specified as a target pallet. Next, the pallet NP is transferred to the above-described inspection position by the second pallet transfer device 116 in S52 after the target pallet is determined.

The tip portion state inspection is performed in preference to the necessary retreat force inspection on respective nozzles N being placed on the pallet NP transferred to the inspection position. The tip portion state inspection is sequentially performed on each of the nozzles N. First, the tip portion state inspection is performed on one nozzle N in S53. Specifically, as described above, the lens 239 of the camera device 232 is moved to a position positioned right below the one nozzle N by the unit moving device 236 and the tip portion of the nozzle N is imaged by the camera device 232, and it is confirmed that whether the state of the tip portion is abnormal based on image data obtained by capturing an image. Specifically, it is confirmed that whether the shape abnormality of the tip portion such as "curvature, " "chipping of the tip, " or "crushing of the tip" and "attachment of foreign matters or dirt" are generated on the nozzle N. Based on the result of the confirmation, determination is made in S54 and the tip portion state inspection is performed on the above-described reference pipe 160 fixed to the pallet NP in a case where it is recognized that the state of the tip portion is abnormal in S55. Specifically, the tip portion of the reference pipe 160 is imaged by the camera device 232 and it is confirmed that whether abnormality is found in the state of the tip portion of the reference pipe 160 based on the image data of the tip portion obtained by capturing an image. As a result of the confirmation, determination is made in S56 and it is determined that the nozzle N is a defective nozzle in S57 in a case where the state of the tip portion of the reference pipe 160 is normal. Meanwhile, in the case where the state of the tip portion of the reference pipe 160 is abnormal, it is certified that the function related to the inspection of the first inspecting device 106 is abnormal in S58, the certification is displayed on the display 86, the abnormality of the state of the tip portion with respect to the nozzle N is not determined, and the tip portion state inspection subsequently performed on other nozzles N is skipped. In S54, in a case where it is confirmed that the state of the tip portion is normal or it is determined that the nozzle N is a defective nozzle in S57, processes subsequent to S53 are repeated until the tip portion state inspection is completed on all nozzles N being placed on the pallet NP by performing the process of S59.

As a result of the above-described series of processes, "C" is provided for the column of the "state of the tip portion" of the nozzle N in the information related to stored nozzle illustrated in the table of Fig. 22 in the case where it is determined that the state of the tip portion of the nozzle N is normal and "D" is provided in the case where the nozzle N is determined as a defective nozzle in terms of the state of the tip portion. In the case where it is certified that the function of inspection using the first inspecting device 106 is abnormal, the columns of the "the state of the tip portion" of all nozzles N being placed on the pallet P are blanked. That is, the nozzles N being placed on the pallet NP are considered as nozzles, all of which are not subjected to the tip portion state inspection.

After the tip portion state inspection, the necessary retreat force inspection is sequentially performed on each of the nozzles N being placed on the pallet NP. In a process according to the program, prior to the necessary retreat force inspection with respect to each nozzle N, in S60, the necessary retreat force of the above-described reference nozzle 158 which is fixed to the pallet NP is measured. That is, when the suction pipe 32 of the reference nozzle 158 is allowed to retreat, the load applied to the load cell 242 included in the load measuring device 234 is measured. Next, in S61, the load measuring device 234 is adjusted (for example, setting or the like of the lifted distance of the load measuring device 234 performed by the unit moving device 236) for the purpose of the value of the load measured by the load cell 242 becoming equivalent to the actual value based on the measurement results.

After the above-described adjustment of the load measuring device 234, first, the necessary retreat force inspection is performed on one nozzle N in S62. Specifically, the load cell 242 is positioned on the lower side of the nozzle N to be measured, the load measuring device 234 is lifted by the set distance, and the load applied to the load cell 242 at this time is measured. In addition, in a case where the load is greater than the threshold force set for the nozzle N, it is certified that the necessary retreat force of the nozzle N is excessive. Based on the certification, determination is made in S63, and the nozzle N is determined as a defective nozzle in S64 in the case where the necessary retreat force is excessive. Further, processes subsequent to S62 are repeated until the necessary retreat force inspection performed on all nozzles N being placed on the pallet NP is completed by a process of S65.

As a result of the above-described series of processes, "C" is provided for the column of the "necessary retreat force" of the nozzle N in the information related to stored nozzle illustrated in the table of Fig. 22 in the case where it is determined that the necessary retreat force of the nozzle N is normal and "D" is provided in the case where the nozzle N is determined as a defective nozzle in terms of the necessary retreat force. After the necessary retreat force inspection of all nozzles N being placed on the pallet NP is finished, the pallet NP is returned to the storing device 100 by the second transfer device 116 in S66.

### viii) Second nozzle inspecting operation

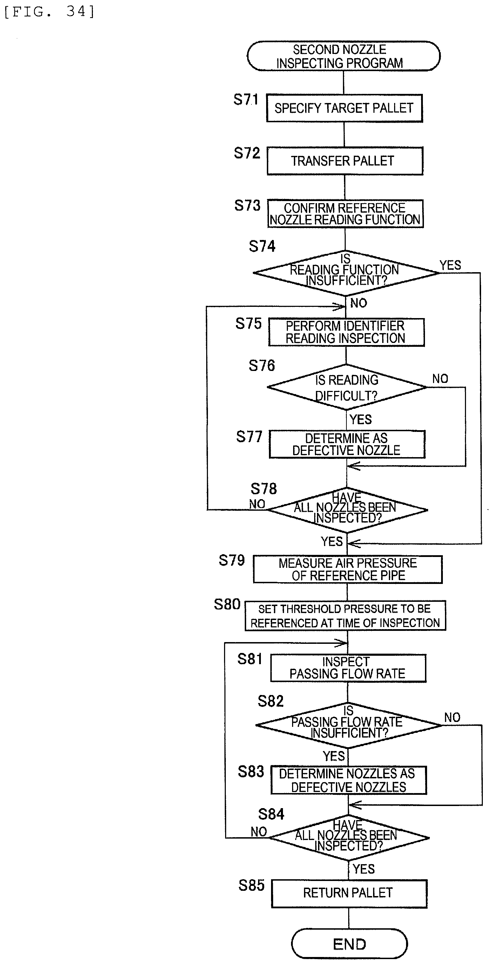

The second nozzle inspecting operation is an operation of performing identifier reading inspection and passing flow rate inspection using the second inspecting device 108 with respect to nozzles N being placed on one pallet NP in the storing device 100 and is performed by executing the second nozzle inspecting program illustrated in the flowchart of Fig. 34. Since the details of the identifier reading inspection and the passing flow rate inspection rate have been described above, the flow of the operation will be mainly described here.

In the process according to the second nozzle inspecting program, first, a pallet NP as a target of the operation is specified in S71. Specifically, among pallets NP_{P} for a pre-process on which nozzles N which have been washed by the nozzle washing operation and have not been inspected by the second nozzle inspecting operation are placed, a pallet NP_{P} for a pre-process on which nozzles N whose storage time is the earliest are placed is specified as a target pallet. Next, the pallet NP is transferred to the inspection position by the third pallet transfer device 118 in S72 after the target pallet is determined.

The identifier reading inspection is performed in preference to the passing flow rate inspection with respect to each of the nozzles N being placed on the pallet NP transferred to the inspection position. The identifier reading inspection is sequentially performed on each of the nozzles N by the camera 276 included in the second inspecting device 108, but the two-dimensional code 38 provided for the flange 34 of the reference nozzle 158 which is fixed to the pallet NP is imaged by the camera 276 prior to the inspection of each nozzle N in S73 and it is confirmed that the function related to the identifier reading inspection of the second inspecting device 100 is sufficient based on the image data obtained by capturing an image. In addition, determination is made in S74 based on the result of the confirmation and the identifier reading inspection is performed on each of the nozzles N in S75 and subsequent steps under the condition in which the above-described function is sufficient. Further, in a case where it is confirm the function related to the identifier reading inspection is insufficient in the determination of S74, the content of confirmation is displayed on the display 86 and the identifier reading inspection is not performed on each of the nozzles N being placed on the pallet NP.

In the identifier reading inspection performed on one nozzle N in S75, first, the inspection head 270 is moved to a position, by the head moving device 272, in which the camera 276 is positioned in the right above the two-dimensional code 38 provided for the flange 34 of the nozzle N. In this state, the two-dimensional code 38 is imaged by the camera 276. In addition, it is confirmed that whether the ID of the nozzle N can be sufficiently recognized based on the image data obtained by capturing an image. The determination is made in S76 based on the result of the confirmation and it is determined that the nozzle N is a defective nozzle in S77 in a case where the ID cannot be sufficiently read from the image two-dimensional code 38, that is, it is difficult to read the two-dimensional code 38. In addition, processes subsequent to the process of S75 are repeated until the identifier reading inspection performed on all nozzles N being placed on the pallet NP is completed by the process of S78.

As a result of the above-described series of processes, "C" is provided for the column of the "reading identifier" of the nozzle N in the information related to stored nozzle illustrated in the table of Fig. 22 in the case where the two-dimensional code 38 can be sufficiently read, that is, the nozzle N is normal in terms of reading an identifier and "D" is provided for the column in the case where the nozzle N is determined as a defective nozzle in terms of reading an identifier. In the case where it is certified that the function of inspection using the second inspecting device 108 is insufficient and the identifier reading inspection is not performed on each nozzle N, the columns of the "reading identifier" of all nozzles N being placed on the pallet NP are blanked so as to include the fact in the stored nozzle information. In addition, in a case where the two-dimensional code 38 cannot be read in the storing and transferring of the nozzles N and in a case where it is determined that the ID of the nozzle N in which "?" is provided for the column of the "nozzle ID" and "(••••)" is provided for the column of the "nozzle type, " can be sufficiently recognized by the identifier reading inspection, and the ID read during the inspection is written in the column of the "nozzle ID" and the nozzle type specified based on the ID is written in the column of the "nozzle type."

After the identifier reading inspection, the passing flow rate inspection is sequentially performed on each of the nozzles N being placed on the pallet NP. However, in the process according to the program, the compressed air is supplied to the above-described reference pipe 160, by the air carrying device 274, which fixed to the pallet NP in S79 prior to the passing flow rate inspection of respective nozzles N, the air pressure is measured by the air pressure sensor 280 in this state. Next, the above-described threshold pressure to be referenced at the time of passing flow rate inspection of the nozzles N is set based on the measured air pressure in S80.

After the threshold pressure is set, first, the passing flow rate inspection is performed on one nozzle N in S81. Specifically, the compressed air is supplied to the nozzle N, to be inspected, by the air carrying device 274 and the air pressure is measured by the air pressure sensor 280 in this state. In addition, in a case where the measured air pressure is higher than the set threshold value, it is certified that the passing flow rate of the air of the nozzle N is insufficient. Based on the result of the certification, in a case where determination is made in S82 and the passing flow rate is insufficient, the nozzle N is determined as a defective nozzle in S83. In addition, processes subsequent to the process of S81 are repeated until the passing flow rate inspection performed on all nozzles N being placed on the pallet NP is completed by carrying out the process of S84.

As a result of the above-described series of processes, "C" is provided for the column of the "amount of passing flow rate" of the nozzle N in the information related to stored nozzle illustrated in the table of Fig. 22 in the case where it is determined that the amount of the passing flow rate of the nozzle N is normal and "D" is provided in the case where the nozzle N is determined as a defective nozzle in terms of the passing flow rate. After the passing flow rate inspection of all nozzles N being placed on the pallet NP is finished, the pallet NP is returned to the storing device 100 by the third transfer device 118 in S85.

### ix) Several modes in regard to alignment of nozzles

The nozzles N after being provided for the first and second inspecting operations are arranged by being aligned on the pallet NP_{A} for alignment by performing the second nozzle arranging operation. In regard to the alignment, there are several modes following different rules, and one or more modes from the several modes can be selectively employed in the management machine 80. That is, the second nozzle arranging operation is an operation that arranges and transfers the nozzles N according to rules for making the alignment mode of nozzles N into a selected alignment mode. Hereinafter, several alignment modes which can be employed will be sequentially described including ejection of nozzles N for setting.

### ix-a) Alignment mode for separating nozzles for each type

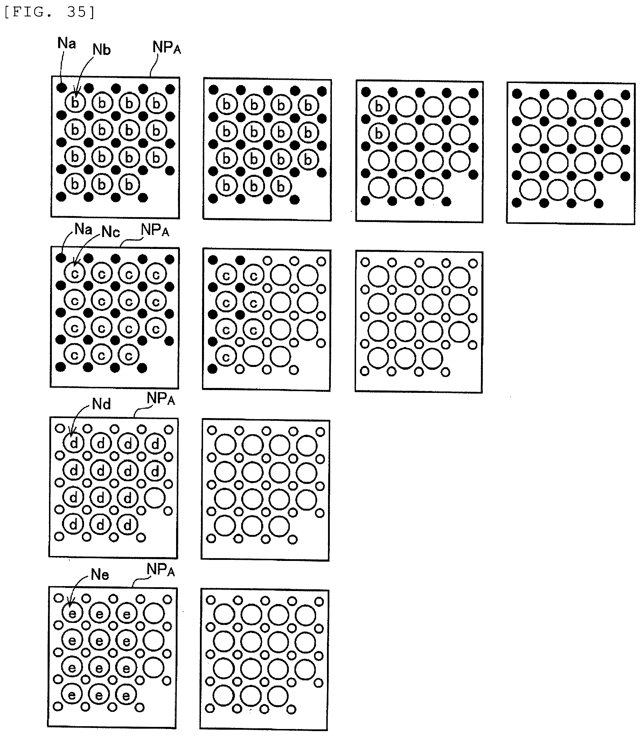

One of the several alignment modes which can be employed is a mode which can be referred to as an "alignment mode for separating nozzles for each type" and is a mode that arranges the nozzles N by aligning them on pallets NP_{A} for alignment for each type of nozzle when simply described. Specifically, the mode is a mode in which only the same kinds of nozzles of four kinds of nozzles Nb to Ne which can be placed on the same placing holes 144b from among the above-described five kinds, that is, five types of nozzles N, are arranged by being aligned on one pallet NP_{A} for alignment. Here, it is assumed that one hundred twenty eight nozzles Na, thirty two nozzles Nb, twenty two nozzles Nc, fourteen nozzles Nd, and twelve nozzles Ne are present as the nozzles N in which the first and second inspections are finished, the nozzles N are arranged as illustrated in Fig. 35 by following the rules of the mode. Further, in the figures subsequent to the this figure, characters of "b," "c," "d," and "e" are respectively written in the placing holes 144b on which nozzles Nb, nozzles Nc, nozzles Nd, and nozzles Ne are placed instead of filling the placing holes 144b with black in some cases.

As illustrated in the figure, in the alignment mode for separating nozzles for each type, several pallets NP_{A} for alignment are allocated to each of the nozzles Nb to Ne. Specifically, four pallets NP_{A}, three pallets NP_{A}, two pallets NP_{A}, and two pallets NP_{A} are respectively allocated to the nozzle Nb, the nozzle Nc, the nozzle Nd, and the nozzle Ne according to the respective numbers. Four pallets NP allocated to the nozzle Nb are four pallets NP on the top stage on the figure, the four pallets NP are ranked in order from the left side, and nozzles Nb are aligned according to the above-described arrangement order in order from the pallet NP in the head position. Further, since nozzles Nb whose storage time is earlier are arranged in the head position, the nozzles Nb are aligned in order from the nozzles whose storage time is earlier through the four pallets NP. The three pallets NP allocated to the nozzles Nc are three pallets NP at the second stage from the top of the figure and the three pallets NP are ranked similar to the nozzles Nb. The nozzles Nc are aligned in the three pallets NP in order from the nozzles whose storage time is earlier through the three pallets NP in order from the left side according to the above-described arrangement order. The two pallets NP allocated to the nozzles Nd are two pallets NP at the third stage from the top of the figure and the two pallets NP are ranked similar to the nozzles Nb. The nozzles Nd are aligned in the two pallets NP in order from the nozzles whose storage time is earlier through the two pallets NP in order from the left side according to the above-described arrangement order. The two pallets NP allocated to the nozzles Ne are two pallets NP at the lowermost stage of the figure and the two pallets NP are ranked similar to the nozzles Nb. The nozzles Ne are aligned in the two pallets NP in order from the nozzles whose storage time is earlier through the two pallets NP in order from the left side according to the above-described arrangement order. Further, in order to add and align the nozzles N in which the first and second inspections are finished, the pallets NP on the rearmost side at each stage are used as pallets NP on which nozzles N are not placed.

Further, the nozzles Na are aligned by following rules different from those of the nozzles Nb to Ne. Specifically, all pallets NP_{A} for alignment illustrated in the figure are ranked and the nozzles Na are aligned in order from nozzles whose storage time is earlier through all those pallets NP according to the above-described arrangement order. That is, the nozzles Na and Nb to Ne are placed on the same pallet NP, but the nozzles are managed in dimensions from different from each other. In addition, allocating and ranking of the pallets NP illustrated in the figure are virtual and there is no special relationship between the allocating or ranking and the position in the storing device 100, that is, the position of the carrier 130 stored in the storing device.

In a case where the nozzles N aligned in the above-described manner are provided for setting, respective types of nozzles N are ejected from the pallet NP in order from the pallet NP in the head position in the above-described ranking according to the alignment order. That is, in the setting, respective types of nozzles N are transferred to the tray NT in order from the nozzles whose storage time is earlier. Meanwhile, respective types of nozzles N in which the first and second inspections are finished are additionally arranged on the pallet NP on which the nozzles N on the rearmost side are placed according to the arrangement order in order to maintain the alignment following rules. By performing the ejection in the above-described manner, the pallet NP in the head position in the ranking becomes a pallet NP on which nozzles N are not placed in a case of any type of nozzles N when the ejection progresses. At this time, a change in the ranking occurs. Specifically, the pallet NP from which nozzles N are removed by being transferred is positioned in the rearmost position and the ranking is made such that a pallet NP next to the pallet NP becomes a pallet NP positioned in the head position. Further, it is possible to realign respective types of nozzles N by performing the above-described "process of transferring and filling with nozzles on the front side" and transferring the nozzles N to the empty placing hole 144 in the head position instead of changing the above-described ranking.

ix-b) Alignment mode for mixing various types of nozzles

One of the several alignment modes which can be employed is a mode which can be referred to as an "alignment mode for mixing various types of nozzles" and is a mode that mixes at a specific ratio and arranges respective types of nozzles N by aligning them on one pallet NP_{A} for alignment when simply described. In other words, the mode is a mode in which plural types of nozzles N are aligned on one pallet NP_{A} for alignment and arranged by forming a set obtained by mixing the nozzles N at a specific ratio. Specifically, the mode is a mode in which the above-described five kinds of nozzles Na to Ne, that is, five types of nozzles Na to Ne are aligned on one pallet NP_{A} for alignment and arranged by mixing the nozzles N at a ratio according to the frequency of use for each type. The frequency of use for each type is based on the above-described information related to the frequency of use for each type of nozzle and the information is stored in the controller 84 as a table for information related to the frequency of use for each type of nozzle illustrated in Fig. 23 as described above.

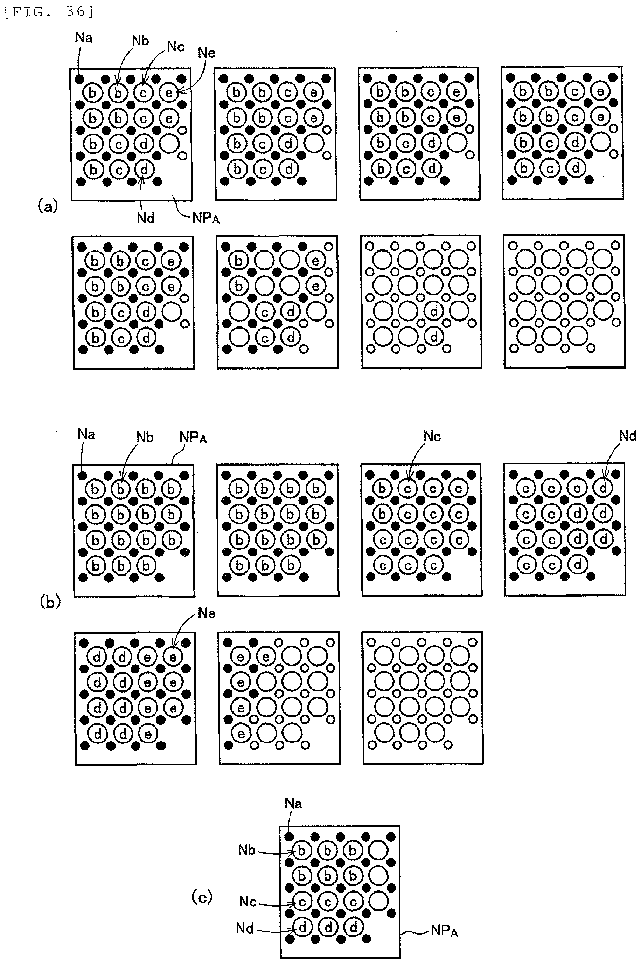

When it is assumed that the frequency of use for each type of nozzle, that is, the total value of the number of times of settings for each type nozzle is 1056 for nozzles Na, 276 for nozzles Nb, 182 for nozzles Nc, 122 for nozzles Nd, and 98 for nozzles Ne, the integer ratio of the frequency of use for each type of nozzle N in a case where the nozzle Ne whose value of frequency of use is the lowest is set as 1 is "Na:Nb:Nc:Nd:Ne = 11:3:2:1:1." One or more sets of nozzles Na to Ne in which the nozzles Na to Ne are formed at this rate are arranged on one pallet NP. Further, in a case where it is assumed that respective numbers of the nozzles Na to Ne in which the first and second inspections are completed are the same as those in the case of the alignment mode for separating each type of nozzle and those nozzles N are aligned by following the rules of the alignment mode, those nozzles N are arranged as illustrated in Fig. 36(a). In the figure, two sets of nozzles N are respectively arranged in four pallets NP at the upper stage and the pallet NP on the leftmost side at the lower stage. Further, in the figure, eight pallets NP are allocated as pallets NP_{A} for alignment, those pallets NP are ranked from the left to right side at the upper stage and from the left to right at the lower stage, and nozzles N are arranged in order from the pallet on the head side according to the ranking. Specifically, two sets of nozzles N are aligned such that the nozzles are continuously arranged on each pallet NP according to the arrangement order for each type of nozzle, specifically, each type of nozzle N is arranged in order from the nozzles whose storage time is earlier. Accordingly, an empty placing hole 144 is present on the rearmost side of the five pallets NP and several nozzles N which cannot form a set are placed on the placing hole 144 on which nozzles are placed when they can form a set in the second and third pallets NP from the left side at the lower stage. In addition, in order to add and align nozzles N in which the first and second inspections are finished, the pallet NP on the rearmost side, that is, the pallet NP on the rightmost side at the lower stage are considered as pallets NP on which all nozzles Na to Ne are not placed. In addition, ranking of the pallets NP illustrated in the figure is virtual similar to the case of the alignment mode for separating each type of nozzle and there is no special relationship between the ranking and the position in the storing device 100, that is, the position of the carrier 130 stored in the storing device.

In a case where the nozzles N aligned in the above-described manner are provided for setting, nozzles N are ejected from the pallet NP in order from the pallet NP in the head position in the above-described ranking according to the alignment order similar to the case of the alignment mode for separating each type of nozzle. That is, in the setting, respective types of nozzles N are transferred to the tray NT in order from the nozzles whose storage time is earlier. Meanwhile, respective types of nozzles N in which the first and second inspections are finished are additionally arranged in order from the pallet NP on which the nozzles N on the rearmost side are placed according to the arrangement order in order to maintain the alignment following rules similar to the case of the alignment mode for separating for each type of nozzle. By performing the ejection in the above-described manner, the pallet NP in the head position in the ranking becomes a pallet NP on which nozzles N are not placed when the ejection progresses. At the time, a change in ranking is made such that the pallet NP is positioned on the rearmost side and a pallet NP next to the pallet NP becomes a pallet NP in the head position similar to the case of the alignment mode for separating each type of nozzle. Further, it is possible to realign respective types of nozzles N by performing the above-described "process of transferring and filling with nozzles on the front side" and transferring the nozzles N to the empty placing hole 144 in the head position instead of changing the above-described ranking.

Further, according to the alignment mode for mixing each type of nozzle, since a plurality of types of nozzles N, specifically, all types of nozzles N are placed on each pallet NP at a ratio according to the frequency of use of each type of nozzle, each type of nozzle N is ejected from the pallet NP at substantially the same ratio at the time of setting the nozzles in the tray NT. Accordingly, it is highly likely to finish the setting by setting only one pallet NP in the transfer position at the time of setting nozzles in one tray NT. Accordingly, the arrangement of nozzles N in the alignment mode for mixing each type of nozzle highly contributes to rapid setting.

### ix-c) Type order alignment mode

Another one of the several alignment modes which can be employed is a mode which can be referred to as a "type order alignment mode" and a mode that arranges respective types of nozzles N on several pallets NP_{A} for alignment in specific order for each type when simply described. Specifically, the mode is a mode in which several types of nozzles N are continuously used and arranged on several pallets NP in order from the nozzles whose frequency of use for each type of nozzle is higher so as to collect each type of nozzle N. The frequency of use for each type is based on the above-described information related to the frequency of use for each type of nozzle similar to the alignment mode for mixing each type of nozzle and the information is stored in the controller 84 as a table for information related to the frequency of use for each type of nozzle illustrated in Fig. 23 as described above.

When it is assumed that the frequency of use for each type of nozzle is the frequency described in the alignment mode for mixing each type of nozzle and respective numbers of the nozzles Na to Ne in which the first and second inspections are finished are the same numbers in the case of the alignment mode for separating each type of nozzle described above, nozzles N in the type order alignment mode are arranged as illustrated in Fig. 36(b). In the figure, eight pallets NP are allocated as the pallets NP_{A} for alignment, the pallets NP are ranked from the left side to the right side at the upper stage and the left side to the right side at the lower stage, and the nozzles N are arranged in order from the pallets on the head side according to the ranking. The nozzles Nb to Ne being placed on the placing hole 144b are continuously aligned in order of the pallet NP on the head side and in order of the nozzles Nb, the nozzles Nc, the nozzles. Nd, and the nozzles Ne according to the arrangement order described above. Each of the nozzles Nb, the nozzles Nc, the nozzles Nd, and the nozzles Ne are arranged from the nozzles whose storage time is earlier according to the arrangement order described above among the respective arrangement orders. The nozzle Na being placed on the placing hole 144a are arranged in order from the pallet NP on the head side and in order from the nozzles whose storage time is earlier according to the arrangement order described above regardless of other types of nozzles Nb to Ne. Further, in order to add and align nozzles N in which the first and second inspections are finished, the pallet NP on the rearmost side, that is, the pallet NP on the rightmost side at the lower stage are considered as pallets NP on which all types of nozzles N are not placed. In addition, ranking of the pallets NP illustrated in the figure is virtual similar to the cases of two modes described above and there is no special relationship between the ranking and the position in the storing device 100, that is, the position of the carrier 130 stored in the storing device. However, the ranking of the pallets NP are fixed in this type order alignment mode.

In the case where the nozzles N aligned in the above-described manner are provided for setting and a kind of nozzles N are transferred, the pallet NP on which nozzles N in the head position of the kind of nozzles N are placed is set and the nozzles N are transferred to the tray NT in order from nozzles whose storage time is earlier according to the alignment order. Accordingly, in a case where any of the nozzles Nc, the nozzles Nd, and the nozzles Ne are set and transferred, which is different from the above-described two modes, the placing hole 114b on which nozzles N are not placed appears between different types of nozzles N. Further, in the case where each type of nozzle N in which the first and second inspections are finished is added and aligned, the nozzles N being placed on the pallet NP, that is, the nozzles Nb, the nozzles Nc, the nozzles Nd, and the nozzles Ne are constantly continuously aligned in order from the pallet NP in the head position according to the above-described arrangement order in the state illustrated in the figure and the nozzles Na are arranged in an alignment state in order from the pallet NP in the head position according to the alignment order, which is different from two modes described above. Therefore, in the case where the nozzles N are added and aligned, the state in which the nozzles N are placed is grasped in advance after being added and the nozzles N are rearranged such that the nozzles N enter the grasped state. That is, the nozzles are rearranged in one pallet NP_{A} for alignment and between two pallets NP_{A} for alignment using the above-described "process of transferring and filling with nozzles on the front side" or a "process of transferring and filling with nozzles on the rear side". Moreover, the "process of transferring and filing nozzle on the rear side" is a transferring process that determines the placing hole 144 on which nozzles N on the rearmost side are placed and aligns several nozzles N in order from nozzles on the rearmost side which is opposite to the arrangement order.

In addition, according to the type order alignment mode, as understood from comparison among Figs. 36(b), 36(a), and 35, since the pallets NP on which the nozzles N are not fully placed can be reduced, the number of pallets NP_{A} for alignment being allocated can be reduced as possible. Further, according to the type order alignment mode, in a case where the nozzles N whose storage time is earlier are not necessarily and preferentially ejected in the setting of the nozzles N in the tray NT, for example, since two types of nozzles N can be continuously transferred to the tray NT by setting the pallet NP on which two types of nozzles N from among the nozzles Nb to Ne are placed in the transfer position, it is possible to perform setting rapidly to some extent.

### ix-d) Special set alignment mode

Another one of the several alignment modes which can be employed is a mode which can be referred to as a "special set alignment mode" and an alignment mode that collectively arranges nozzles N being placed on the tray NT so as to form a special set thereon when simply described. For example, a state in which a set of nozzles N, that is, one set of nozzles N of eight nozzles Na, two nozzles Nb, one nozzle Nc, and one nozzle Nd, are arranged on one pallet NP_{A} for alignment is a state illustrated in Fig. 36(c). In the figure, two sets of nozzles N are aligned and arranged.

When a set of nozzles N which are frequently used are aligned and arranged in one pallet NP as a special set as described above, setting of nozzles N of the set which is relatively frequently performed can be rapidly performed. In addition, when a set of nozzles N which are expected to be used are aligned and arranged in one pallet NP as a special set before setting, setting of nozzles N of the set can be rapidly performed.

This special set alignment mode can be employed with the above-described other alignment modes. That is, nozzles N may be arranged in some of a plurality of pallets NP allocated as the pallet NP_{A} for alignment in this special set alignment mode. In consideration of this point, the above-described three alignment modes can be considered as basic alignment modes and this alignment mode can be considered as an additional alignment mode. Further, in a case where this alignment mode is employed, a plurality of sets which are respectively formed of different types of nozzles N can be collectively arranged for each pallet NP.

In addition, in this alignment mode, the nozzles N may not be arranged by following the above-described arrangement order as a rule. Particularly, in the case where other alignment modes are employed with this alignment mode, the probability in which the nozzles N may not be arranged by following the arrangement order is high. However, even in a case where the nozzles cannot be arranged by following the arrangement order, for example, it is preferable that the nozzles are aligned in order from the nozzles whose storage time is earlier for each set from a viewpoint of making the frequency of use of nozzles N as uniform as possible.

### x) Second nozzle arranging operation

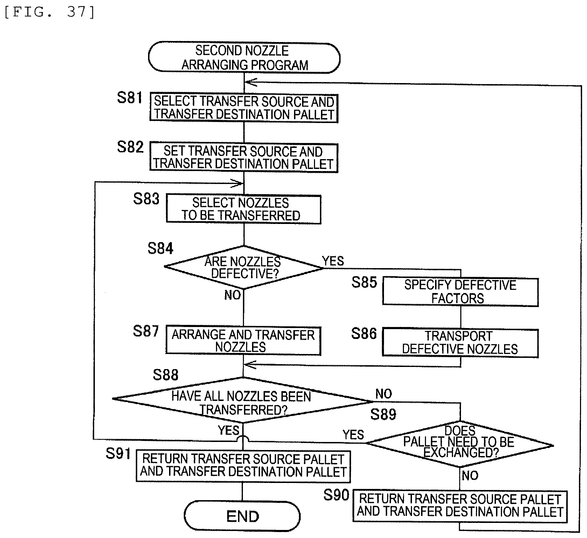

The second nozzle arranging operation is an operation for aligning and arranging nozzles N in which the first and second inspections are completed on one or more pallets NP_{A} for alignment from the pallet NP_{P} for a pre-process. The operation is performed by the controller 84 executing a second nozzle arranging program illustrated in the flowchart of Fig. 37 . The operation is started under the condition in which the above-described nozzle storing operation, the first nozzle arranging operation, and the nozzle setting operation are not performed in a case where the pallet NP_{P} for a pre-process on which nozzles N in which the first and second inspections are finished are placed appears. In addition, specific techniques of arranging of nozzles N in the second nozzle arranging operation, that is, the arrangement transfer of nozzles N is different from each other in terms that which mode from among the above-described alignment modes is employed. Since the details of the arrangement transfer of nozzles in respective modes have been described above with reference to the figures, the above-described alignment modes are generally handled here, the description of the specific techniques of arrangement transfer of nozzles N is not described, and the operation will be described.

In a process according to the second nozzle arranging program, first, the transfer destination pallet NP₁ and the transfer source pallet NP₂ are selected in S81. For example, in a case where the alignment mode is considered as the alignment mode for separating for each type of nozzle or the alignment mode for mixing each type of nozzle without performing the above-described process of transferring and filling with nozzles on the front side, as a rule, a pallet NP_{P} for a pre-process on which nozzles N in which the first and second inspections are finished are placed is selected as the transfer source pallet NP₂ and one of one or more pallets NP_{A} for alignment serving as a candidate to which the nozzles N being placed on the transfer source pallet NP₂ are transferred are selected based on the employed alignment mode as the transfer destination pallet NP₁. In addition, for example, in a case where the alignment mode is considered as the type order alignment mode or the alignment mode for separating each type of nozzle or the alignment mode of mixing each type of nozzle to be expected to perform the process of transferring and filling with nozzles on the front side, the pallet NP_{A} for alignment and another pallet NP_{A} for alignment are respectively selected as the transfer destination pallet NP₁ and the transfer source pallet NP₂ in order to perform the process for transferring and filling with the nozzles on the front side and the process of transferring and filling with nozzles on the rear side in addition to the above-described selection.

Next, in S82, the pallets NP selected in S81 are transferred from the storing device 100 by the first transfer device 114 and respectively set in the first transfer position and the second transfer position. In addition, it is determined that which one of the selected two pallets NP is set in the first transfer position or the second transfer position in consideration that the operation is performed as rapidly as possible. Specifically, for example, in a case where the alignment mode is an alignment mode of separating each type of nozzle or an alignment mode of mixing each type of nozzle in which the above-described transferring and filling with nozzles on the front side is not performed, as a rule, the transfer source pallet NP₂ is set in the first transfer position and the transfer destination pallet NP₁ is set in the second transfer position. Meanwhile, for example, in a case where the alignment mode is a type order alignment mode, an alignment mode of separating each type of nozzle or an alignment mode of mixing each type of nozzle in which the process of transferring and filling with nozzles on the front side is to be performed, one of the two pallets NP is set in the first transfer position and the other is set in the second transfer position in order to reduce the number of times of setting the pallet NP accompanied by exchange as largely as possible.

After two pallets NP are set, nozzles N to be transferred are selected in S83 . In a case where the nozzles N being placed on the pallet NP_{P} for a pre-process is aligned and arranged in the pallet NP_{A} for alignment, nozzles N whose storage time is earlier are preferentially selected according to the above-described arrangement order. In addition, in a case where the above-described process of transferring and filling with nozzles on the front side and process of transferring and filling with nozzles on the rear side are performed, nozzles N to be transferred are selected such that the processes can be efficiently performed.

In the operation, a process with respect to defective nozzles is performed prior to the arrangement transfer of nozzles N. Specifically, it is determined whether the nozzles N selected in S83 are defective nozzles based on the information related to stored nozzle illustrated in the table of Fig. 22 in S84, and the above-described defective factors of the nozzles N are specified based on the stored nozzle information when the nozzles N are defective nozzles in S85. In addition, the nozzles N are transported to the above-described defective box 224 by the transfer device 104 in S86. As described above, partitioned four spaces 226 are provided in the defective box 224 corresponding to four defective factors and the defective nozzles are placed in one space 226 corresponding to the specified defective factor at the time of transportation of the defective nozzles. Further, when the transportation is completed, information related to the defective nozzles is deleted from the stored nozzle information. In addition, in a case where two or more defective factors are present with respect to one defective nozzle, the defective nozzle is placed in the space 226 corresponding to the defective factor of the column on the leftmost side in the table of Fig. 22.

In a case where the selected nozzle N are not defective nozzles, in S87, the transfer of nozzles N for the arrangement thereof, that is, the arrangement transfer of nozzles is performed by the transfer device 104. In a case where the nozzles N are aligned and arranged in the transfer destination pallet NP₁, the nozzles N are placed on the placing hole 144 according to the above-described arrangement order. That is, the selected nozzles N are transferred such that the nozzles N whose storage time is earlier are positioned on the head side in the arrangement order. In addition, the stored nozzle information is updated according to the arrangement transfer of one nozzle N. Specifically, specific information of nozzles N stored in cells subsequent to the "nozzle ID" of the row corresponding to the placing hole 144 on which the nozzles N are placed in the transfer source pallet NP₂ is transferred to one of the rows of the table for information related to stored nozzle illustrated in Fig. 22, that is, cells subsequent to the "nozzle ID" of the row corresponding to the placing hole 144 of the transfer destination pallet NP₁ on which the nozzles N are placed.

Next, in S88, in a case where the arrangement transfer of all nozzles is not finished when it is determined whether the arrangement transfer of all nozzles N to be expected to be arranged and transferred is finished, it is determined whether at least one of the transfer source pallet NP₂ and the transfer destination pallet NP₁ needs to be exchanged in S89. In a case where both pallets NP does not need to be exchanged, processes subsequent to the process of S83 are repeated. Meanwhile, in a case where at least one of the transfer source pallet NP₂ and the transfer destination pallet NP₁ needs to be exchanged, in S90, one or both of the transfer source pallet NP₂ and the transfer destination pallet NP₁ are returned to the storing device 100 by the first transfer device 114 and processes subsequent to the process of S81 are repeated. In addition, only a pallet NP is returned in a case where only the pallet NP set in the second transfer position is exchanged, but two pallets NP are returned in a case where only the pallet NP set in the first transfer position is exchanged.

In a case where the arrangement transfer of all nozzles N to be expected to be arranged and transferred is finished, in S91, both of the transfer source pallet NP₂ and the transfer destination pallet NP₁ are returned to the storing device 100 by the first transfer device 114 and then the second nozzle arranging operation is finished.

### xi) Nozzle setting operation

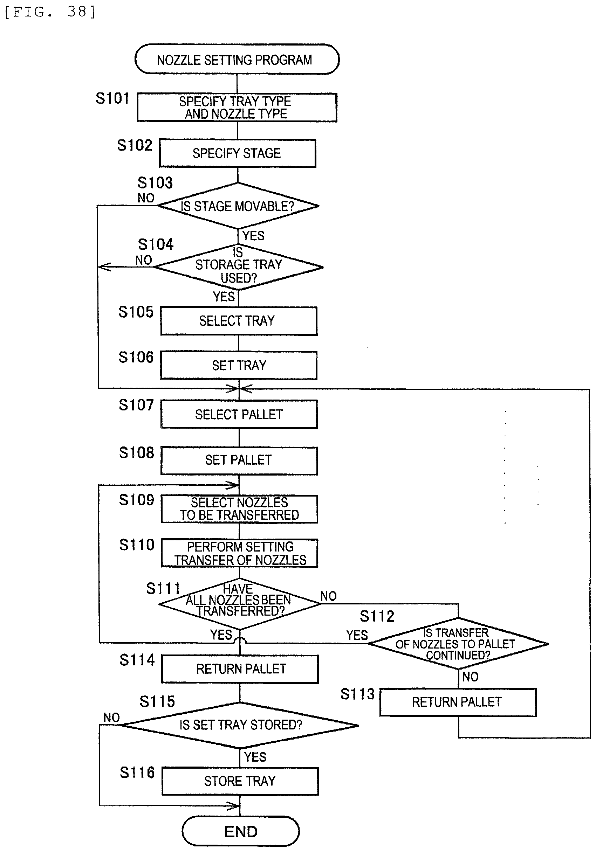

The nozzle setting operation is an operation of setting necessary nozzles N in the tray NT for the purpose of preparation of nozzles N to be used for the mounting machine and the operation is performed by the controller 84 executing the nozzle setting program illustrated in the flowchart in Fig. 38. In addition, in the nozzle setting operation, it is possible to respectively select whether the stage for setting nozzles N is the fixed stage 202 or the movable stage 204, whether any one of the tray NT stored in the storing device 102 and the tray NT set by the operator of the management machine 80 is used, and whether the tray NT which has been set is to be stored in the storing device 102, and the selection is performed based on the operation using the operation key 88 of the controller 84 by the operator.

In the process according to the nozzle setting process, first, the type of tray NT and the type of each nozzle N provided for setting are specified based on nozzle setting information which is sent or input to the management machine 80 or nozzle setting information stored previously in S101. The nozzle setting information can be considered as information in which the "tray ID" and the "nozzle ID" are not written in the table illustrated in Fig. 25.

Next, in a case where it is specified whether the stage in which nozzles are set is the fixed stage 202 or the movable stage 204 in S102 and the specified stage is determined as the movable stage 204 in S103, it is determined whether the tray NT stored in the storing device 102 is used in S104. In a case where it is determined that the tray NT stored in the storing device 102 is used, one tray NT is selected based on the nozzle setting information and the stored tray information in S105, and the selected tray NT is transferred to the transfer position by the tray transfer device 122 and set in the transfer position in S106. Meanwhile, in a case where it is determined to use a tray NT that is set by the operator in S104 or the setting is performed on the movable stage 202 in S103, since the tray NT is already set by the operator, selecting and setting of a tray NT are not performed.

Next, in S107, one pallet NP provided for setting transfer is selected from among a plurality of pallets NP included in the storing device 100 based on the nozzle setting information and the stored nozzle information. In this selection, one pallet NP is selected from a viewpoint that setting of nozzles N can be efficiently performed in pallets NP_{A} for alignment according to the alignment modes being employed. Further, in S108, the selected pallet NP is transferred by the first transfer device 114 and set in the above-described transfer position. The transfer position may be the above-described first transfer position or the second transfer position. In addition, two pallets NP_{A} for alignment are selected in S107 and may be respectively set in the first transfer position and the second transfer position so as to be aligned in S108.

In S109, one nozzle which can be placed on the set tray NT is selected from among the nozzles N being placed on the set pallet NP based on the stored nozzle information and the nozzle setting information, and the selected nozzle N is transferred to a specific placing hole 64 of the set tray NT by the transfer device 104 based on the nozzle setting information in S110. That is, the above-described setting transfer is performed. At the time of setting transfer, information related to the nozzles N to be transferred is deleted from the stored nozzle information and the ID of the nozzles N is added to the nozzle setting information. In addition, the information related to frequency of use for each type of nozzle illustrated in the chart of Fig. 23 is updated. Specifically, the number of times of use for each type of nozzle being stored in the column of the "frequency of use" in the row of the type of nozzles N is counted. In addition, in the selection of the nozzles N, the nozzles whose stored time is earlier are preferentially selected according to the above-described arrangement order.

After setting transfer of one nozzle N is finished, it is determined whether the setting transfer of all nozzles N to be expected for the setting transfer is completed in S111. In a case where the setting transfer of all nozzles N is not completed, it is determined whether the transfer of nozzles N from the set pallet NP is continued in S112 . In a case where the transfer of the nozzle N from the pallet NP can be continuously performed, the process is returned to S109 and the next nozzle N is transferred from the pallet NP to the tray NT. For example, in a case where it is determined that the transfer of the nozzles from the pallet NP cannot be continued in S112 because of the reason that the nozzles N which can be transferred are not present in the pallet NP or the like, the pallet NP is returned to the storing device 100 by the first transfer device 114 in S113, the process is returned to S107, and the next pallet NP is selected. After the pallet NP is set, the setting transfer of the nozzles N from the pallet NP is started. In S111, in a case where it is determined that the setting transfer of all nozzles N to be expected for the setting transfer is completed, the set pallet NP is returned to the storing device 100 by the first transfer device 114 in S114.

After the setting transfer of all nozzles N is completed and the pallet NP is returned, in S115, it is determined whether the tray NT in which the nozzles N are set is stored in the tray storing device 102 . In a case where it is determined that the tray NT is stored in the storing device 102, in S116, the set tray NT is stored in the storing device 102 by the tray transfer device 122 and the nozzle storing operation is finished. Meanwhile, in a case where it is determined that the tray NT is not stored in the storing device 102 in S115, the setting of the tray NT is released and the nozzle storing operation is finished in a state in which the tray NT remains in the fixed stage 102 or the movable stage 204. Moreover, the two-dimensional code 76 provided for the tray NT is imaged by the camera 22 provided for the transfer device 104 prior to the setting transfer of the nozzle NT, the ID of the tray NT is acquired, and the ID of the tray NT is added to the stored tray information by being associated with the carrier 192 to be stored together with the fact that the tray NT is a tray NT in which the setting of the nozzles N are finished at the time when the tray NT is stored in the storing device 102. Meanwhile, in a case where the operation is finished in a state in which the tray NT already set in the movable stage 204 remains, the information related to the tray NT included in the stored tray information is deleted.

According to the above-described nozzle setting operation, the setting transfer is performed on the nozzles N having the same type, that is, the same form in order from the nozzles whose storage time is earlier. Specifically, in each of the nozzle storing operation, the first nozzle arrangement operation, the second nozzle arranging operation, and the nozzle setting operation, the nozzles N are preferentially transferred to the pallet NP in order from the nozzles whose storage time is earlier according to the arrangement order and are preferentially ejected from the pallet NP in order from the nozzles whose storage time is earlier, and accordingly, the setting of the nozzles N whose storage time is earlier is performed. In other words, in both of the first nozzle arranging operation and the second nozzle arranging operation, the nozzles N are transferred to the tray NT in order from the nozzles whose unused period is longer in the setting operation by arranging the nozzles N in order from the nozzles whose unused period is longer for each type of nozzles and transferring the nozzles N to the tray NT from the pallet NP according to the order in the nozzle setting operation. As a result, the setting is performed such that the frequency of use of the nozzles N becomes as uniform as possible.

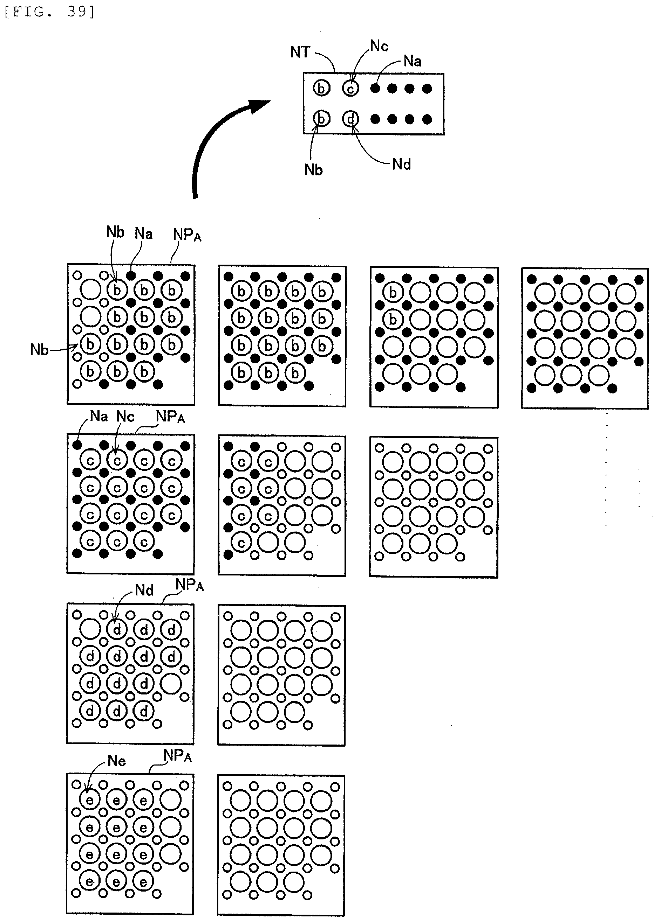

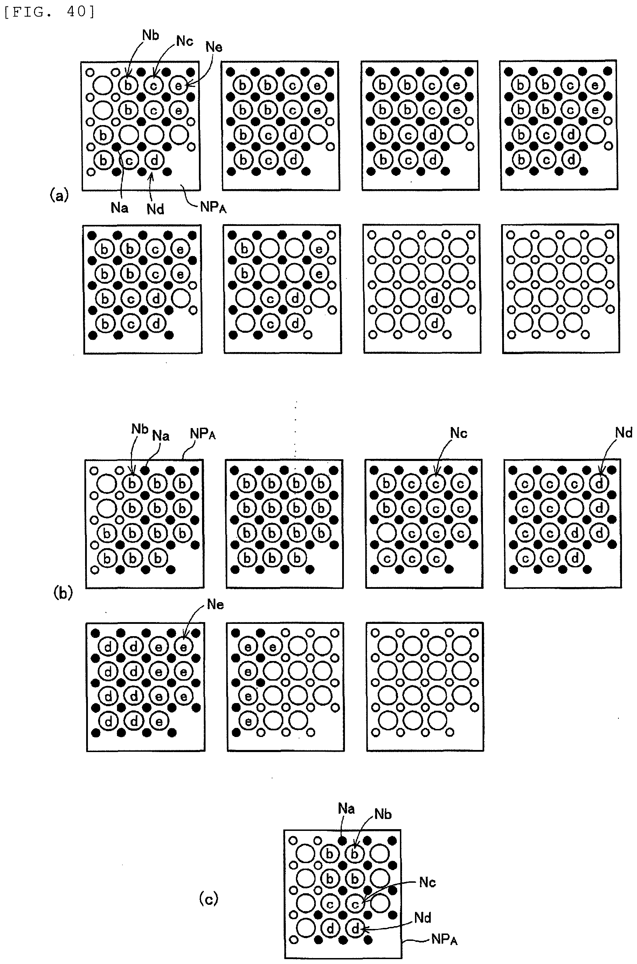

Here, for the sake of easy understanding for the differences among the above-described several alignment modes, the results of setting eight nozzles Na, two nozzles Nb, two nozzles Nc, two nozzles Nd, and two nozzles Ne in one tray NT are respectively illustrated in Figs. 39 and 40(a) to 40(c) from a state the nozzles N are arranged as illustrated in Figs. 35 and 36(a) to 36(c). This set of nozzles N is the above-described specific set and the setting of nozzles N from only one pallet NP is possible in the specific set alignment mode illustrated in Fig. 40(c). In addition, in the alignment mode of mixing each type of nozzle illustrated in Fig. 40(a), since nozzles N are arranged in one pallet NP at a ratio in accordance with the frequency of use for each type of nozzle, the possibility of setting nozzles N in only one pallet NP becomes higher. Therefore, according to those two alignment mode, the possibility of rapidly setting nozzles becomes higher.

### xii) Nozzle resetting operation

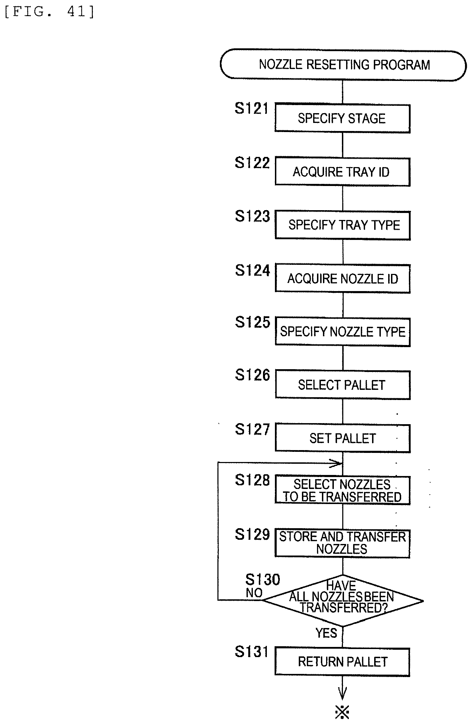

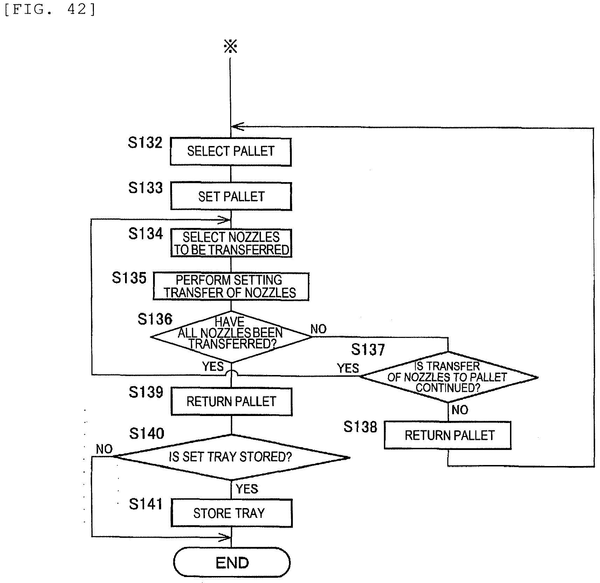

The nozzle resetting operation is an operation of setting the tray NT on which nozzles N are already set on a stage and placing other nozzles N having the same form as that of the nozzles N in place of the nozzles N. In other words, the nozzle resetting operation is an operation of creating nozzle setting information based on the set tray NT and exchanging nozzles based on the information. The nozzle setting operation is performed by the controller 84 executing the nozzle resetting program illustrated in the flowcharts of Figs. 41 and 42. Further, in the nozzle setting operation, it is possible to select the stage for setting the nozzles N between the fixed stage 202 and the movable stage 204 and to select whether the reset tray NT is stored in the storing device 102, and the selection is performed using the operation key 88 of the controller 84 based on the operation by the operator.

In the nozzle resetting operation, when simply described, the nozzle storing operation is performed in the first half of the operation. Specifically, nozzles N being placed on the set tray NT are stored in the storing device 100 by the process according to the first half portion of the nozzle resetting program illustrated in the flowchart of Fig. 41. Since the processes performed in S121 to S131 of the program are substantially the same as those performed in S1 to S11 of the nozzle storing program described above, the description of the processes is not repeated, but nozzle setting information is created in this operation based on the form of the tray NT and the form of nozzles N specified in S123 and S125.

After the nozzles N being placed on the tray NT are stored in the storing device 100, other nozzles N stored in the storing device 100 are set in the tray NT on which the nozzles N are placed by the process according to the second half of the nozzle resetting program illustrated in the flowchart of Fig. 42. Since the process performed in the flow starting from the program of S132 to the process of S141 is substantially the same as the process performed in the flow starting from the above-described nozzle setting program of S107 to the process of S116, the description of these processes will not be repeated.

When simply described, the above-described operation is an operation of transferring other nozzles N having the same form as that of the nozzles N transferred from the tray NT by the nozzle storing operation to the tray NT by the nozzle setting operation. The operation is a convenient in a case where a set of nozzles N set in the tray NT is exchanged for another set of nozzles N having the same form as that of the above-described set for the purpose of avoiding the use of the nozzle N for a long period of time.

### xiii) Other operations

The management machine 80 can perform several operations other than the above-described operations. As an example thereof, a nozzle maintenance operation that performs maintenance of nozzles N being placed on the tray NT can be exemplified.

The nozzle maintenance operation is an operation for ejecting nozzles N being placed on the tray NT from the tray N, washing, inspecting, and resetting the nozzles N in the tray NT. In the operation, the nozzles N being placed on the tray NT are transferred to one empty pallet NPₚ for a pre-process from the tray NT by the above-described nozzle storing operation. In addition, at this time, the empty tray NT remains in the stage. Next, the above-described nozzle washing operation is performed on the transferred nozzles N in a state in which the nozzles are placed on the pallet NPₚ for a pre-process and the first nozzle inspecting operation and the second nozzle inspecting operation are performed. Further, the pallet NPₚ is set in the transfer position and the nozzle setting operation is performed on the pallet NPₚ for a pre-process in a state in which the inspected nozzles N are placed on the pallet NP_{P}. The nozzles N are reset, by the operation, in the originally placed position in the original tray NT remaining in the stage.

Further, in a case where it is determined whether the nozzles N are defective nozzles in any of the first nozzle inspecting operation and the second nozzle inspecting operation, the nozzles N are recovered to the above-described defective box 224 in the nozzle setting operation. In addition, the pallet NP_{A} for alignment on which nozzles N having the same form as that of the above-described nozzles N are placed is selected, the selected pallet NP_{A} for alignment is set to the transfer position, and the nozzles N having the same form as that of the above-described nozzles N are set in the original tray NT from the pallet NP_{A}. In this manner, excellent nozzles N are replenished in place of the nozzles determined as defective nozzles.

### [L] Functional configuration of control device

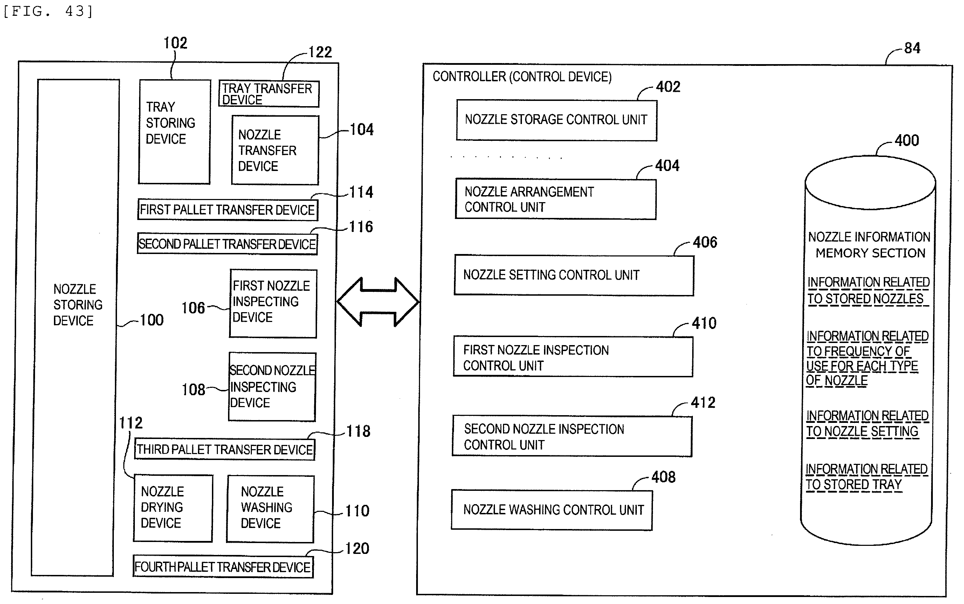

As described above, the management machine 80 of Examples is controlled by the controller 84 which is a control device. Specifically, as illustrated in Fig. 43, respective operations of the nozzle storing device 100 to the tray transfer device 122 are controlled by the controller 84 by exchanging signals and information therebetween. In addition, under the control of the controller 84, the management machine 80 performs the above-described various operations. In consideration of the operations, the controller 84 can be considered to include a plurality of functional units as illustrated in Fig. 43, that is, a plurality of functional units realized by executing various programs.

When each of a plurality of functional units are specifically described, the controller 84 includes a nozzle information memory section 400 as a functional unit storing the above-described stored nozzle information, information of frequency of use for each type of nozzle, nozzle setting information, and stored tray information which are management information respectively related to nozzles N. Specifically, a storage medium such as a hard disk included in a computer which is a main constituent element of the controller 84 plays a role of the nozzle information memory section 400. In addition, the management machine 80 performs the above-described operations based on the stored management information.

Further, the controller 84 includes six functional units as the functional units controlling the above-described respective operations. Specifically, the controller 84 includes a nozzle storage control unit 402 that controls the nozzle storing operation, a nozzle arrangement control unit 404 that controls the first and second nozzle arranging operation, a nozzle setting control unit 406 that controls the nozzle setting operation, a nozzle washing control unit 408 that controls the nozzle washing operation, a first nozzle inspection control unit 410 that controls the first nozzle inspecting operation, and a second nozzle inspection control unit 412 that controls the second nozzle inspecting operation. In addition, these control units 402 to 412 are functional units realized by executing the above-described nozzle storing program, the first and second nozzle arranging program, the nozzle setting program, the nozzle washing program, the first nozzle inspecting program, and the second nozzle inspecting program.

In addition, the nozzle resetting operation is an operation combining the nozzle storing operation and the nozzle setting operation, and these operations can be controlled in cooperation of the nozzle storage control unit 402 and the nozzle setting control unit 406. Accordingly, the nozzle storage control unit 402 is a functional unit realized by executing the first half of the nozzle resetting program and the nozzle setting control unit 406 is a functional unit realized by executing the second half of the nozzle resetting program.

### Reference Signs List

10: Electrical component mounting machine
18: Mounting head
N: Suction nozzle
30: Barrel tube [rear end portion]
32: Suction pipe [tip portion]
34: Flange
36: Interlocking pin
38: Two-dimensional code [identifier]
50: Nozzle station
NT: Nozzle tray
60: Base plate
62: Cover plate
64: Placing hole [placing unit]
66: Stepped surface
76: Two-dimensional code [identifier]
80: Nozzle management machine
84: Controller [control device]
100: Nozzle storing device
102: Tray storing device
104: Nozzle transfer device [device for performing treatment on nozzles] [defective nozzle transporting device]
106: First nozzle inspecting device [device for performing treatment on nozzles]
108: Second nozzle inspecting device [device for performing treatment on nozzles]
110: Nozzle washing device [device for performing treatment on nozzles]
112: Nozzle drying device
114: First pallet transfer device [nozzle transfer device] [pallet transfer device for transfer]
116: Second pallet transfer device [nozzle transfer device] [pallet transfer device for treatment]
118: Third pallet transfer device [nozzle transfer device] [pallet transfer device for treatment]
120: Fourth pallet transfer device [nozzle transfer device] [pallet transfer device for treatment]
122: Tray transfer device
134: Pallet transfer device [pallet circulating device]
NP: Nozzle pallet
140: Base plate
142: Cover plate
144: Placing hole [placing unit]
146: Stepped surface
156: Two-dimensional code [identifier]
158: Reference nozzle [reference target]
160: Reference pipe [reference target] [simulated object]
190: Tray moving device [tray circulating device]
202: Fixed stage
204: Movable stage
210: Transfer head
212: Head moving device [holding jig moving device]
218, 218a, 218b, 218c: Holding chuck [nozzle holding jig]
220: Camera [identifier reader]
224: Defective box [defective nozzle indwelling device]
226: Space [indwelling unit]
232: Camera device
234: Load measuring device
235: Inspecting unit
236: Unit moving device
270: Inspection head
272: Head moving device
274: Air carrying device
276: Camera
302: Upper portion washing unit
304: Lower portion washing unit
310: Y direction moving mechanism
312: Injection hole
314: Air blowing pipe
330: Rail
332: Moving mechanism
334: Guide 336: Transporting unit
338: Guide
340: Transporting unit
350: Cradle
360: Host computer [management device]
400: Nozzle information memory section
402: Nozzle storage control unit
404: Nozzle arrangement control unit
406: Nozzle setting control unit
408: Nozzle washing control unit
410: First nozzle inspection control unit
412: Second nozzle inspection control unit

## Claims

1. A nozzle management machine (80) which manages suction nozzles (N) used to hold an electrical component in an electrical component mounting machine (10), the nozzle management machine (80) comprising:
a nozzle storing device (100) that includes a plurality of carriers (130) each storing a pallet (NP) capable of respectively accommodating the suction nozzles (N);
a nozzle tray (NT); and
a nozzle transfer device (104) that transfers the suction nozzles (N) respectively placed on the plurality of pallets (NP), wherein
the nozzle transfer device (104) is configured to transfer a suction nozzle (N) from one of the pallets (NP) to the nozzle tray (NT) be to placed when used in an electrical component mounting machine (10),
the nozzle storing device (100) comprises a circulatory mechanism (132) adapted to circulate the carriers (130) concurrently along a defined path,
the nozzle management machine (80) includes a linearly moveable pallet transfer device (114) that transfers any one of the plurality of pallets (NP) from the nozzle storing device (100) to a transfer position set as a position in which the suction nozzles (N) are transferred by the nozzle transfer device (104), and
the nozzle transfer device (104) is configured so as to transfer the suction nozzles (N) placed on one of the plurality of pallets (NP) transferred to the transfer position by the pallet transfer device (114) to said nozzle tray (NT) and vice versa.

2. The nozzle management machine (80) according to claim 1, wherein the nozzle transfer device (104) is configured so as to transfer the suction nozzles (N) between one of the plurality of pallets (NP) and another one thereof.

3. The nozzle management machine (80) according to claim 1 or 2, wherein the pallet transfer device for transfer (114) is configured so as to sequentially transfer two or more pallets (NP) from among the plurality of pallets (NP) such that two or more of the plurality of pallets (NP) are temporarily and positioned in two or more of transfer positions respectively, which are the transfer positions.

4. The nozzle management machine (80) according to any one of claims 1 to 3, wherein the nozzle management machine (80) includes one or more devices for performing a treatment on nozzles (104, 106, 108, 110) that respectively perform a process on the suction nozzle (N) placed on any one of the plurality of pallets (NP),
wherein the process performed by the device for performing a treatment may be inspection, washing or drying of the nozzle.

5. The nozzle management machine (80) according to claim 4, wherein the nozzle management machine (80) is configured such that the transfer of the suction nozzle (N) placed on one of the plurality of pallets (NP) performed by the nozzle transfer device (104) and any process performed by one of one or more devices for performing a treatment on nozzles (104, 106, 108, 110) with respect to the suction nozzle (N) placed on another one of the plurality of pallets (NP) are performed in parallel.

6. The nozzle management machine (80) according to any one of claims 1 to 5, wherein the nozzle management machine (80) includes a control device (84) that controls its own device.

7. The nozzle management machine (80) according to claim 6,
wherein the electrical component mounting machine (10) is configured such that the suction nozzles (N) used thereon are placed on a nozzle tray (NT) disposed so as to be detachably attached thereto,
the nozzle transfer device (104) is configured so as to transfer the suction nozzles (N) between the nozzle tray (NT) and one of the plurality of pallets (NP), and
the control device (84) includes a setting control unit (406) that transfers the suction nozzles (N) required for the electrical component mounting machine (10) to the nozzle tray (NT) from one or more of the plurality of pallets (NP) by controlling the nozzle transfer device (104).

8. The nozzle management machine (80) according to claim 7,
wherein the nozzle management machine (80) is communicative with at least one of the electrical component mounting machine (10) and a management device (360) that manages the electrical component mounting machine (10), and
the setting control unit (406) is configured so as to transfer the suction nozzles (N) required for the electrical component mounting machine (10) based on information received from at least one of the electrical component mounting machine (10) and the management device (360).

9. The nozzle management machine (80) according to claim 7 or 8,
wherein the control device (84) includes a storage control unit that transfers the suction nozzles (N) to one or more pallets from among the plurality of pallets (NP) from the nozzle tray (NT) on which the suction nozzles (N) are placed by controlling the nozzle transfer device (104) in order to store the suction nozzles (N) in the nozzle storing device (100), and
the control device (84) is configured such that another suction nozzle (N) having the same form as those of the suction nozzles (N) transferred from the nozzle tray (NT) by the control of the storage control unit is transferred to the nozzle tray (NT) by the control of the setting control unit (406).

10. The nozzle management machine (80) according to any one of claims 7 to 9, wherein the setting control unit (406) is configured such that the suction nozzles (N) are transferred to the nozzle tray (NT) so that the frequency of use is as uniform as possible.

11. The nozzle management machine (80) according to any one of claims 6 to 10, wherein the control device (84) includes an arrangement control unit (404) that arranges the suction nozzles (N) to one or more of the plurality of pallets (NP) in the nozzle storing device (100) by controlling the nozzle transfer device (104) according to set rules.

12. The nozzle management machine (80) according to claim 11,
wherein the nozzle management machine (80) includes a nozzle washing device (110) that washes the suction nozzle (N) placed on any one of the plurality of pallets (NP), and the arrangement control unit (404) arranges only the suction nozzle (N) which is not completely washed by the nozzle washing device (110) on one of the plurality of pallets (NP).

13. The nozzle management machine (80) according to claim 11 or 12,
wherein the electrical component mounting machine (10) is configured such that the suction nozzles (N) used thereon are placed on the nozzle tray (NT) disposed so as to be detachably attached thereto, and
the arrangement control unit (404) arranges the suction nozzles (N) placed on the nozzle tray (NT) so as to constitute a specific set in one of the plurality of pallets (NP).

14. The nozzle management machine (80) according to any one of claims 1 to 13,
wherein the nozzle storing device (100) stores plural types of suction nozzles (N) whose types are different from one another, and
the nozzle transfer device (104) is configured so as to include a nozzle holding jig (218, 218a, 218b, 218c) holding one suction nozzle (N) and a holding jig moving device (212) that moves the nozzle holding jig (218, 218a, 218b, 218c) and use one nozzle holding jig (218, 218a, 218b, 218c) according to the type of the suction nozzles (N) being held among a plurality of nozzle holding jigs (218, 218a, 218b, 218c) respectively prepared as the nozzle holding jigs (218, 218a, 218b, 218c).

## Patentansprüche

1. Vorrichtung (80) zur Verwaltung von Düsen, die Saugdüsen (N) verwaltet, die zum Halten eines elektrischen Bauteils in einer Maschine (10) zum Montieren elektrischer Bauteile eingesetzt wird, wobei die Vorrichtung (80) zur Verwaltung von Düsen umfasst:
eine Einrichtung (100) zum Aufbewahren von Düsen, die eine Vielzahl von Trägern (130) enthält, die jeweils eine Palette (NP) aufbewahren, die jeweils die Saugdüsen (N) aufnehmen können;
eine Düsen-Ablage (NT); sowie
eine Einrichtung (104) zum Überführen von Düsen, die die Saugdüsen (N) überführt, die jeweils auf der Vielzahl von Paletten (NP) platziert sind, wobei
die Einrichtung (104) zum Überführen von Düsen so eingerichtet ist, dass sie eine Saugdüse (N) von einer der Paletten (NP) zu der Düsen-Ablage (NT) überführt, um sie beim Einsatz in einer Maschine (10) zum Montieren elektrischer Bauteile zu platzieren,
die Einrichtung (100) zum Aufbewahren von Düsen einen Umlauf-Mechanismus (132) umfasst, der so eingerichtet ist, dass er die Träger (130) gleichzeitig auf einem festgelegten Weg umlaufen lässt,
die Vorrichtung (80) zur Verwaltung von Düsen eine linear bewegliche Einrichtung (114) zum Überführen von Paletten enthält, die beliebige der Vielzahl von Paletten (NP) von der Einrichtung (100) zum Aufbewahren von Düsen zu einer Überführungs-Position überführt, die als eine Position festgelegt ist, an der die Saugdüsen (N) durch die Einrichtung (104) zum Überführen von Düsen überführt werden, und
die Einrichtung (104) zum Überführen von Düsen so eingerichtet ist, dass sie die Saugdüsen (N), die auf einer durch die Einrichtung (114) zum Überführen von Paletten zu der Überführungs-Position überführten der Vielzahl von Paletten (NP) platziert sind, zu der Düsen-Ablage (NT) und umgekehrt überführt.

2. Vorrichtung (80) zur Verwaltung von Düsen nach Anspruch 1, wobei die Einrichtung (104) zum Überführen von Düsen so eingerichtet ist, dass sie die Saugdüsen (N) zwischen einer der Vielzahl von Paletten (NP) und einer anderen derselben überführt.

3. Vorrichtung (80) zur Verwaltung von Düsen nach Anspruch 1 oder 2, wobei die Einrichtung (114) zum Überführen von Paletten so eingerichtet ist, dass sie zum Überführen sequenziell zwei oder mehr Paletten (NP) der Vielzahl von Paletten (MP) so überführt, dass zwei oder mehr der Vielzahl von Paletten (NP) vorübergehend jeweils an zwei oder mehr Überführungs-Positionen positioniert werden, die die Überführungs-Positionen sind.

4. Vorrichtung (80) zur Verwaltung von Düsen nach einem der Ansprüche 1 bis 3, wobei die Vorrichtung (80) zur Verwaltung von Düsen eine oder mehrere Einrichtung/en (104, 106, 108, 110) zum Durchführen einer Behandlung an Düsen enthält, die jeweils einen Prozess an der Saugdüse (N) durchführt/durchführen, die auf einer der Vielzahl von Paletten (NP) platziert ist,
der durch die Vorrichtung zum Durchführen einer Behandlung durchgeführte Prozess Prüfung, Spülen oder Trocknen der Düse sein kann.

5. Vorrichtung (80) zur Verwaltung von Düsen nach Anspruch 4, wobei die Vorrichtung (80) zur Verwaltung von Düsen so eingerichtet ist, dass die durch die Einrichtung (104) zum Überführen von Düsen durchgeführte Überführung der Saugdüse (N), die auf einer der Vielzahl von Paletten (NP) platziert ist, und jeder Prozess, der durch eine von einer oder mehreren Einrichtung/en (104, 106, 108, 110) zum Durchführen einer Behandlung an Düsen in Bezug auf die auf einer anderen der Vielzahl von Paletten (NP) platzierten Saugdüse (N) durchgeführt wird, parallel durchgeführt werden.

6. Vorrichtung (80) zur Verwaltung von Düsen nach einem der Ansprüche 1 bis 5, wobei die Vorrichtung (80) zur Verwaltung von Düsen eine Steuerungseinrichtung (84) enthält, die ihre eigene Einrichtung steuert.

7. Vorrichtung (80) zur Verwaltung von Düsen nach Anspruch 6,
wobei die Maschine (10) zum Montieren elektrischer Bauteile so eingerichtet ist, dass die daran eingesetzten Saugdüsen (N) auf einer Düsen-Ablage (NT) platziert werden, die so angeordnet ist, dass sie abnehmbar daran angebracht ist,
die Einrichtung (104) zum Überführen von Düsen so eingerichtet ist, dass sie die Saugdüsen (N) zwischen der Düsen-Ablage (NT) und einer der Vielzahl von Paletten (NP) überführt, und
die Steuerungseinrichtung (84) eine Einheit (406) für Einstellungs-Steuerung einschließt, die die für die Maschine (10) zum Montieren elektrischer Bauteile erforderlichen Saugdüsen (N) von einer oder mehreren der Vielzahl von Paletten (NP) durch Steuern der Einrichtung (104) zum Überführen von Düsen zu der Düsen-Ablage (NT) überführt.

8. Vorrichtung (80) zur Verwaltung von Düsen nach Anspruch 7,
wobei die Vorrichtung (80) zur Verwaltung von Düsen mit der Maschine (10) zum Montieren elektrischer Bauteile oder/und einer Verwaltungseinrichtung (360) kommuniziert, die die Maschine (10) zum Montieren elektrischer Bauteile verwaltet, und
die Einheit (406) für Einstellungs-Steuerung so eingerichtet ist, dass sie die für die Maschine (10) zum Montieren elektrischer Bauteile erforderlichen Saugdüsen (N) auf Basis von der Maschine (10) zum Montieren elektrischer Bauteile oder/und der Verwaltungseinrichtung (360) empfangener Informationen überführt.

9. Vorrichtung (80) zur Verwaltung von Düsen nach Anspruch 7 oder 8,
wobei die Steuerungseinrichtung (84) eine Einheit für Aufbewahrungs-Steuerung einschließt, die die Saugdüsen (N) zu einer oder mehreren Palette/n der Vielzahl von Paletten (NP) von der Düsen-Ablage (NT) überführt, auf der die Saugdüsen (M) platziert sind, indem sie die Einrichtung (104) zum Überführen von Düsen steuert, um die Saugdüsen (N) in der Einrichtung (100) zum Aufbewahren von Düsen aufzubewahren, und
die Steuerungseinrichtung (84) so eingerichtet ist, dass eine andere Saugdüse (N), die die gleiche Form hat wie die der durch die Steuerung der Einheit für Aufbewahrungs-Steuerung von der Düsen-Ablage (NT) überführten Saugdüsen (N), durch die Steuerung der Einheit (406) für Einstellungs-Steuerung zu der Düsen-Ablage (NT) überführt wird.

10. Vorrichtung (80) zur Verwaltung von Düsen nach einem der Ansprüche 7 bis 9, wobei die Einheit (406) für Einstellungs-Steuerung so eingerichtet ist, dass die Saugdüsen (N) so zu der Düsen-Ablage (NT) überführt werden, dass die Nutzungshäufigkeit so einheitlich wie möglich ist.

11. Vorrichtung (80) zur Verwaltung von Düsen nach einem der Ansprüche 6 bis 10, wobei die Steuerungseinrichtung (84) eine Einheit (404) für Anordnungs-Steuerung einschließt, die die Saugdüsen (N) durch Steuern der Einrichtung (104) zum Überführen von Düsen entsprechend festgelegter Regeln an einer oder mehrerer der Vielzahl von Paletten (NP) in der Einrichtung (100) zum Aufbewahren von Düsen anordnet.

12. Vorrichtung (80) zur Verwaltung von Düsen nach Anspruch 11,
wobei die Vorrichtung (80) zur Verwaltung von Düsen eine Einrichtung (110) zum Spülen von Düsen einschließt, die die auf einer der Vielzahl von Paletten (NP) platzierte Saugdüse (N) spült, und
die Einheit (404) für Anordnungs-Steuerung nur die Saugdüse (N), die durch die Einrichtung (110) zum Spülen von Düsen nicht vollständig gespült wird, an einer der Vielzahl von Paletten (NP) anordnet.

13. Vorrichtung (80) zur Verwaltung von Düsen nach Anspruch 11 oder 12,
wobei die Maschine (10) zum Montieren elektrischer Bauteile so eingerichtet ist, dass die daran eingesetzten Saugdüsen (N) auf der Düsen-Ablage (NT) platziert werden, die so angeordnet ist, dass sie abnehmbar daran angebracht ist, und
die Einheit (404) für Anordnungs-Steuerung die auf der Düsen-Ablage (NT) platzierten Saugdüsen (N) so anordnet, dass sie eine bestimmte Gruppe in einer der Vielzahl von Paletten (NP) bilden.

14. Vorrichtung (80) zur Verwaltung von Düsen nach einem der Ansprüche 1 bis 13, wobei die Einrichtung (100) zum Aufbewahren von Düsen mehrere Typen von Saugdüsen (N) aufbewahrt, deren Typen sich voneinander unterscheiden, und
die Einrichtung (104) zum Überführen von Düsen so eingerichtet ist, dass sie eine Düsen-Haltevorrichtung (218, 218a, 218b, 218c), die eine Saugdüse (N) hält, und eine Einrichtung (212) zum Bewegen der Haltevorrichtung einschließt, die die Düsen-Haltevorrichtung (218, 218a, 218b, 218c) bewegt, und sie eine Düsen-Haltevorrichtung (218, 218a, 218b, 218c) entsprechend dem Typ der Saugdüsen (N), die gehalten werden, von der Vielzahl von Düsen-Haltevorrichtungen (218, 218a, 218b, 218c) verwendet, die jeweils als die Düsen-Haltevorrichtungen (218, 218a, 218b, 218c) vorbereitet sind.

## Revendications

1. Machine de gestion de buses (80) qui gère des buses d'aspiration (N) utilisées pour maintenir un composant électrique dans une machine de montage de composants électriques (10), la machine de gestion de buses (80) comprenant :
un dispositif de stockage de buses (100) qui inclut une pluralité de dispositifs porteurs (130) stockant chacun un support (NP) pouvant accueillir respectivement les buses d'aspiration (N),
un plateau de buses (NT), et
un dispositif de transfert de buses (104) qui transfère les buses d'aspiration (N) placées respectivement sur la pluralité de supports (NP), où
le dispositif de transfert de buses (104) est configuré pour transférer une buse d'aspiration (N) depuis l'un des supports (NP) jusqu'au plateau de buses (NT) pour être placée, lorsqu'elle est utilisée dans une machine de montage de composants électriques (10),
le dispositif de stockage de buses (100) comprend un mécanisme circulatoire (132) conçu pour faire circuler les dispositifs porteurs (130) simultanément le long d'un trajet défini,
la machine de gestion de buses (80) inclut un dispositif de transfert de supports (114) mobile linéairement qui transfère l'un quelconque de la pluralité de supports (NP) depuis le dispositif de stockage de buses (100) jusqu'à une position de transfert établie comme étant la position dans laquelle les buses d'aspiration (N) sont transférées par le dispositif de transfert de buses (104), et
le dispositif de transfert de buses (104) est configuré de sorte à transférer les buses d'aspiration (N) placées sur l'un de la pluralité de supports (NP) transférés jusqu'à la position de transfert par le dispositif de transfert de supports (114) jusqu'au dit plateau de buses (NT) et vice versa.

2. Machine de gestion de buses (80) selon la revendication 1, dans laquelle le dispositif de transfert de buses (104) est configuré de sorte à transférer les buses d'aspiration (N) entre l'un de la pluralité de supports (NP) et un autre de ceux-ci.

3. Machine de gestion de buses (80) selon la revendication 1 ou la revendication 2, dans lequel le dispositif de transfert de supports (114) est configuré de sorte à transférer séquentiellement deux supports (NP) ou plus pris parmi la pluralité de supports (NP) de sorte à ce que deux supports ou plus de la pluralité de supports (NP) soient temporairement et respectivement positionnés dans deux positions de transfert ou plus, lesquelles représentent les positions de transfert.

4. Machine de gestion de buses (80) selon l'une quelconque des revendications 1 à 3, la machine de gestion de buses (80) incluant un ou plusieurs dispositifs destinés à effectuer un traitement sur des buses (104, 106, 108, 110), qui effectuent respectivement un processus sur la buse d'aspiration (N) placée sur l'un quelconque de la pluralité de supports (NP),
dans laquelle le processus effectué par le dispositif destiné à effectuer un traitement peut être une inspection, un lavage ou un séchage de la buse.

5. Machine de gestion de buses (80) selon la revendication 4, la machine de gestion de buses (80) étant configurée de sorte à ce que le transfert de la buse d'aspiration (N) placée sur l'un de la pluralité de supports (NP), effectué par le dispositif de transfert de buses (104), ainsi que tout processus effectué par un parmi un ou plusieurs dispositifs destinés à effectuer un traitement sur des buses (104, 106, 108, 110) par rapport à la buse d'aspiration (N) placée sur un autre de la pluralité de supports (NP), sont effectués en parallèle.

6. Machine de gestion de buses (80) selon l'une quelconque des revendications 1 à 5, la machine de gestion de buses (80) incluant un dispositif de commande (84) qui commande son propre dispositif.

7. Machine de gestion de buses (80) selon la revendication 6,
dans laquelle la machine de montage de composants électriques (10) est configurée de sorte à ce que les buses d'aspiration (N) utilisées sur celle-ci soient placées sur un plateau de buses (NT) disposé de sorte à être fixé de façon amovible à celle-ci,
le dispositif de transfert de buses (104) est configuré de sorte à transférer les buses d'aspiration (N) entre le plateau de buses (NT) et l'un de la pluralité de supports (NP), et
le dispositif de commande (84) inclut une unité de commande de réglage (406) qui transfère les buses d'aspiration (N) requises pour la machine de montage de composants électriques (10) vers le plateau de buses (NT) depuis un ou plusieurs supports parmi la pluralité de supports (NP) en commandant le dispositif de transfert de buses (104).

8. Machine de gestion de buses (80) selon la revendication 7,
la machine de gestion de buses (80) pouvant communiquer avec au moins un dispositif parmi la machine de montage de composants électriques (10) et un dispositif de gestion (360) qui gère la machine de montage de composants électriques (10), et
l'unité de commande de réglage (406) est configurée de sorte à transférer les buses d'aspiration (N) requises pour la machine de montage de composants électriques (10) sur la base d'informations reçues depuis au moins un dispositif parmi la machine de montage de composants électriques (10) et le dispositif de gestion (360).

9. Machine de gestion de buses (80) selon la revendication 7 ou la revendication 8,
dans lequel le dispositif de commande (84) inclut une unité de commande de stockage qui transfère les buses d'aspiration (N) vers un ou plusieurs supports parmi la pluralité de supports (NP) depuis le plateau de buses (NT) sur lequel sont placées les buses d'aspiration (N) en commandant le dispositif de transfert de buses (104) afin de stocker les buses d'aspiration (N) dans le dispositif de stockage de buses (100), et
le dispositif de commande (84) est configuré de sorte à ce qu'une autre buse d'aspiration (N) présentant la même forme que celle des buses d'aspiration (N) transférées depuis le plateau de buses (NT), grâce à la commande de l'unité de commande de stockage, soit transférée vers le plateau de buses (NT) grâce à la commande de l'unité de commande de réglage (406).

10. Machine de gestion de buses (80) selon l'une quelconque des revendications 7 à 9, dans laquelle l'unité de commande de réglage (406) est configurée de sorte à ce que les buses d'aspiration (N) soient transférées vers le plateau de buses (NT) de telle sorte que la fréquence d'utilisation soit aussi uniforme que possible.

11. Machine de gestion de buses (80) selon l'une quelconque des revendications 6 à 10, dans laquelle le dispositif de commande (84) inclut une unité de commande d'agencement (404) qui dispose les buses d'aspiration (N) sur un ou plusieurs supports parmi la pluralité de supports (NP) dans le dispositif de stockage de buses (100) en commandant le dispositif de transfert de buses (104) en fonction de règles établies.

12. Machine de gestion de buses (80) selon la revendication 11,
la machine de gestion de buses (80) incluant un dispositif de lavage de buse (110) qui nettoie la buse d'aspiration (N) placée sur l'un quelconque de la pluralité supports (NP), et
l'unité de commande d'agencement (404) ne dispose que la buse d'aspiration (N) qui n'est pas complètement nettoyée par le dispositif de lavage de buse (110) sur l'un de la pluralité de supports (NP).

13. Machine de gestion de buses (80) selon la revendication 11 ou la revendication 12,
dans laquelle la machine de montage de composants électriques (10) est configurée de sorte à ce que les buses d'aspiration (N) utilisées soient placées sur le plateau de buses (NT) disposé de sorte à être fixé de manière amovible à celle-ci, et
l'unité de commande d'agencement (404) dispose les buses d'aspiration (N) placées sur le plateau de buses (NT) de sorte à constituer un ensemble spécifique dans l'un de la pluralité de supports (NP).

14. Machine de gestion de buses (80) selon l'une quelconque des revendications 1 à 13,
dans lequel le dispositif de stockage de buses (100) stocke plusieurs types de buses d'aspiration (N) de types différents l'un de l'autre, et
le dispositif de transfert de buses (104) est configuré de sorte à inclure un bâti de maintien de buses (218, 218a, 218b, 218c) soutenant une buse d'aspiration (N) ainsi qu'un dispositif de déplacement de bâti de maintien (212) qui déplace le bâti de maintien de buses (218, 218a, 218b, 218c) et utilise un bâti de maintien de buses (218, 218a, 218b, 218c), en fonction du type des buses d'aspiration (N) soutenues, parmi la pluralité de bâtis de maintien de buses (218, 218a, 218b, 218c) préparés respectivement en tant que bâtis de maintien de buses (218, 218a, 218b, 218c).
